(19) Europäisches Patentamt
European Patent Office
Office européen des brevets

(11) EP 3 950 744 B1

(12) **EUROPEAN PATENT SPECIFICATION**

(45) Date of publication and mention of the grant of the patent:
**18.10.2023 Bulletin 2023/42**

(21) Application number: **20784526.4**

(22) Date of filing: **09.03.2020**

(51) International Patent Classification (IPC):
***C08F 220/16*** *(2006.01)* ***C08F 220/22*** *(2006.01)*
***G03F 7/039*** *(2006.01)* ***G03F 7/20*** *(2006.01)*
***C08F 220/18*** *(2006.01)* ***C08F 220/24*** *(2006.01)*
***C08F 220/28*** *(2006.01)* ***G03F 7/004*** *(2006.01)*
***C08L 33/12*** *(2006.01)*

(52) Cooperative Patent Classification (CPC):
(C-Sets available)
**G03F 7/0045; C08F 220/1806; C08F 220/1807; C08F 220/24; C08F 220/283; C08L 33/12; G03F 7/0046; G03F 7/0392; G03F 7/0397;**
C08F 212/24 (Cont.)

(86) International application number:
**PCT/JP2020/010050**

(87) International publication number:
**WO 2020/203073 (08.10.2020 Gazette 2020/41)**

(54) **PHOTOSENSITIVE COMPOSITION FOR EUV LIGHT, METHOD FOR PATTERN FORMATION, AND METHOD FOR PRODUCING ELECTRONIC DEVICE**

LICHTEMPFINDLICHE ZUSAMMENSETZUNG FÜR EUV-LICHT, VERFAHREN ZUR MUSTERBILDUNG UND VERFAHREN ZUR HERSTELLUNG EINER ELEKTRONISCHEN VORRICHTUNG

COMPOSITION PHOTOSENSIBLE POUR LUMIÈRE EUV, PROCÉDÉ DE FORMATION DE MOTIF ET PROCÉDÉ DE PRODUCTION D’UN DISPOSITIF ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.03.2019 JP 2019067401**
**26.02.2020 JP 2020030660**

(43) Date of publication of application:
**09.02.2022 Bulletin 2022/06**

(73) Proprietor: **FUJIFILM Corporation**
**Tokyo 106-8620 (JP)**

(72) Inventor: **SAKITA, Kyohei**
**Haibara-gun, Shizuoka 421-0396 (JP)**

(74) Representative: **HGF**
**HGF Limited**
**1 City Walk**
**Leeds LS11 9DX (GB)**

(56) References cited:
**WO-A1-2018/193954**
**WO-A1-2019/044231**
**WO-A1-2019/044259**
**WO-A1-2019/045107**
**WO-A1-2019/045107**
**WO-A1-2019/058890**
**WO-A1-2019/058945**
**WO-A1-2019/187803**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
**C08F 220/1806, C08F 220/24, C08F 220/283;**
**C08F 220/1806, C08F 220/24, C08F 220/585;**
**C08F 220/1807, C08F 220/24, C08F 220/365;**
**C08F 220/24, C08F 212/24;**
**C08F 220/283, C08F 212/24;**
**C08L 33/12, C08L 33/14**

## Description

## BACKGROUND OF THE INVENTION

1. Field of the Invention

The present invention relates to a photosensitive composition for EUV light, a pattern forming method, and a method for manufacturing an electronic device.

2. Description of the Related Art

In processes for manufacturing semiconductor devices such as an integrated circuit (IC) and a large scale integrated circuit (LSI) in the related art, microfabrication by lithography using a photosensitive composition has been performed.
Examples of the lithographic method include a method in which a resist film is formed with a photosensitive composition, and then the obtained film is exposed and then developed. In particular, it has recently been investigated to use extreme ultraviolet (EUV) light upon exposure (WO2018/193954A and WO2019045107).

## SUMMARY OF THE INVENTION

EUV light has a wavelength of 13.5 nm, which is a shorter wavelength than that of ArF (wavelength of 193 nm) light or the like, and therefore, the EUV light has a smaller number of incidence photons upon exposure with the same sensitivity. Thus, an effect of "photon shot noise" in which the number of photons statistically varies is significant, and a deterioration in line edge roughness (LER) are caused. In order to reduce the photon shot noise, a method in which an exposure dose is increased to cause an increase in the number of incidence photons is available, but the method is a trade-off with a demand for a higher sensitivity. In addition, there is a method for increasing the number of absorbed photons by increasing a resist film thickness, which however causes a decrease in resolution.
In contrast, in WO2018/193954A, a method for increasing the number of incidence photons by introducing a large number of elements having a high absorption efficiency for EUV light into a resist film to improve the absorption efficiency for EUV light of the resist film has been investigated.
Recently, the present inventors have investigated a relationship between the absorption efficiency for EUV light of a resist film and the characteristics of a pattern to be formed, and have thus found that the more elements having a high absorption efficiency for EUV light are included in a resist film, the more significant a film thickness reduction is in a residual film region after development (for example, an unexposed region in a case of alkali development, and an exposed region in a case of organic solvent development) upon formation of the film. On the other hand, the present inventors have also found that in a case where the content of the elements having a high absorption efficiency for EUV light in a resist film is reduced, bridge defects frequently occur in a pattern thus formed due to an effect of photon shot noise.
Therefore, it is an object of the present invention to provide a photosensitive composition for EUV light, which is capable of forming a pattern having excellent bridge defect suppressing properties and film thickness reduction suppressing properties in a residual film region.
In addition, another object of the present invention is to provide a pattern forming method and a method for manufacturing an electronic device.
The present inventors have conducted intensive investigations on the objects, and as a result, they have found that the objects can be accomplished by the following configurations, thereby leading to completion of the present invention.

[1] A photosensitive composition for EUV light, comprising:

a resin X of which a polarity is increased by an action of an acid so that a solubility in an alkali developer is increased and a solubility in an organic solvent is decreased, and a photoacid generator; or
a resin Y which includes a repeating unit having a photoacid generating group and of which a polarity is increased by an action of an acid so that a solubility in an alkali developer is increased and a solubility in an organic solvent is decreased,
in which the photosensitive composition for EUV light satisfies both Requirement 1 and Requirement 2.
Requirement 1: An A value determined by Expression (1) is 0.12 or more and less than 0.14.

$$\text{Expression (1): } A = ([H] \times 0.04 + [C] \times 1.0 + [N] \times 2.1 + [O] \times 3.6 + [F] \times 5.6 + [S] \times 1.5 + [I] \times 39.5)/([H] \times 1 + [C] \times 12 + [N] \times 14 + [O] \times 16 + [F] \times 19 + [S] \times 32 + [I] \times 127)$$

[H] represents a molar ratio of hydrogen atoms derived from a total solid content with respect to all atoms of the total solid content in the photosensitive composition for EUV light, [C] represents a molar ratio of carbon atoms derived from the total solid content with respect to all the atoms of the total solid content in the photosensitive composition for EUV light, [N] represents a molar ratio of nitrogen atoms derived from the total solid content with respect to all the atoms of the total solid content in the photosensitive composition for EUV light, [O] represents a molar ratio of oxygen atoms derived from the total solid content with respect to all the atoms of the total solid content in the photosensitive composition for EUV light, [F] represents a molar ratio of fluorine atoms derived from the total solid content with respect to all the atoms of the total solid content in the photosensitive composition for EUV light, [S] represents a molar ratio of sulfur atoms derived from the total solid content with respect to all the atoms of the total solid content in the photosensitive composition for EUV light, and [I] represents a molar ratio of iodine atoms derived from the total solid content with respect to all the atoms of the total solid content in the photosensitive composition for EUV light.
Requirement 2: The resin X and the resin Y each include two or more repeating units selected from the group consisting of a repeating unit represented by General Formula (A-1X) which will be described later, a repeating unit represented by General Formula (A-1Y) which will be described later, and a repeating unit including a lactone structure.

[2] The photosensitive composition for EUV light as described in [1], comprising:

the resin X of which a polarity is increased by an action of an acid so that a solubility in an alkali developer is increased and a solubility in an organic solvent is decreased; and
the photoacid generator.

[3] The photosensitive composition for EUV light as described in [1] or [2],
in which a concentration of solid contents in the photosensitive composition for EUV light is 5.0% by mass or less.
[4] The photosensitive composition for EUV light as described in any one of [1] to [3],
in which a content of the photoacid generator is 5% to 50% by mass with respect to a total solid content in the photosensitive composition for EUV light.
[5] The photosensitive composition for EUV light as described in any one of [1] to [4],
in which a volume of an acid generated from the photoacid generator is 300Å$^3$ or more.
[6] The photosensitive composition for EUV light according to any one of [1] to [5],
in which the repeating unit including a lactone structure includes a repeating unit represented by General Formula (A-2Z) which will be described later.
[7] The photosensitive composition for EUV light according to any one of [1] to [6],
in which the repeating unit represented by General Formula (A-1X) includes a repeating unit represented by General Formula (A-2X) which will be described later or General Formula (A-3X) which will be described later.
[8] The photosensitive composition for EUV light according to any one of [1] to [7],
in which at least one of $R^{2Y}$ or $R^{3Y}$ in General Formula (A-1Y) is a group including a fluorine atom.
[9] A pattern forming method, comprising:

forming a resist film on a substrate using the photosensitive composition for EUV light as described in any one of [1] to [8];
exposing the resist film with EUV light; and
developing the exposed resist film using an alkali developer to form a pattern.

[10] A method for manufacturing an electronic device, the method comprising the pattern forming method as described in [9].

According to the present invention, it is possible to provide a photosensitive composition for EUV light, which is capable of forming a pattern having excellent bridge defect suppressing properties and film thickness reduction suppressing properties in a residual film region.
In addition, according to the present invention, it is possible to provide a pattern forming method and a method for manufacturing an electronic device.

## DESCRIPTION OF THE PREFERRED EMBODIMENTS

Hereinafter, the present invention will be described in detail.

Description of configuration requirements described below may be made on the basis of representative embodiments of the present invention in some cases, but the present invention is not limited to such embodiments.

In notations for a group (atomic group) in the present specification, in a case where the group is cited without specifying whether it is substituted or unsubstituted, the group includes both a group having no substituent and a group having a substituent as long as this does not impair the spirit of the present invention. For example, an "alkyl group" includes not only an alkyl group having no substituent (unsubstituted alkyl group), but also an alkyl group having a substituent (substituted alkyl group). In addition, an "organic group" in the present specification refers to a group including at least one carbon atom.

"Actinic rays" or "radiation" in the present specification means, for example, a bright line spectrum of a mercury lamp, far ultraviolet rays typified by an excimer laser, extreme ultraviolet rays (EUV light), X-rays, electron beams (EB), or the like. "Light" in the present specification means actinic rays or radiation.

Unless otherwise specified, "exposure" in the present specification encompasses not only exposure by a bright line spectrum of a mercury lamp, far ultraviolet rays typified by an excimer laser, extreme ultraviolet rays (EUV light), X-rays or the like, but also lithography by particle beams such as electron beams and ion beams.

In the present specification, a numerical range expressed using "to" is used in a meaning of a range that includes the preceding and succeeding numerical values of "to" as the lower limit value and the upper limit value, respectively.

The bonding direction of divalent groups cited in the present specification is not limited unless otherwise specified. For example, in a case where Y in a compound represented by General Formula "X-Y-Z" is -COO-, Y may be -CO-O- or -O-CO-. In addition, the compound may be "X-CO-O-Z" or "X-O-CO-Z".

In the present specification, (meth)acrylate represents acrylate and methacrylate, and (meth)acryl represents acryl and methacryl.

In the present specification, the weight-average molecular weight (Mw), the number-average molecular weight (Mn), and the dispersity (also referred to as a molecular weight distribution) (Mw/Mn) of a resin are defined as values in terms of polystyrene by means of gel permeation chromatography (GPC) measurement (solvent: tetrahydrofuran, flow amount (amount of a sample injected): 10 μL, columns: TSK gel Multipore HXL-M manufactured by Tosoh Corporation, column temperature: 40°C, flow rate: 1.0 mL/min, detector: differential refractive index detector) using a GPC apparatus (HLC-8120 GPC manufactured by Tosoh Corporation).

The acid dissociation constant pKa in the present specification refers to an acid dissociation constant pKa in an aqueous solution, and is defined, for example, in Chemical Handbook (II) (Revised 4th Edition, 1993, compiled by the Chemical Society of Japan, Maruzen Company, Ltd.). A lower value of the acid dissociation constant pKa indicates a higher acid strength. Specifically, the acid dissociation constant pKa in an aqueous solution can be actually measured by using an infinite-dilution aqueous solution and measuring the acid dissociation constant at 25°C. Alternatively, the acid dissociation constant pKa can also be determined using the following software package 1 by computation from a value based on a Hammett substituent constant and the database of publicly known literature values. Any of the pKa values described in the present specification indicates a value determined by computation using the software package.

Software Package 1: Advanced Chemistry Development (ACD/Labs) Software V 8.14 for Solaris (1994 - 2007 ACD/Labs).

1 Å is $1 \times 10^{-10}$ m.

In the present specification, examples of the halogen atom include a fluorine atom, a chlorine atom, a bromine atom, and an iodine atom.

[Photosensitive Composition for EUV Light]

One of feature points of the photosensitive composition for EUV light of an embodiment of the present invention (hereinafter also referred to as a "resist composition") is that the photosensitive composition satisfies Requirements 1 and 2 which will be described later.

The resist composition of the embodiment of the present invention exhibits a desired effect in a case where it has the constitution. Mechanism of the action thereof is not always clear, but is presumed to be as follows by the present inventors.

In a case where the A value shown in Requirement 1 is less than 0.14, a film thickness reduction in a residual film region of a pattern thus formed (for example, an unexposed region in a case of alkali development and an exposed region in a case of organic solvent development) can be suppressed. On the other hand, in a case where the A value of Requirement 1 is 0.12 or more and the Requirement 2 is satisfied, bridge defects are less likely to occur in a pattern thus formed.

That is, by adopting the configuration for the resist composition of the embodiment of the present invention, it

is possible to form a pattern having excellent bridge defect suppressing properties and film thickness reduction suppressing properties in a residual film region.

Hereinafter, the resist composition of the embodiment of the present invention will be described in detail.

The resist composition of the embodiment of the present invention may be either a positive tone resist composition or a negative tone resist composition. In addition, the resist composition may be either a resist composition for alkali development or a resist composition for organic solvent development.

The resist composition of the embodiment of the present invention is typically a chemically amplified resist composition.

First, Requirement 1 will be described below.

Requirement 1: An A value determined by Expression (1) is 0.12 or more and less than 0.14.

The higher the A value, the higher the absorption efficiency for EUV light of a resist film formed of the resist composition. The A value represents the absorption efficiency for EUV light of the resist film in terms of a mass ratio.

$$\text{Expression (1): } A = ([H] \times 0.04 + [C] \times 1.0 + [N] \times 2.1 + [O] \times 3.6 + [F] \times 5.6 + [S] \times 1.5 + [I] \times 39.5)/([H] \times 1 + [C] \times 12 + [N] \times 14 + [O] \times 16 + [F] \times 19 + [S] \times 32 + [I] \times 127)$$

The A value is preferably 0.13 or more from the viewpoint that the bridge defects in a pattern to be formed can be further suppressed.

Moreover, in Expression (1), [H] represents a molar ratio of hydrogen atoms derived from a total solid content with respect to all atoms of the total solid content in the resist composition, [C] represents a molar ratio of carbon atoms derived from the total solid content with respect to all the atoms of the total solid content in the resist composition, [N] represents a molar ratio of nitrogen atoms derived from the total solid content with respect to all the atoms of the total solid content in the resist composition, [O] represents a molar ratio of oxygen atoms derived from the total solid content with respect to all the atoms of the total solid content in the resist composition, [F] represents a molar ratio of fluorine atoms derived from the total solid content with respect to all the atoms of the total solid content in the resist composition, [S] represents a molar ratio of sulfur atoms derived from the total solid content with respect to all the atoms of the total solid content in the resist composition, and [I] represents a molar ratio of iodine atoms derived from the total solid content with respect to all the atoms of the total solid content in the resist composition.

For example, in a case where the resist composition includes a resin X, a photoacid generator, an acid diffusion control agent, and a solvent, the resin X, the photoacid generator, and the acid diffusion control agent correspond to the solid content. That is, all the atoms in the total solid content correspond to a sum of all the atoms derived from the resin, all the atoms derived from the photoacid generator, and all the atoms derived from the acid diffusion control agent. For example, [H] represents a molar ratio of hydrogen atoms derived from the total solid content with respect to all the atoms in the total solid content, and by way of description based on the example above, [H] represents a molar ratio of a sum of the hydrogen atom derived from the resin, the hydrogen atom derived from the photoacid generator, and the hydrogen atom derived from the acid diffusion control agent with respect to a sum of all the atoms derived from the resin, all the atoms derived from the photoacid generator, and all the atoms derived from the acid diffusion control agent.

Furthermore, the solid content is intended to mean components excluding the solvent in the composition, and any of components other than the solvent are regarded as the solid content even in a case where they are liquid components.

The A value can be calculated by computation of the structure of constituent components of the total solid content in the resist composition, and the ratio of atoms contained in a case where the content is already known. In addition, even in a case where the constituent component is not known yet, it is possible to calculate a ratio of the number of constituent atoms by subjecting a resist film obtained after evaporating the solvent components of the resist composition to computation according to an analytic approach such as elemental analysis.

Next, various components of the resist composition of the embodiment of the present invention and Requirement 2 satisfied by the resist composition of the embodiment of the present invention will be described.

[Resin of which Polarity Is Increased by Action of Acid so that Solubility in Alkali Developer Is Increased and Solubility in Organic Solvent Is Decreased]

The resist composition of the embodiment of the present invention includes a resin of which a polarity is increased by an action of an acid so that a solubility in an alkali developer is increased and a solubility in an organic solvent is decreased (hereinafter also referred to as a "resin (A)").

In addition, the resin (A) may have a repeating unit having a photoacid generating group, as described later. Furthermore, in the present specification, a resin of which a polarity is increased by an action of an acid so that a solubility in an alkali developer is increased and a solubility in an organic solvent is decreased, in which the resin does not include a repeating unit having a photoacid generating group, is referred to a "resin X", and a resin which includes a repeating unit having a photoacid generating group and of which a polarity is increased by an action of an acid so that a solubility in an alkali developer is increased and a solubility in an organic solvent is decreased, is referred to as a "resin Y", in some cases. In a case where the resist composition includes the resin Y, the resist composition may not include a photoacid generator.

Among those, the resin (A) preferably has an acid group having an acid dissociation constant (pKa) of 13 or less. The acid dissociation constant of the acid group is more preferably 3 to 13, and still more preferably 5 to 10.

In a case where the resin (A) has an acid group having a predetermined pKa, the storage stability of the resist composition is excellent, and thus, the progress of development is improved.

Examples of the acid group having an acid dissociation constant (pKa) of 13 or less include a carboxyl group, a phenolic hydroxyl group, a fluorinated alcohol group (preferably a hexafluoroisopropanol group), a sulfonic acid group, and a sulfonamide group.

In a case where the resin (A) has an acid group having a pKa of 13 or less, the content of the acid group in the resin (A) is not particularly limited, but is 0.2 to 6.0 mmol/g in many cases. Among those, the content of the acid group is preferably 0.8 to 6.0 mmol/g, more preferably 1.2 to 5.0 mmol/g, and still more preferably 1.6 to 4.0 mmol/g. In a case where the content of the acid group is within the range, the progress of development is improved, and thus, the shape of a pattern thus formed is excellent and the resolution is also excellent.

The resin (A) usually includes a repeating unit having a group having a polarity that is increased through decomposition by the action of an acid (hereinafter also referred to as an "acid-decomposable group"), and preferably includes a repeating unit having an acid-decomposable group.

<Repeating Unit Having Acid-Decomposable Group>

The acid-decomposable group is a group that decomposes by the action of an acid to generate a polar group. The acid-decomposable group preferably has a structure in which the polar group is protected by a leaving group that leaves by the action of an acid. That is, the resin (A) preferably has a repeating unit having a group that decomposes by the action of an acid to generate a polar group. The resin having such a repeating unit has a polarity that is increased by the action of an acid so that a solubility in an alkali developer is increased and a solubility in an organic solvent is decreased.

As the polar group, an alkali-soluble group is preferable, and examples thereof include an acidic group such as a carboxyl group, a phenolic hydroxyl group, a fluorinated alcohol group, a sulfonic acid group, a phosphoric acid group, a sulfonamide group, a sulfonylimide group, an (alkylsulfonyl)(alkylcarbonyl)methylene group, an (alkylsulfonyl)(alkylcarbonyl)imide group, a bis(alkylcarbonyl)methylene group, a bis(alkylcarbonyl)imide group, a bis(alkylsulfonyl)methylene group, a bis(alkylsulfonyl)imide group, a tris(alkylcarbonyl)methylene group, and a tris(alkylsulfonyl)methylene group, and an alcoholic hydroxyl group.

Among those, the carboxyl group, the phenolic hydroxyl group, the fluorinated alcohol group (preferably a hexafluoroisopropanol group), or the sulfonic acid group is preferable as the polar group.

Examples of the leaving group that leaves by the action of an acid include groups represented by Formulae (Y1) to (Y4).

Formula (Y1): $-C(Rx_1)(Rx_2)(Rx_3)$

Formula (Y2): $-C(=O)OC(Rx_1)(Rx_2)(Rx_3)$

Formula (Y3): $-C(R_{36})(R_{37})(OR_{38})$

Formula (Y4): $-C(Rn)(H)(Ar)$

In Formula (Y1) and Formula (Y2), $Rx_1$ to $Rx_3$ each independently represent an (linear or branched) alkyl group or (monocyclic or polycyclic) cycloalkyl group, an (linear or branched) alkenyl group, or an (monocyclic or polycyclic) aryl group. In addition, in a case where all of $Rx_1$ to $Rx_3$ are (linear or branched) alkyl groups, it is preferable that at least two of $Rx_1$, ..., or $Rx_3$ are methyl groups.

Above all, it is preferable that $Rx_1$ to $Rx_3$ each independently represent a linear or branched alkyl group, and it is more preferable that $Rx_1$ to $Rx_3$ each independently represent the linear alkyl group.

Two of $Rx_1$ to $Rx_3$ may be bonded to each other to form a monocycle or a polycycle.

As the alkyl group of each of $Rx_1$ to $Rx_3$, an alkyl group having 1 to 5 carbon atoms, such as a methyl group, an ethyl group, an n-propyl group, an isopropyl group, an n-butyl group, an isobutyl group, and a t-butyl group, is preferable.

As the cycloalkyl group of each of $Rx_1$ to $Rx_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable.

As the aryl group as each of $Rx_1$ to $Rx_3$, an aryl group having 6 to 10 carbon atoms is preferable, and examples thereof include a phenyl group, a naphthyl group, and an anthryl group.

As the alkenyl group of each of $Rx_1$ to $Rx_3$, a vinyl group is preferable.

As a ring formed by the bonding of two of $Rx_1$ to $Rx_3$, a cycloalkyl group is preferable. As the cycloalkyl group formed by the bonding of two of $Rx_1$ to $Rx_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable, and a monocyclic cycloalkyl group having 5 or 6 carbon atoms is more preferable.

In the cycloalkyl group formed by the bonding of two of $Rx_1$ to $Rx_3$, for example, one methylene group constituting the ring may be substituted with a heteroatom such as an oxygen atom or a group having a heteroatom, such as a carbonyl group, or may be substituted with a vinylidene group. In addition, in the cycloalkyl group, one or more of the ethylene groups constituting the cycloalkane ring may be substituted with a vinylene group.

For the group represented by Formula (Y1) or Formula (Y2), for example, an aspect in which $Rx_1$ is a methyl group or an ethyl group, and $Rx_2$ and $Rx_3$ are bonded to each other to form the above-mentioned cycloalkyl group is preferable.

In Formula (Y3), $R_{36}$ to $R_{38}$ each independently represent a hydrogen atom or a monovalent organic group. $R_{37}$ and $R_{38}$ may be bonded to each other to form a ring. Examples of the monovalent organic group include an alkyl group, a cycloalkyl group, an aryl group, an aralkyl group, and an alkenyl group. It is also preferable that $R_{36}$ is a hydrogen atom.

Furthermore, the alkyl group, the cycloalkyl group, the aryl group, and the aralkyl group may include a heteroatom such as an oxygen atom, and/or a group having a heteroatom, such as a carbonyl group. For example, in the alkyl group, the cycloalkyl group, the aryl group, and the aralkyl group, one or more of the methylene groups may be substituted with a heteroatom such as an oxygen atom and/or a group having a heteroatom, such as a carbonyl group.

In addition, $R_{38}$ and another substituent contained in the main chain of the repeating unit may be bonded to each other to form a ring. A group formed by the mutual bonding of $R_{38}$ and another substituent on the main chain of the repeating unit is preferably an alkylene group such as a methylene group.

For Formula (Y3), a group represented by Formula (Y3-1) is preferable.

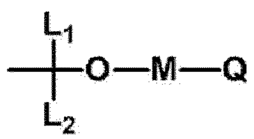

(Y3-1)

Here, $L_1$ and $L_2$ each independently represent a hydrogen atom, an alkyl group, a cycloalkyl group, an aryl group, or a group formed by combination thereof (for example, a group formed by combination of an alkyl group and an aryl group).

M represents a single bond or a divalent linking group.

Q represents an alkyl group which may include a heteroatom, a cycloalkyl group which may include a heteroatom, an aryl group which may include a heteroatom, an amino group, an ammonium group, a mercapto group, a cyano group, an aldehyde group, or a group formed by combination thereof (for example, a group formed by combination of an alkyl group and a cycloalkyl group).

In the alkyl group and the cycloalkyl group, for example, one methylene group may be substituted with a heteroatom such as an oxygen atom, or a group having a heteroatom, such as a carbonyl group.

Furthermore, it is preferable that one of $L_1$ or $L_2$ is a hydrogen atom, and the other is an alkyl group, a cycloalkyl group, an aryl group, or a group formed by combination of an alkylene group and an aryl group.

At least two of Q, M, or $L_1$ may be bonded to each other to form a ring (preferably a 5- or 6-membered ring).

From the viewpoint of making a pattern finer, $L_2$ is preferably a secondary or tertiary alkyl group, and more preferably the tertiary alkyl group. Examples of the secondary alkyl group include an isopropyl group, a cyclohexyl group, and a norbornyl group, and examples of the tertiary alkyl group include a tert-butyl group and an adamantane group. In these aspects, a glass transition temperature (Tg) or an activation energy is increased, and therefore, in addition to secured film hardness, suppression of fogging can be achieved.

In Formula (Y4), Ar represents an aromatic ring group. Rn represents an alkyl group, a cycloalkyl group, or an

aryl group. Rn and Ar may be bonded to each other to form a non-aromatic ring. Ar is more preferably an aryl group.

From the viewpoint that the acid decomposability of the repeating unit is excellent, in a case where a non-aromatic ring is directly bonded to a polar group (or a residue thereof) in a leaving group that protects the polar group, it is also preferable that a ring member atom adjacent to the ring member atom directly bonded to the polar group (or a residue thereof) in the non-aromatic ring has no halogen atom such as a fluorine atom as a substituent.

In addition, the leaving group that leaves by the action of an acid may be a 2-cyclopentenyl group having a substituent (an alkyl group and the like), such as a 3-methyl-2-cyclopentenyl group, and a cyclohexyl group having a substituent (an alkyl group and the like), such as a 1,1,4,4-tetramethylcyclohexyl group.

As the repeating unit having an acid-decomposable group, a repeating unit represented by Formula (A) is also preferable.

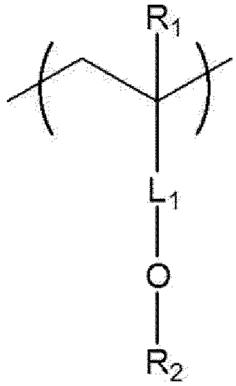

(A)

$L_1$ represents a divalent linking group which may have a fluorine atom or an iodine atom, $R_1$ represents a hydrogen atom, a fluorine atom, an iodine atom, an alkyl group which may have a fluorine atom or an iodine atom, or an aryl group which may have a fluorine atom or an iodine atom, and $R_2$ represents a leaving group which leaves by the action of an acid and may have a fluorine atom or an iodine atom. It should be noted that at least one of $L_1$, $R_1$, or $R_2$ has a fluorine atom or an iodine atom.

$L_1$ represents a divalent linking group which may have a fluorine atom or an iodine atom. Examples of the divalent linking group which may have a fluorine atom or an iodine atom include -CO-, -O-, -S-, -SO-, $-SO_2-$, a hydrocarbon group which may have a fluorine atom or an iodine atom (for example, an alkylene group, a cycloalkylene group, an alkenylene group, and an arylene group), and a linking group formed by the linking of a plurality of these groups. Among those, as $L_1$, -CO- or -arylene group-, alkylene group having a fluorine atom or an iodine atom is preferable.

As the arylene group, a phenylene group is preferable.

The alkylene group may be linear or branched. The number of carbon atoms of the alkylene group is not particularly limited, but is preferably 1 to 10, and more preferably 1 to 3.

The total number of fluorine atoms and iodine atoms included in the alkylene group having a fluorine atom or an iodine atom is not particularly limited, but is preferably 2 or more, more preferably 2 to 10, and still more preferably 3 to 6.

$R_1$ represents a hydrogen atom, a fluorine atom, an iodine atom, an alkyl group which may have a fluorine atom or an iodine atom, or an aryl group which may have a fluorine atom or an iodine atom.

The alkyl group may be linear or branched. The number of carbon atoms of the alkyl group is not particularly limited, but is preferably 1 to 10, and more preferably 1 to 3.

The total number of fluorine atoms and iodine atoms included in the alkyl group having a fluorine atom or an iodine atom is not particularly limited, but is preferably 1 or more, more preferably 1 to 5, and still more preferably 1 to 3.

The alkyl group may include a heteroatom such as an oxygen atom other than a halogen atom.

$R_2$ represents a leaving group that leaves by the action of an acid and may have a fluorine atom or an iodine atom.

Among those, examples of the leaving group include groups represented by Formulae (Z1) to (Z4).

Formula (Z1): $-C(Rx_{11})(Rx_{12})(Rx_{13})$

Formula (Z2): $-C(=O)OC(Rx_{11})(Rx_{12})(Rx_{13})$

Formula (Z3): $-C(R_{136})(R_{137})(OR_{138})$

Formula (Z4): $-C(Rn_1)(H)(Ar_1)$

In Formulae (Z1) and (Z2), $Rx_{11}$ to $Rx_{13}$ each independently represent an (linear or branched) alkyl group which may have a fluorine atom or an iodine atom, a (monocyclic or polycyclic) cycloalkyl group which may have a fluorine atom or an iodine atom, an (linear or branched) alkenyl group which may have a fluorine atom or an iodine atom, or an (monocyclic or polycyclic) aryl group which may have a fluorine atom or an iodine atom. In addition, in a case where all of $Rx_{11}$ to $Rx_{13}$ are (linear or branched) alkyl groups, it is preferable that at least two of $Rx_{11}$, ..., or $Rx_{13}$ are methyl groups.

$Rx_{11}$ to $Rx_{13}$ are the same as $Rx_1$ to $Rx_3$ in Formulae (Y1) and (Y2) described above, respectively, except that they may have a fluorine atom or an iodine atom, and have the same definitions and suitable ranges as those of the alkyl group, the cycloalkyl group, the alkenyl group, and the aryl group.

In Formula (Z3), $R_{136}$ to $R_{138}$ each independently represent a hydrogen atom, or a monovalent organic group which may have a fluorine atom or an iodine atom. $R_{137}$ and $R_{138}$ may be bonded to each other to form a ring. Examples of the monovalent organic group which may have a fluorine atom or an iodine atom include an alkyl group which may have a fluorine atom or an iodine atom, a cycloalkyl group which may have a fluorine atom or an iodine atom, an aryl group which may have a fluorine atom or an iodine atom, an aralkyl group which may have a fluorine atom or an iodine atom, and a group formed by combination thereof (for example, a group formed by combination of an alkyl group and a cycloalkyl group).

In addition, a heteroatom such as an oxygen atom, in addition to the fluorine atom and the iodine atom, may be included in the alkyl group, the cycloalkyl group, the aryl group, and the aralkyl group. That is, in the alkyl group, the cycloalkyl group, the aryl group, and the aralkyl group, for example, one methylene group may be substituted with a heteroatom such as an oxygen atom, or a group having a heteroatom, such as a carbonyl group.

In addition, $R_{138}$ and another substituent contained in the main chain of the repeating unit may be bonded to each other to form a ring. In this case, a group formed by the mutual bonding of $R_{138}$ and another substituent on the main chain of the repeating unit is preferably an alkylene group such as a methylene group.

For Formula (Z3), a group represented by Formula (Z3-1) is preferable.

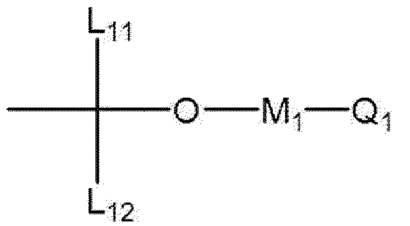

(Z3-1)

Here, $L_{11}$ and $L_{12}$ each independently represent a hydrogen atom; an alkyl group which may have a heteroatom selected from the group consisting of a fluorine atom, an iodine atom, and an oxygen atom; a cycloalkyl group which may have a heteroatom selected from the group consisting of a fluorine atom, an iodine atom, and an oxygen atom; an aryl group which may have a heteroatom selected from the group consisting of a fluorine atom, an iodine atom, and an oxygen atom; or a group formed by combination thereof (for example, a group formed by combination of an alkyl group and a cycloalkyl group, which may have a heteroatom selected from the group consisting of a fluorine atom, an iodine atom, and an oxygen atom).

$M_1$ represents a single bond or a divalent linking group.

$Q_1$ represents an alkyl group which may have a heteroatom selected from the group consisting of a fluorine atom, an iodine atom, and an oxygen atom; a cycloalkyl group which may have a heteroatom selected from the group consisting of a fluorine atom, an iodine atom, and an oxygen atom; an aryl group which may have a heteroatom selected from the group consisting of a fluorine atom, an iodine atom, and an oxygen atom; an amino group; an ammonium group; a mercapto group; a cyano group; an aldehyde group; or a group formed by combination thereof (for example, a group formed by combination of an alkyl group and a cycloalkyl group, which may have a heteroatom selected from the group consisting of a fluorine atom, an iodine atom, and an oxygen atom).

In Formula (Z4), $Ar_1$ represents an aromatic ring group which may have a fluorine atom or an iodine atom. $Rn_1$ represents an alkyl group which may have a fluorine atom or an iodine atom, a cycloalkyl group which may have a fluorine atom or an iodine atom, or an aryl group which may have a fluorine atom or an iodine atom. $Rn_1$ and $Ar_1$ may be bonded to each other to form a non-aromatic ring.

As the repeating unit having an acid-decomposable group, a repeating unit represented by General Formula (AI) is also preferable.

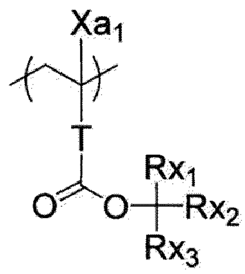

(A I)

In General Formula (AI),

$Xa_1$ represents a hydrogen atom, or an alkyl group which may have a substituent.
T represents a single bond or a divalent linking group.
$Rx_1$ to $Rx_3$ each independently represent an (linear or branched) alkyl group, a (monocyclic or polycyclic) cycloalkyl group, an (linear or branched) alkenyl group, or an (monocyclic or polycyclic) aryl group. It should be noted that in a case where all of $Rx_1$ to $Rx_3$ are (linear or branched) alkyl groups, it is preferable that at least two of $Rx_1$, $Rx_2$, or $Rx_3$ are methyl groups.

Two of $Rx_1$, to $Rx_3$ may be bonded to each other to form a monocycle or polycycle (a monocyclic or polycyclic cycloalkyl group and the like).

Examples of the alkyl group which may have a substituent represented by $Xa_1$ include a methyl group or a group represented by $-CH_2-R_{11}$. $R_{11}$ represents a halogen atom (a fluorine atom or the like), a hydroxyl group, or a monovalent organic group, examples thereof include an alkyl group having 5 or less carbon atoms, which may be substituted with a halogen atom, an acyl group having 5 or less carbon atoms, which may be substituted with a halogen atom, and an alkoxy group having 5 or less carbon atoms, which may be substituted with a halogen atom; and an alkyl group having 3 or less carbon atoms is preferable, and a methyl group is more preferable. As $Xa_1$, a hydrogen atom, a methyl group, a trifluoromethyl group, or a hydroxymethyl group is preferable.

Examples of the divalent linking group of T include an alkylene group, an aromatic ring group, a -COO-Rt- group, and an -O-Rt- group. In the formulae, Rt represents an alkylene group or a cycloalkylene group.

T is preferably a single bond or a -COO-Rt- group. In a case where T represents the -COO-Rt-group, Rt is preferably an alkylene group having 1 to 5 carbon atoms, and more preferably a $-CH_2-$ group, a $-(CH_2)_2-$ group, or a $-(CH_2)_3-$ group.

As the alkyl group of each of $Rx_1$ to $Rx_3$, an alkyl group having 1 to 4 carbon atoms, such as a methyl group, an ethyl group, an n-propyl group, an isopropyl group, an n-butyl group, an isobutyl group, and a t-butyl group, is preferable.

As the cycloalkyl group of each of $Rx_1$ to $Rx_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable.

As the aryl group as each of $Rx_1$ to $Rx_3$, an aryl group having 6 to 10 carbon atoms is preferable, and examples thereof include a phenyl group, a naphthyl group, and an anthryl group.

As the alkenyl group of each of $Rx_1$ to $Rx_3$, a vinyl group is preferable.

As the cycloalkyl group formed by the bonding of two of $Rx_1$ to $Rx_3$, a monocyclic cycloalkyl group such as a cyclopentyl group and a cyclohexyl group is preferable, and in addition, a polycyclic cycloalkyl group such as norbornyl group, a tetracyclodecanyl group, a tetracyclododecanyl group, and an adamantyl group is preferable. Among those, a monocyclic cycloalkyl group having 5 or 6 carbon atoms is preferable.

In the cycloalkyl group formed by the bonding of two of $Rx_1$ to $Rx_3$, for example, one methylene group constituting the ring may be substituted with a heteroatom such as an oxygen atom or a group having a heteroatom, such as a carbonyl group, or may be substituted with a vinylidene group. In addition, in the cycloalkyl group, one or more of the ethylene groups constituting the cycloalkane ring may be substituted with a vinylene group.

For the repeating unit represented by General Formula (AI), for example, an aspect in which $Rx_1$ is a methyl group or an ethyl group, and $Rx_2$ and $Rx_3$ are bonded to each other to form the above-mentioned cycloalkyl group is preferable.

In a case where each of the groups has a substituent, examples of the substituent include an alkyl group (having 1 to 4 carbon atoms), a halogen atom, a hydroxyl group, an alkoxy group (having 1 to 4 carbon atoms), a carboxyl group, and an alkoxycarbonyl group (having 2 to 6 carbon atoms). The number of carbon atoms of the substituent is preferably 8 or less.

The repeating unit represented by General Formula (AI) is preferably an acid-decomposable tertiary alkyl (meth)acrylate ester-based repeating unit (the repeating unit in which $Xa_1$ represents a hydrogen atom or a methyl group and T represents a single bond).

The content of the repeating unit having an acid-decomposable group is preferably 15% by mass or more, more preferably 20% by mass or more, and still more preferably 30% by mass or more with respect to all repeating units in the resin (A). In addition, an upper limit value thereof is preferably 80% by mass or less, and more preferably 70% by mass or less.

Specific examples of the repeating unit having an acid-decomposable group are shown below, but the present invention is not limited thereto. Further, in the formulae, $Xa_1$ represents H, $CH_3$, $CF_3$, or $CH_2OH$, and Rxa and Rxb each represent a linear or branched alkyl group having 1 to 5 carbon atoms, or an aryl group.

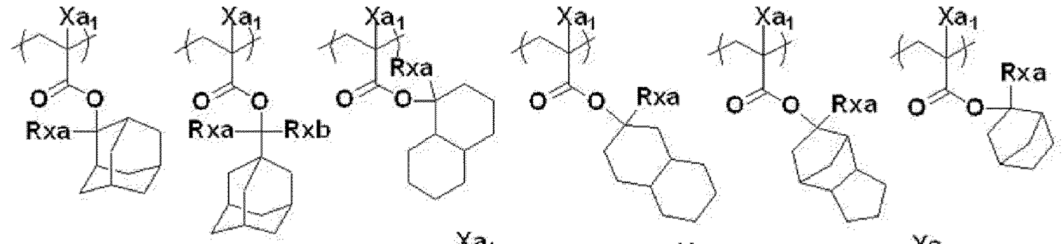

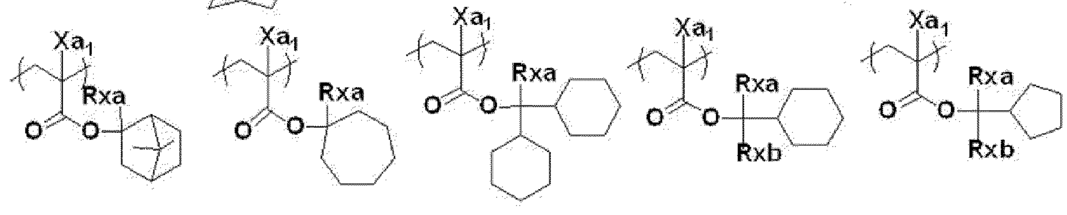

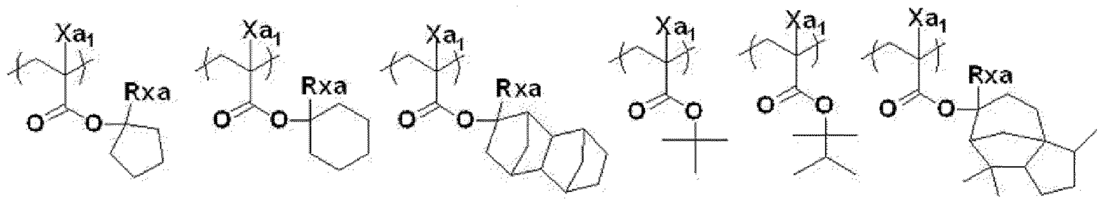

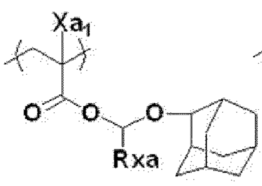
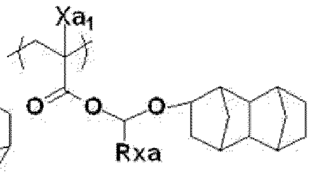
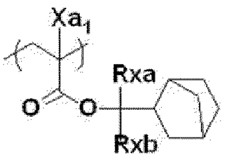
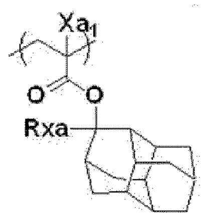

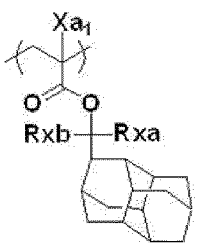
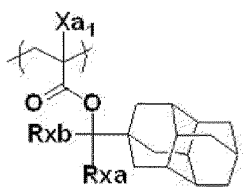
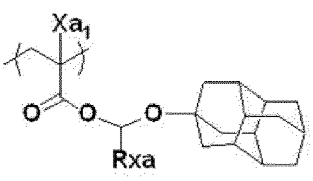
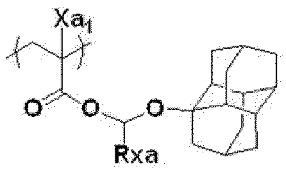

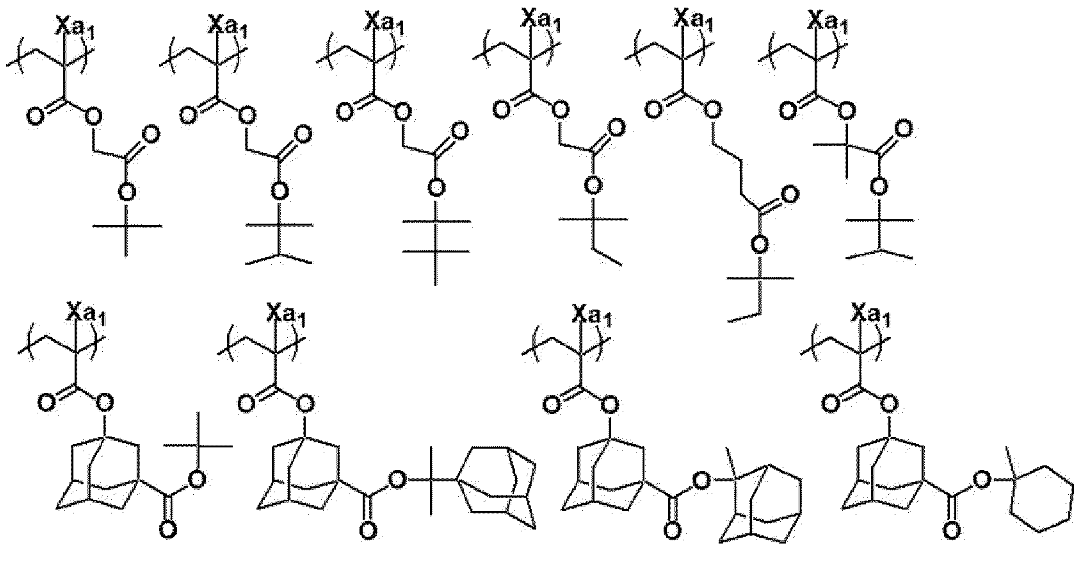

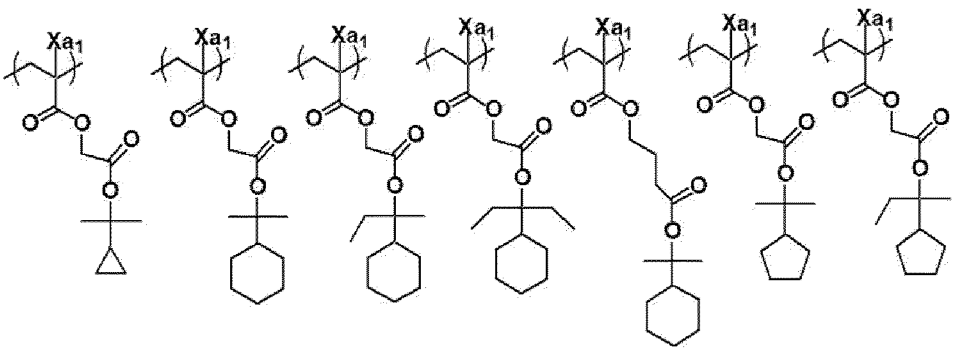

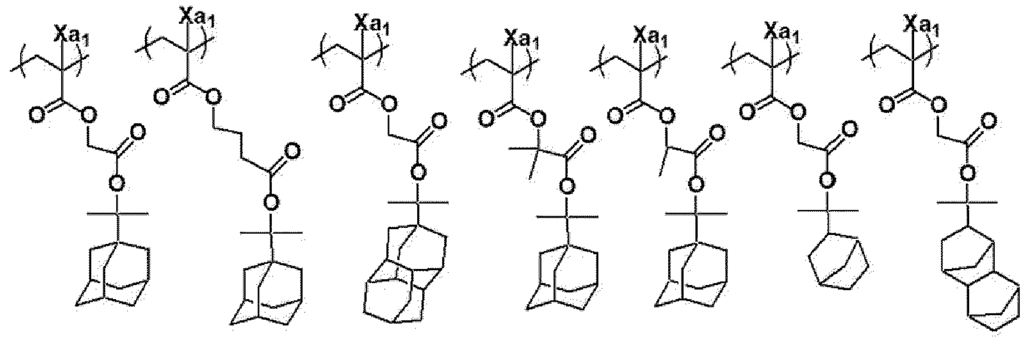

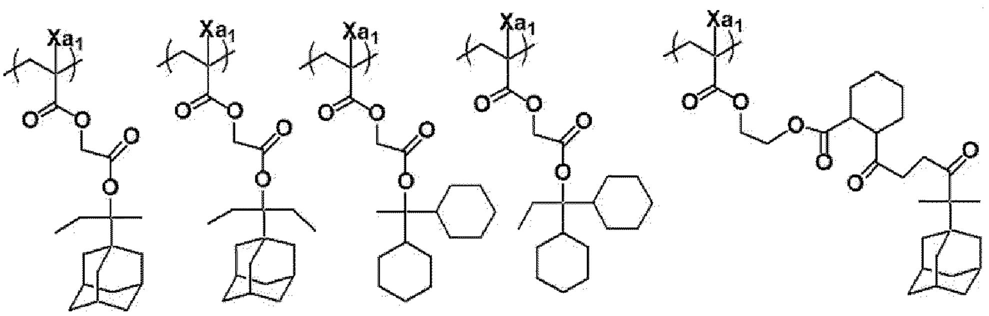

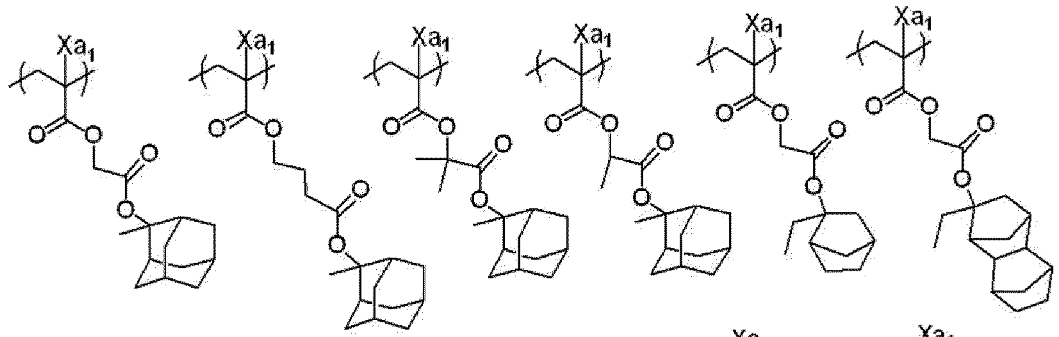

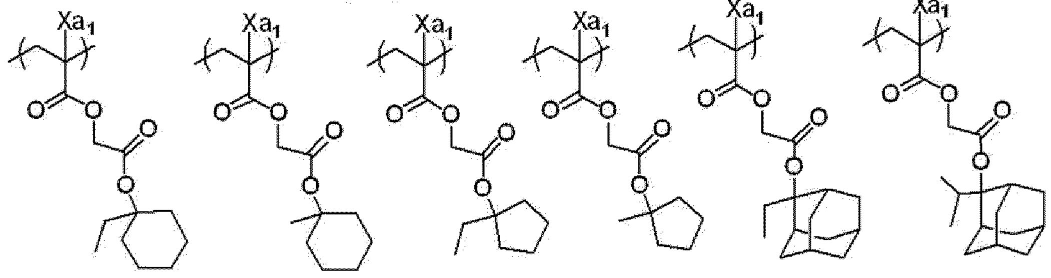

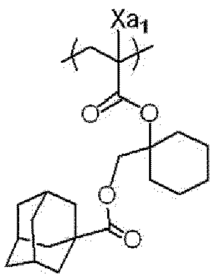

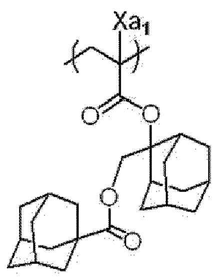

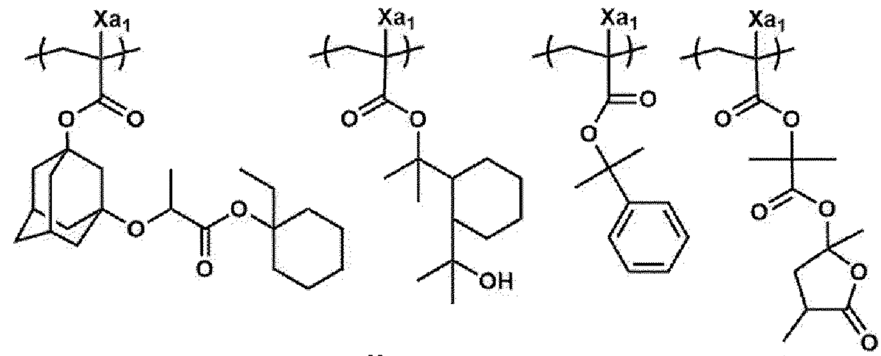

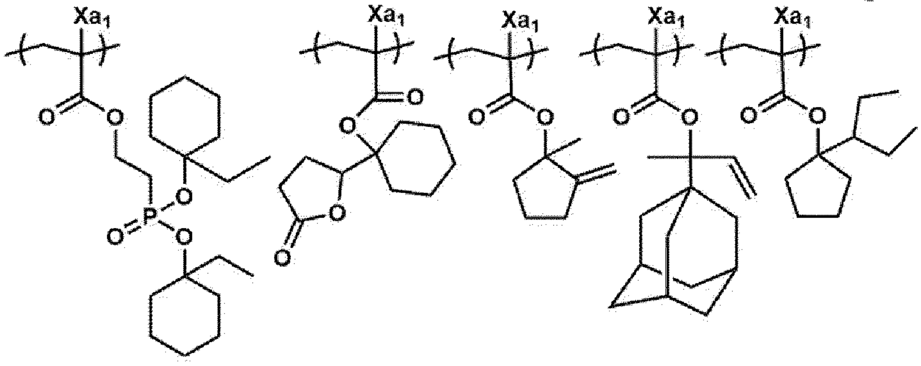

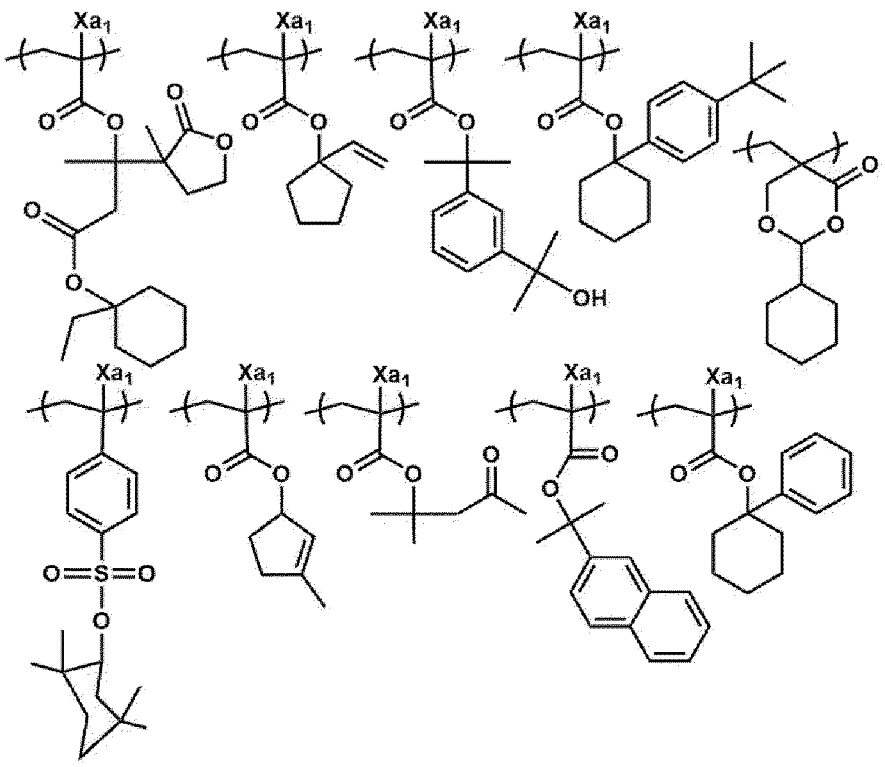

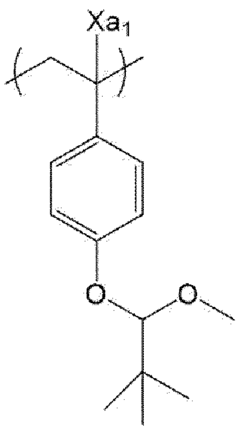

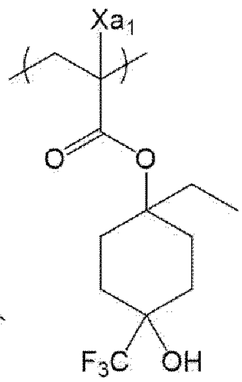

<Specific Repeating Unit: Requirement 2>

The resist composition of the embodiment of the present invention satisfies Requirement 2. That is, the resin (A) includes two or more repeating units (hereinafter also referred to as "specific repeating units") selected from the group consisting of a repeating unit represented by General Formula (A-1X) which will be described later, a repeating unit represented by General Formula (A-1Y) which will be described later, and a repeating unit including a lactone structure.

Hereinafter, the specific repeating unit will be described in detail.

(Repeating Unit Represented by General Formula (A-1X))

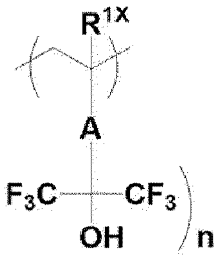

(A-1X)

In General Formula (A-1X), $R^{1X}$ represents a hydrogen atom, an alkyl group which may be substituted with a fluorine atom, or a halogen atom.

The alkyl group which may be substituted with a fluorine atom represented by $R^{1X}$ may be linear, branched, or cyclic but is preferably linear or branched. In addition, the number of carbon atoms of the alkyl group is not particularly limited, but is preferably 1 to 6, and more preferably 1 to 3.

As the alkyl group which may be substituted with the fluorine atom represented by $R^{1X}$, a methyl group or a trifluoromethyl group is preferable.

Examples of the halogen atom represented by $R^{1X}$ include a fluorine atom, a chlorine atom, a bromine atom, and an iodine atom, the fluorine atom or the iodine atom is preferable, and the fluorine atom is more preferable.

In General Formula (A-1X), A represents an (n+1)-valent linking group.

The (n+1)-valent linking group represented by A is not particularly limited, but is preferably a group represented by an (n+1)-valent hydrocarbon ring group, an (n+1)-valent heterocyclic group, or a group represented by General Formula (A-1XX) which will be described later.

Examples of the (n+1)-valent hydrocarbon ring group include an (n+1)-valent aliphatic hydrocarbon ring group and an (n+1)-valent aromatic hydrocarbon ring group. The number of ring members of the hydrocarbon ring constituting the (n+1)-valent hydrocarbon ring group is not particularly limited, but is preferably 5 to 10.

The aliphatic hydrocarbon ring constituting the (n+1)-valent aliphatic hydrocarbon ring group may have either a monocyclic structure or a polycyclic structure. Further, in a case where the aliphatic hydrocarbon ring has the polycyclic structure, it is preferable that at least one of the rings included in the polycyclic structure is a 5-membered ring or a 6-membered ring.

The number of carbon atoms in the aliphatic hydrocarbon ring is not particularly limited, but is preferably 5 to 10, and more preferably 5 or 6. Specific examples of the aliphatic hydrocarbon ring include a cyclopentane ring, a cyclohexane ring, a cycloheptane ring, a cyclooctane ring, a norbornene ring, and an adamantane ring. Among these, the cyclohexane ring, the norbornene ring, or the adamantane ring is preferable.

The aromatic hydrocarbon ring constituting the (n+1)-valent aromatic hydrocarbon ring group may have either a monocyclic structure or a polycyclic structure. Furthermore, in a case where the aromatic hydrocarbon ring has the polycyclic structure, it is preferable that at least one of the rings included in the polycyclic structure is a 5-membered ring or a 6-membered ring.

The number of carbon atoms in the aromatic hydrocarbon ring is not particularly limited, but is preferably 6 to 18, and more preferably 6 to 10. Specific examples of the aromatic hydrocarbon ring include a benzene ring, a naphthalene ring, an anthracene ring, a phenanthrene ring, and a fluorene ring. Among these, the benzene ring or the naphthalene ring is preferable, and the benzene ring is more preferable.

Examples of the (n+1)-valent heterocyclic group include an (n+1)-valent aliphatic heterocyclic group and an (n+1)-valent aromatic heterocyclic group. The number of ring members of the heterocycle constituting the (n+1)-valent heterocyclic group is not particularly limited, but is 5 to 10 in many cases.

The aliphatic heterocycle constituting the (n+1)-valent aliphatic heterocyclic group may have either a monocyclic structure or a polycyclic structure. Further, in a case where the aliphatic heterocycle has a polycyclic structure, it is preferable that at least one of the rings included in the polycyclic structure is a 5-membered ring or a 6-membered ring.

Examples of the heteroatom included in the aliphatic heterocycle include a nitrogen atom, an oxygen atom, and a sulfur atom. The number of ring members of the aliphatic heterocycle is not particularly limited, but is preferably 5 to 10. Specific examples of the aliphatic heterocycle include an oxolane ring, an oxane ring, a piperidine ring, and a piperazine ring. Further, the aliphatic heterocycle may be a ring in which $-CH_2-$ is substituted with -CO-, and examples thereof include a phthalimide ring.

The aromatic heterocycle constituting the (n+1)-valent aromatic heterocyclic group may have either a monocyclic structure or a polycyclic structure. Further, in a case where the aromatic heterocycle has the polycyclic structure, it is preferable that at least one of the rings included in the polycyclic structure is a 5-membered ring or a 6-membered ring.

Examples of the heteroatom included in the aromatic heterocyclic group include a nitrogen atom, an oxygen atom, and a sulfur atom. The number of ring members of the aromatic heterocycle is not particularly limited, but is preferably 5 to 18. Specific examples of the aromatic heterocycle include a pyridine ring, a pyridazine ring, a pyrimidine ring, a pyrazine ring, a triazine ring, a thiophene ring, a thiazole ring, and an imidazole ring.

Furthermore, the (n+1)-valent hydrocarbon ring group and the (n+1)-valent heterocyclic group exemplified as the (n+1)-valent linking group represented by A may further have a substituent.

Next, the above-mentioned group represented by General Formula (A-1XX) will be described.

$$*^{1}-L^{1X}-A^{1X}\left(L^{2X}-*^{2}\right)_{n} \qquad \text{(A-1XX)}$$

In General Formula (A-1XX), $L^{1X}$ represents a divalent linking group.

The divalent linking group represented by $L^{1X}$ is not particularly limited, but may be, for example, a divalent aliphatic hydrocarbon group (in which the divalent aliphatic hydrocarbon group may be linear, branched, or cyclic, and preferably has 1 to 20 carbon atoms, and examples thereof include an alkylene group, an alkenylene group, and an alkynylene group), -O-, -S-, $-SO_2-$, $-NR^{2x}-$, -CO-, and a group formed by combination of two or more kinds thereof. Here, $R^{2X}$ represents a hydrogen atom or an alkyl group (preferably having 1 to 10 carbon atoms). Further, the hydrogen atom in the divalent linking group may be substituted with another substituent such as a halogen atom.

As the divalent linking group represented by $L^{1X}$, an alkylene group having 1 to 20 carbon atoms, -O-, -CO-, or a group formed by combination of two or more kinds thereof is preferable.

In General Formula (A-1XX), $A^{1X}$ represents an (n+1)-valent hydrocarbon ring group or an (n+1)-valent heterocyclic group.

The (n+1)-valent hydrocarbon ring group and the (n+1)-valent heterocyclic group represented by $A^{1X}$ have the same definitions as the (n+1)-valent hydrocarbon ring group and (n+1)-valent heterocyclic group, exemplified by the (n+1)-valent linking group represented by A, respectively, and suitable aspects thereof are also the same.

In General Formula (A-1XX), $*^{1}$ represents a bonding position with the main chain (in other words, a bonding position with a carbon atom substituted with $R^{1X}$, which is specified in General Formula (A-1X)). $*^{2}$ represents a bonding position with a carbon atom substituted with a hydroxyl group, which is specified in General Formula (A-1X). n has the same definition as n in General Formula (A-1X).

As the (n+1)-valent linking group represented by A, the (n+1)-valent hydrocarbon ring group or a group represented by General Formula (A-1XX) which will be described later (provided that $A^{1X}$ represents a hydrocarbon ring) is preferable.

In General Formula (A-1XX), $L^{2X}$ represents a single bond or a divalent linking group.

The divalent linking group represented by $L^{2X}$ has the same definition as the above-mentioned divalent linking group represented by $L^{1X}$, and a suitable aspect thereof is also the same.

In General Formula (A-1X), n represents an integer of 1 or more.

n is not particularly limited, and is preferably 1 to 6, and more preferably 1 to 3.

The repeating unit represented by General Formula (A-1X) is preferably a repeating unit represented by General Formula (A-2X) or General Formula (A-3X).

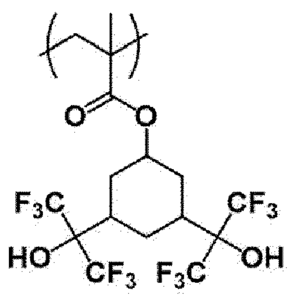

(A-2X)

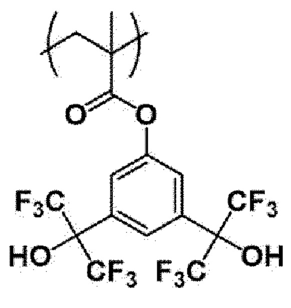

(A-3X)

Specific examples of the repeating unit represented by General Formula (A-1X) will be shown below. In the following specific examples, $R^c$ represents an alkyl group which may be substituted with a hydrogen atom, a halogen atom, or a fluorine atom.

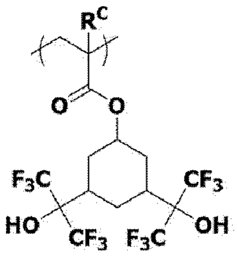
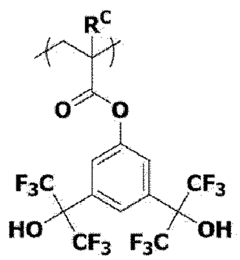
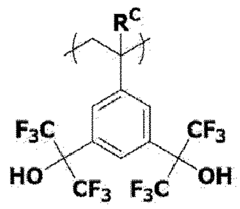
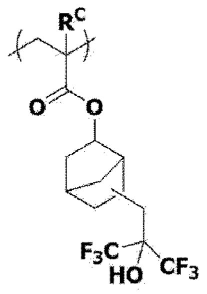
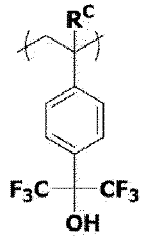
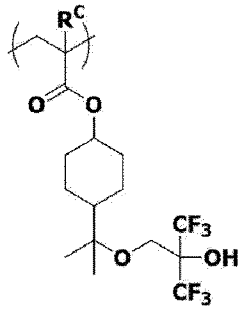
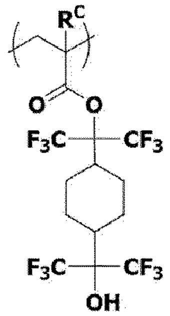

(Repeating Unit Represented by General Formula (A-1Y))

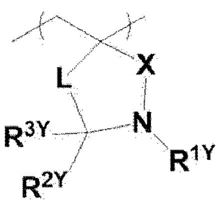

**(A-1Y)**

In General Formula (A-1Y), X represents -CO-, -SO-, or $-SO_2-$.
As X, -CO- is preferable among those.
In General Formula (A-1Y), $R^{1Y}$ to $R^{3Y}$ each independently represent a hydrogen atom or an organic group.
The organic group represented by each of $R^{1Y}$ to $R^{3Y}$ is not particularly limited, and examples thereof include an alkyl group (which may be linear, branched, or cyclic), an aryl group, an aralkyl group, an alkenyl group, an alkoxycarbonyl group (-COOR: R represents an alkyl group), and an alkylcarbonyloxy group (-OCOR: R represents an alkyl group). Further, a hydrogen atom in the alkyl group, the aryl group, the aralkyl group, the alkenyl group, the alkoxycarbonyl group, and the alkyl group in the alkylcarbonyloxy group may be substituted with a substituent. The substituent is not particularly limited, and examples thereof include a fluorine atom, an iodine atom, and a hydroxyl group.
In particular, as $R^{1Y}$, a hydrogen atom or a substituted or unsubstituted alkyl group having 1 to 6 carbon atoms is preferable, and the hydrogen atom is more preferable.
In addition, as $R^{2Y}$ and $R^{3Y}$, a hydrogen atom, a substituted or unsubstituted alkyl group having 1 to 10 carbon atoms, and a substituted or unsubstituted alkoxycarbonyl group (-COOR: R is an alkyl group having 1 to 10 carbon atoms), or a substituted or unsubstituted alkylcarbonyloxy group (-OCOR: R is an alkyl group having 1 to 10 carbon atoms) is preferable, and the hydrogen atom, an alkyl group having 1 to 6 carbon atoms, which may be substituted with a fluorine atom, a fluorinated alkyl group having 1 to 6 carbon atoms, which may be substituted with a hydroxyl group (for example, a hexafluoroisopropanol group), an alkoxycarbonyl group (-COOR: R is an alkyl group having 1 to 6 carbon atoms, which may be substituted with a fluorine atom), which may be substituted with a fluorine atom, or a substituted or unsubstituted alkylcarbonyloxy group (-OCOR: R is an alkyl group having 1 to 6 carbon atoms, which may be substituted with a fluorine atom) is more preferable. Among these, it is preferable that at least one of $R^{2Y}$ or $R^{3Y}$ is a group including a fluorine atom, such as an alkyl fluoride group.
In General Formula (A-1Y), L represents a divalent linking group including a heteroatom as a ring member atom.

Examples of the heteroatom include a nitrogen atom, an oxygen atom, and a sulfur atom.

As the divalent linking group represented by L, a group formed by combination of one or more selected from the group consisting of -O-, -S-, -N($R^{4Y}$)-, -SO-, and -$SO_2$- with an alkylene group having 1 to 6 carbon atoms, which may have a substituent, or -O-, -S-, -N($R^{4Y}$)-, -SO-, or -$SO_2$- is preferable; a group formed by combination of one or more selected from the group consisting of -O-, -S-, and -N($R^{4Y}$)- with an alkylene group having 1 to 3 carbon atoms, which may have a substituent, or -O-, -S-, or -N($R^{4Y}$)- is more preferable; and an -O-methylene group which may have a substituent- or -S-methylene group which may have a substituent- is still more preferable.

$R^{4Y}$ represents a hydrogen atom or a substituent. Examples of the substituent represented by $R^{4Y}$ include an alkyl group having 1 to 10 carbon atoms.

In General Formula (A-1Y), the number of ring members of a ring formed of X, N, L, a carbon atom bonded to the main chain specified in the formula, and a carbon atom substituted with $R^{2Y}$ and $R^{3Y}$ specified in the formula the atoms is not particularly limited, but is preferably 5 to 8, more preferably 5 or 6, and still more preferably 6.

Specific examples of the repeating unit represented by General Formula (A-1Y) will be shown below.

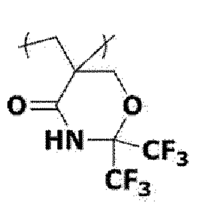
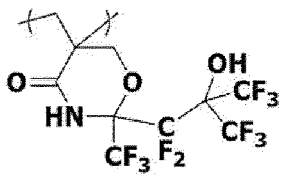

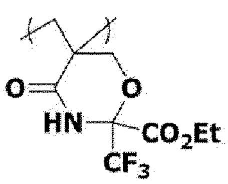
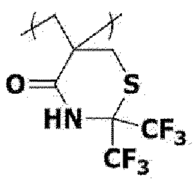
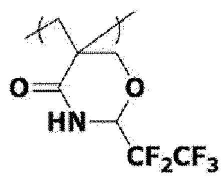

(Repeating Unit Including Lactone Structure)

The lactone structure is not particularly limited, but is preferably a 5- to 7-membered ring lactone structure, and more preferably a 5- to 7-membered ring lactone structure to which another ring structure is fused to form a bicyclo structure or spiro structure.

The lactone structural moiety may have a substituent. The substituent is not particularly limited, but above all, an electron-withdrawing group is preferable. Examples of the electron-withdrawing group include an alkoxycarbonyl group having 1 to 8 carbon atoms, a carboxyl group, a halogen atom, an alkyl halide group, and a cyano group.

Specifically, as the repeating unit including a lactone structure, a repeating unit having a lactone group formed by extracting one or more hydrogen atoms from a ring member atom of a lactone structure represented by any of General Formulae (LC1-1) to (LC1-21) is preferable. The repeating unit including a lactone structure may be either a repeating unit having the lactone group in a side chain or a repeating unit having the lactone group directly bonded to the main chain (specifically intended to mean a repeating unit in which a ring member atom of a lactone group constitutes the main chain.).

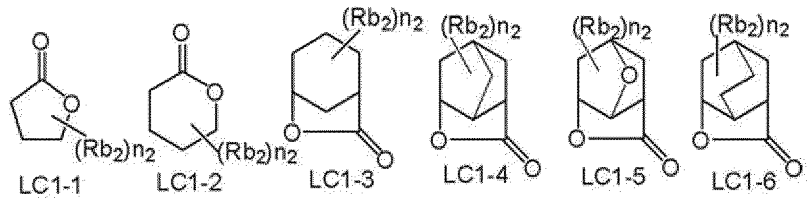
LC1-1 LC1-2 LC1-3 LC1-4 LC1-5 LC1-6

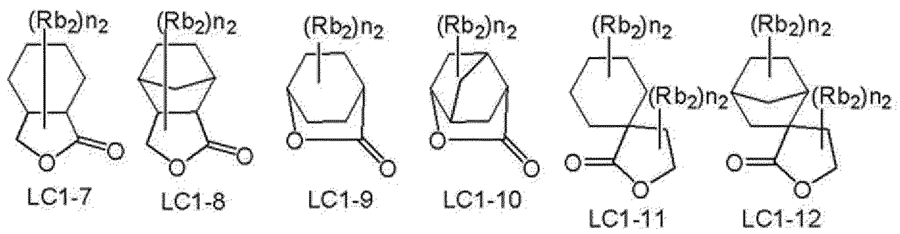

LC1-7 LC1-8 LC1-9 LC1-10 LC1-11 LC1-12

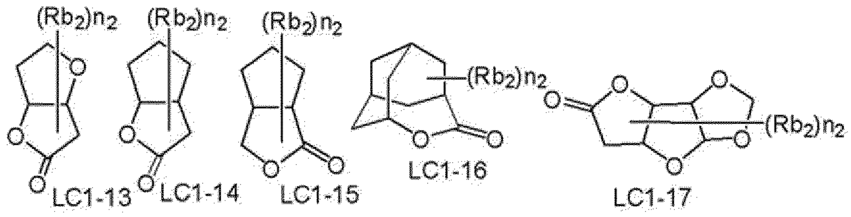

LC1-13 LC1-14 LC1-15 LC1-16 LC1-17

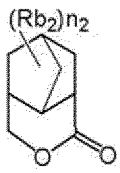

LC1-18

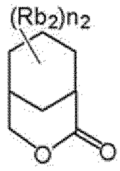

LC1-19

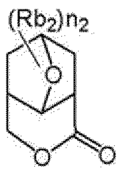

LC1-20

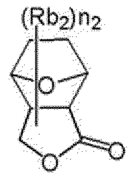

LC1-21

In General Formulae (LC1-1) to (LC1-21), $Rb_2$ represents a substituent. As the substituent represented by $Rb_2$, an electron-withdrawing group is preferable. The electron-withdrawing group is as described above. n2 represents an integer of 0 to 4. In a case where n2 is 2 or more, $Rb_2$'s which are present in a plural number may be different from each other, and $Rb_2$'s which are present in a plural number may be bonded to each other to form a ring.

Examples of the repeating unit having a lactone structure represented by any of General Formulae (LC1-1) to (LC1-21) include a repeating unit represented by General Formula (A-1Z).

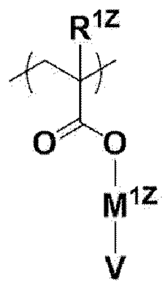

**(A-1Z)**

In General Formula (AI), $R^{1Z}$ represents a hydrogen atom, a halogen atom, or an alkyl group which may have a substituent.

The alkyl group represented by $R^{1Z}$ preferably has 1 to 4 carbon atoms, and is more preferably a methyl group. In addition, examples of the substituent which may be contained in the alkyl group include a hydroxyl group and a halogen atom.

Examples of the halogen atom represented by $R^{1Z}$ include a fluorine atom, a chlorine atom, a bromine atom, and an iodine atom.

As $R^{1Z}$, the hydrogen atom or the alkyl group which may have a substituent is preferable, and the hydrogen atom or the methyl group is more preferable.

$M^{1Z}$ represents a single bond or a divalent linking group.

The divalent linking group represented by $M^{1Z}$ is not particularly limited, but is a linear or branched alkylene group, a cycloalkylene group (which is either monocyclic or polycyclic), -O-, -CO-, or a group formed by combination of two or more of these groups.

As the divalent linking group represented by $M^{1Z}$, a linking group represented by -$M^{1ZX}$-COO- or -$M^{1ZX}$-OCO- is preferable. $M^{1ZX}$ represents a linear or branched alkylene group, or a monocyclic or polycyclic cycloalkylene group, and is preferably a methylene group, an ethylene group, a cyclohexylene group, an adamantylene group, or a norbornylene group, and more preferably the methylene group or the ethylene group. Further, these groups may further have a substituent.

V represents a group formed by extracting one hydrogen atom from ring member atoms of a lactone structure represented by any of General Formulae (LC1-1) to (LC1-21).

As the repeating unit represented by General Formula (A-1Z), above all, a repeating unit represented by General Formula (A-2Z) is preferable.

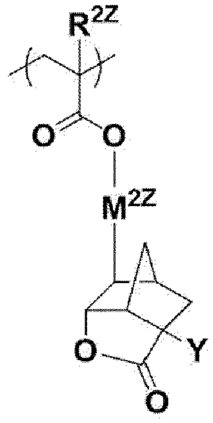

(A-2Z)

In General Formula (A-2Z), $R^{2Z}$ represents a hydrogen atom or an alkyl group which may have a substituent.

The alkyl group which may have a substituent represented by $R^{2Z}$ has the same definition as the alkyl group which may have a substituent represented by $R^{1Z}$ in General Formula (A-1Z), and a suitable aspect thereof is the same.

$M^{2Z}$ represents a single bond or a divalent linking group.

The divalent linking group represented by $M^{2Z}$ has the same definition as the divalent linking group represented by $M^{1Z}$ in General Formula (A-1Z), and a suitable aspect thereof is also the same.

Y represents a hydrogen atom or an electron-withdrawing group.

The electron-withdrawing group is not particularly limited, and examples thereof include an alkoxycarbonyl group having 1 to 8 carbon atoms, a carboxyl group, a halogen atom, an alkyl halide group, and a cyano group. As the electron-withdrawing group, the halogen atom or the cyano group is preferable, and a fluorine atom or the cyano group is more preferable.

In a case where optical isomers of the repeating unit having a lactone structure are present, any of the optical isomers may be used. In addition, one optical isomer may be used alone or a mixture of a plurality of the optical isomers may be used. In a case where one optical isomer is mainly used, the optical purity (ee) thereof is preferably 90 or more, and more preferably 95 or more.

The repeating units having a lactone structure are exemplified below.

(in the formulae, Rx represents H, $CH_3$, $CH_2OH$, of $CF_3$)

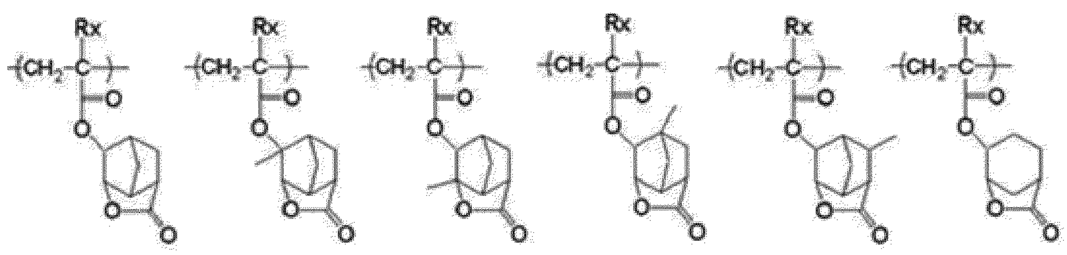

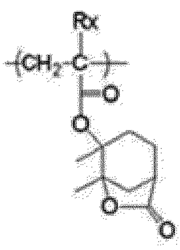
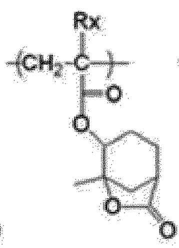
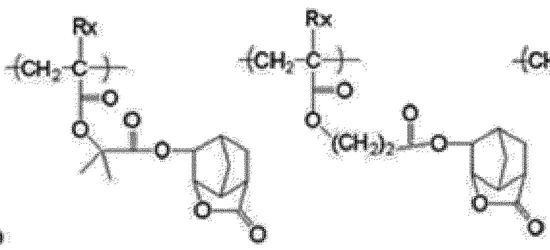
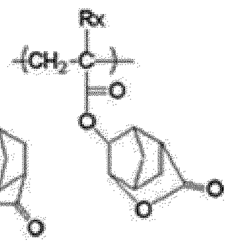

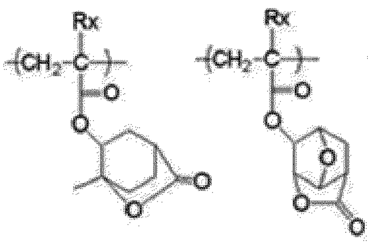
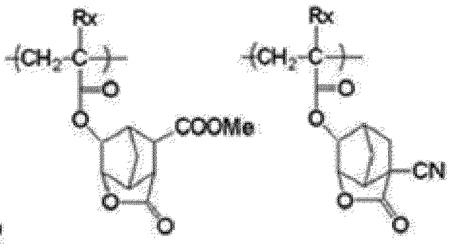
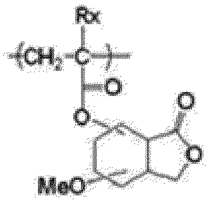

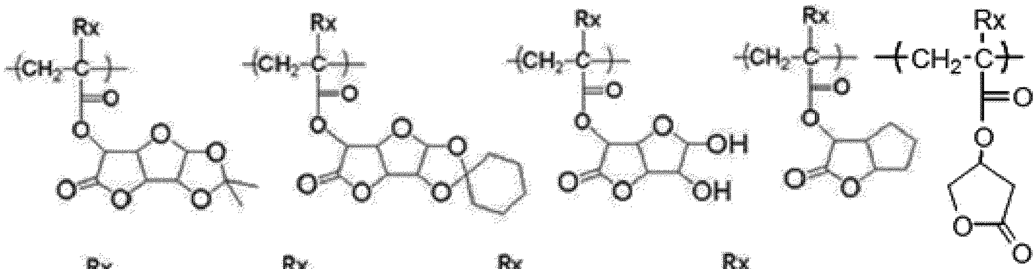

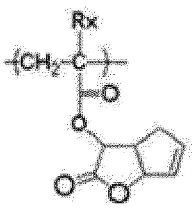
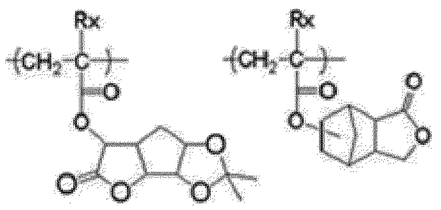
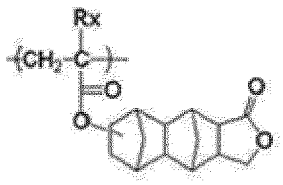

(in the formulae, Rx represents H, $CH_3$, $CH_2OH$, or $CF_3$)

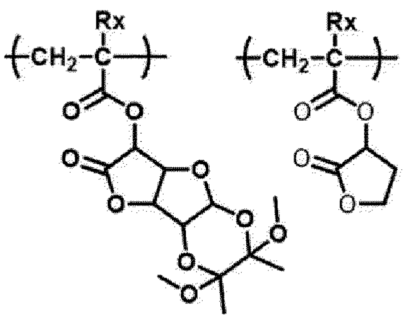
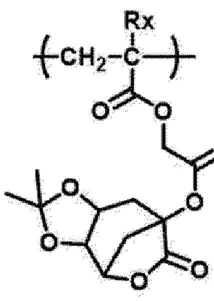
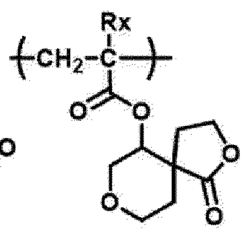

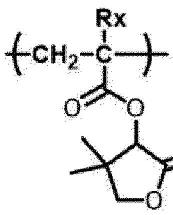
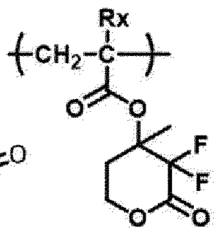
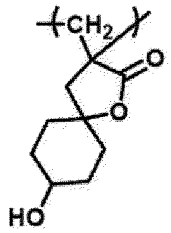

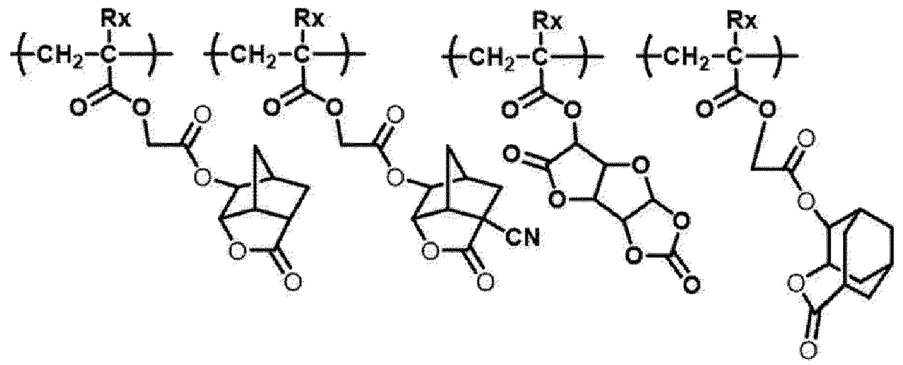

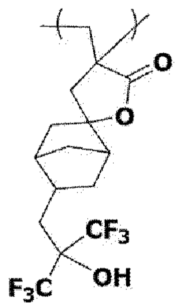

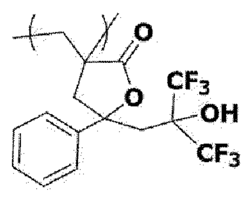

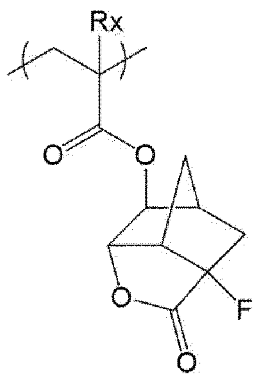

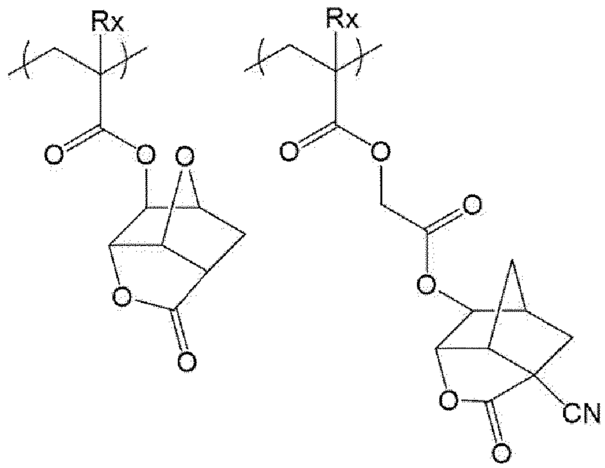

The resin (A) includes two or more of the above-mentioned specific repeating units.

In a case where the resin (A) includes the above-mentioned repeating unit represented by General Formula (A-1X) as a specific repeating unit, and the repeating unit represented by General Formula (A-1X) includes the above-mentioned repeating unit represented by General Formula (A-2X) or the above-mentioned repeating unit represented by General Formula (A-3X), a pattern in which a film thickness reduction is further suppressed can be formed.

In a case where the resin (A) includes repeating unit including a lactone structure as a specific repeating unit, and the repeating unit including a lactone structure includes the above-mentioned repeating unit represented by General Formula (A-2Z), a pattern in which bridge defects are further suppressed can be formed.

The total content of the specific repeating units is preferably 15% by mass or more, more preferably 20% by mass or more, and still more preferably 30% by mass or more with respect to all repeating units in the resin (A). In addition, an upper limit value thereof is preferably 80% by mass or less, more preferably 70% by mass or less, and still more preferably 60% by mass or less.

The resin (A) may include a repeating unit other than the above-mentioned repeating units.

For example, the resin (A) preferably includes at least one repeating unit selected from the group consisting of the following groups A.

Group A: A group consisting of the following repeating units (20) to (29).

(20) A repeating unit having an acid group, which will be described later.

(21) A repeating unit having a fluorine atom or an iodine atom, which will be described later.
(22) A repeating unit having a sultone group or a carbonate group, which will be described later.
(23) A repeating unit having a photoacid generating group, which will be described later.
(24) A repeating Unit represented by General Formula (V-1) or General Formula (V-2), which will be described later.
(25) A repeating unit represented by Formula (A), which will be described later.
(26) A repeating unit represented by Formula (B), which will be described later.
(27) A repeating unit represented by Formula (C), which will be described later.
(28) A repeating unit represented by Formula (D), which will be described later.
(29) A repeating unit represented by Formula (E), which will be described later.

The resin (A) preferably includes at least one of a fluorine atom or an iodine atom from the viewpoint that a resist film formed of the resist composition of the embodiment of the present invention has an excellent EUV absorption efficiency. In addition, in a case where the resin (A) includes both a fluorine atom and an iodine atom, the resin (A) may have one repeating unit including both a fluorine atom and an iodine atom, and may also include two kinds of repeating units, that is, a repeating unit including a fluorine atom and a repeating unit including an iodine atom.
Moreover, the resin (A) preferably has a repeating unit having an aromatic group from the viewpoint that the resist film formed of the resist composition of the embodiment of the present invention has an excellent EUV absorption efficiency.

<Repeating Unit Having Acid Group>

The resin (A) may have a repeating unit having an acid group.
The resin (A) may have a repeating unit having an acid group in addition to <Repeating Unit Having Acid-Decomposable Group> and <Specific Repeating Unit> mentioned above. In addition, <Repeating Unit Having Acid Group> as mentioned herein is preferably different from other kinds of repeating units belonging to the group A, such as <Repeating Unit Having Fluorine Atom or Iodine Atom>, <Repeating Unit Having Sultone Group or Carbonate Group>, and <Repeating Unit Having Photoacid Generating Group>, which will be described later.
As the acid group, an acid group having a pKa of 13 or less is preferable.
As the acid group, for example, a carboxyl group, a phenolic hydroxyl group, a fluorinated alcohol group (preferably a hexafluoroisopropanol group), a sulfonic acid group, a sulfonamide group, or an isopropanol group is preferable.
In addition, in the hexafluoroisopropanol group, one or more (preferably one or two) fluorine atoms may be substituted with a group (an alkoxycarbonyl group and the like) other than a fluorine atom. $-C(CF_3)(OH)-CF_2-$ formed as above is also preferable as the acid group. In addition, one or more fluorine atoms may be substituted with a group other than a fluorine atom to form a ring including $-C(CF_3)(OH)-CF_2-$.
The repeating unit having an acid group may have a fluorine atom or an iodine atom.
As the repeating unit having an acid group, a repeating unit represented by Formula (B) is preferable.

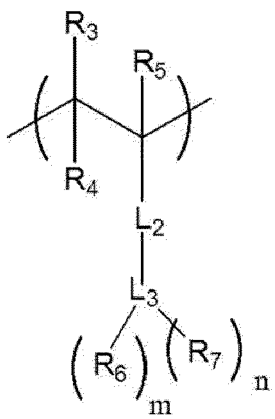

(B)

$R_3$ represents a hydrogen atom or a monovalent organic group which may have a fluorine atom or an iodine atom.
As the monovalent organic group which may have a fluorine atom or an iodine atom, a group represented by $-L_4-R_8$ is preferable. $L_4$ represents a single bond or an ester group. Examples of $R_8$ include an alkyl group which may have a fluorine atom or an iodine atom, a cycloalkyl group which may have a fluorine atom or an iodine atom, an aryl group which may have a fluorine atom or an iodine atom, or a group formed by combination thereof.
$R_4$ and $R_5$ each independently represent a hydrogen atom, a fluorine atom, an iodine atom, or an alkyl group

which may have a fluorine atom or an iodine atom.

$L_2$ represents a single bond or an ester group.

$L_3$ represents an (n+m+1) -valent aromatic hydrocarbon ring group or an (n+m+1) -valent alicyclic hydrocarbon ring group. Examples of the aromatic hydrocarbon ring group include a benzene ring group and a naphthalene ring group. The alicyclic hydrocarbon ring group may be either a monocycle or a polycycle, and examples thereof include a cycloalkyl ring group. Among those, $L_3$ is preferably the (n+m+1) -valent aromatic hydrocarbon ring group.

$R_6$ represents a hydroxyl group.

$R_7$ represents a halogen atom. Examples of the halogen atom include a fluorine atom, a chlorine atom, a bromine atom, and an iodine atom.

m represents an integer of 1 or more. m is preferably an integer of 1 to 3, and more preferably an integer of 1 or 2.

n represents an integer of 0, or 1 or more. n is preferably an integer of 1 to 4.

In addition, (n+m+1) is preferably an integer of 1 to 5.

As the repeating unit having an acid group, a repeating unit represented by General Formula (I) is also preferable.

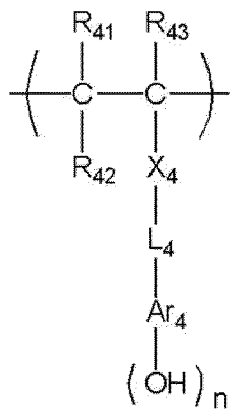

(I)

In General Formula (I),

$R_{41}$, $R_{42}$, and $R_{43}$ each independently represent a hydrogen atom, an alkyl group, a cycloalkyl group, a halogen atom, a cyano group, or an alkoxycarbonyl group. It should be noted that $R_{42}$ may be bonded to $Ar_4$ to form a ring, and in this case, $R_{42}$ represents a single bond or an alkylene group.

$X_4$ represents a single bond, -COO-, or -$CONR_{64}$-, and $R_{64}$ represents a hydrogen atom or an alkyl group.

$L_4$ represents a single bond or an alkylene group.

$Ar_4$ represents an (n+1)-valent aromatic ring group, and in a case where $Ar_4$ is bonded to $R_{42}$ to form a ring, $Ar_4$ represents an (n+2)-valent aromatic ring group.

n represents an integer of 1 to 5.

As the alkyl group of each of $R_{41}$, $R_{42}$, and $R_{43}$ in General Formula (I), an alkyl group having 20 or less carbon atoms, such as a methyl group, an ethyl group, a propyl group, an isopropyl group, an n-butyl group, a sec-butyl group, a hexyl group, a 2-ethylhexyl group, an octyl group, and a dodecyl group, is preferable, an alkyl group having 8 or less carbon atoms is more preferable, and an alkyl group having 3 or less carbon atoms is still more preferable.

The cycloalkyl group of each of $R_{41}$, $R_{42}$, and $R_{43}$ in General Formula (I) may be monocyclic or polycyclic. Among those, a monocyclic cycloalkyl group having 3 to 8 carbon atoms, such as a cyclopropyl group, a cyclopentyl group, and a cyclohexyl group, is preferable.

Examples of the halogen atom of each of $R_{41}$, $R_{42}$, and $R_{43}$ in General Formula (I) include a fluorine atom, a chlorine atom, a bromine atom, and an iodine atom, and the fluorine atom is preferable.

As the alkyl group included in the alkoxycarbonyl group of each of $R_{41}$, $R_{42}$, and $R_{43}$ in General Formula (I), the same ones as the alkyl group in each of $R_{41}$, $R_{42}$, and $R_{43}$ are preferable.

Preferred examples of the substituent in each of the groups include an alkyl group, a cycloalkyl group, an aryl group, an amino group, an amide group, a ureide group, a urethane group, a hydroxyl group, a carboxyl group, a halogen atom, an alkoxy group, a thioether group, an acyl group, an acyloxy group, an alkoxycarbonyl group, a cyano group, and a nitro group. The number of carbon atoms of the substituent is preferably 8 or less.

$Ar_4$ represents an (n+1)-valent aromatic ring group. The divalent aromatic ring group in a case where n is 1 is preferably, for example, an arylene group having 6 to 18 carbon atoms, such as a phenylene group, a tolylene group, a naphthylene group, and an anthracenylene group, or a divalent aromatic ring group including a heterocycle such as a thiophene ring, a furan ring, a pyrrole ring, a benzothiophene ring, a benzofuran ring, a benzopyrrole ring, a triazine

ring, an imidazole ring, a benzimidazole ring, a triazole ring, a thiadiazole ring, and a thiazole ring. Furthermore, the aromatic ring group may have a substituent.

Specific examples of the (n+1)-valent aromatic ring group in a case where n is an integer of 2 or more include groups formed by excluding any (n-1) hydrogen atoms from the above-mentioned specific examples of the divalent aromatic ring group.

The (n+1)-valent aromatic ring group may further have a substituent.

Examples of the substituent which can be contained in the alkyl group, the cycloalkyl group, the alkoxycarbonyl group, the alkylene group, and the (n+1)-valent aromatic ring group, each mentioned above, include the alkyl groups; the alkoxy groups such as a methoxy group, an ethoxy group, a hydroxyethoxy group, a propoxy group, a hydroxypropoxy group, and a butoxy group; the aryl groups such as a phenyl group; and the like, as mentioned for each of $R_{41}$, $R_{42}$, and $R_{43}$ in General Formula (I).

Examples of the alkyl group of $R_{64}$ in $-CONR_{64}-$ represented by $X_4$ ($R_{64}$ represents a hydrogen atom or an alkyl group) include an alkyl group having 20 or less carbon atoms, such as a methyl group, an ethyl group, a propyl group, an isopropyl group, an n-butyl group, a sec-butyl group, a hexyl group, a 2-ethylhexyl group, an octyl group, and a dodecyl group, and an alkyl group having 8 or less carbon atoms, is preferable.

As $X_4$, a single bond, -COO-, or -CONH- is preferable, and the single bond or -COO- is more preferable.

As the alkylene group in $L_4$, an alkylene group having 1 to 8 carbon atoms, such as a methylene group, an ethylene group, a propylene group, a butylene group, a hexylene group, and an octylene group, is preferable.

As $Ar_4$, an aromatic ring group having 6 to 18 carbon atoms is preferable, and a benzene ring group, a naphthalene ring group, and a biphenylene ring group are more preferable.

The repeating unit represented by General Formula (I) preferably comprises a hydroxystyrene structure. That is, $Ar_4$ is preferably a benzene ring group.

As the repeating unit represented by General Formula (I), a repeating unit represented by General Formula (1) is preferable.

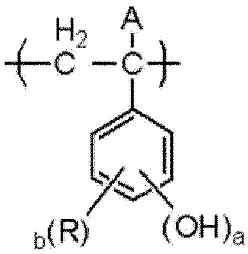

(1)

In General Formula (1),

A represents a hydrogen atom, an alkyl group, a cycloalkyl group, a halogen atom, or a cyano group.

R represents a halogen atom, an alkyl group, a cycloalkyl group, an aryl group, an alkenyl group, an aralkyl group, an alkoxy group, an alkylcarbonyloxy group, an alkylsulfonyloxy group, an alkyloxycarbonyl group, or an aryloxycarbonyl group, and in a case where R's are present in a plural number, they may be the same as or different from each other. In a case where a plurality of R's are included, they may be combined with each other to form a ring. As R, the hydrogen atom is preferable.

a represents an integer of 1 to 3.

b represents an integer of 0 to (5-a).

The repeating unit having an acid group is exemplified below. In the formulae, a represents 1 or 2.

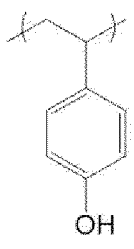 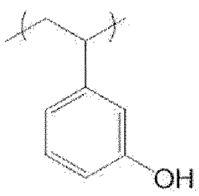 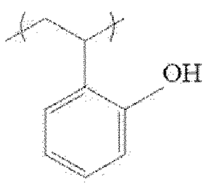

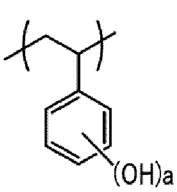
(B-1)

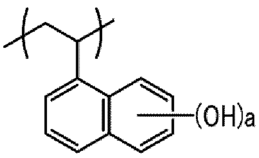
(B-2)

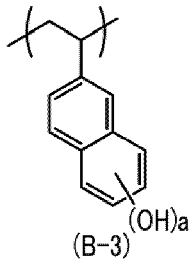
(B-3)

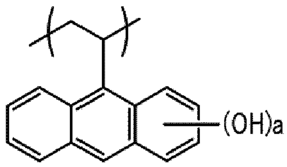
(B-4)

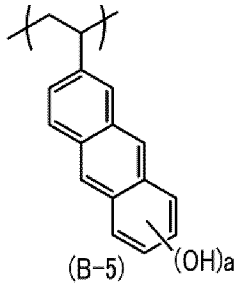
(B-5)

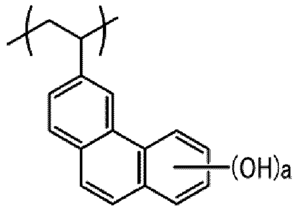
(B-6)

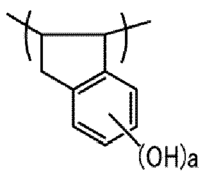
(B-7)

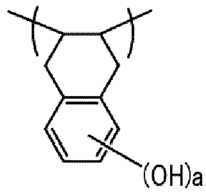
(B-8)

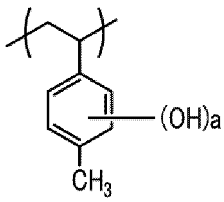
(B-9)

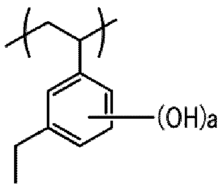
(B-10)

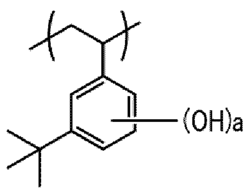
(B-11)

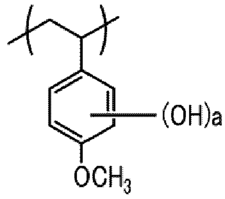
(B-12)

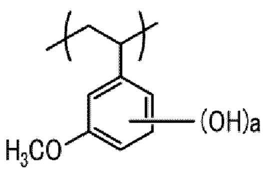
(B-13)

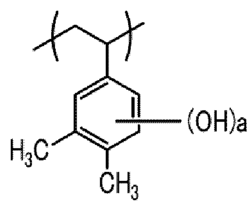
(B-14)

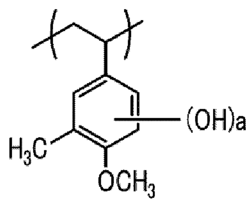
(B-15)

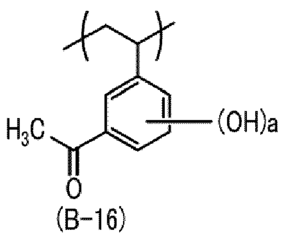
(B-16)

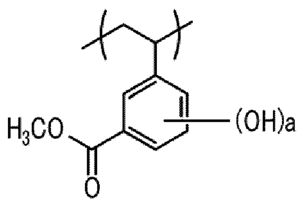
(B-17)

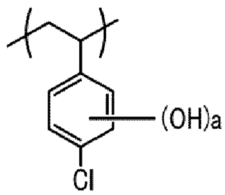
(B-18)

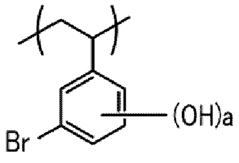

(B-19)

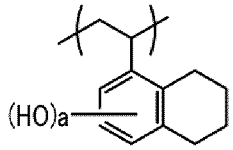

(B-20)

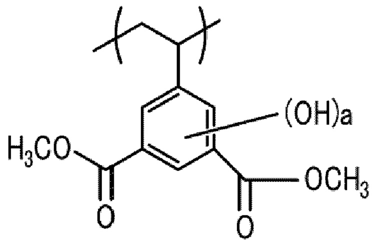

(B-21)

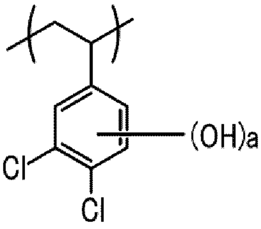

(B-22)

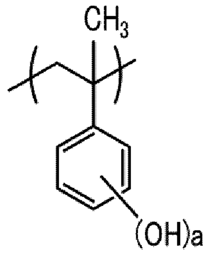

(B-23)

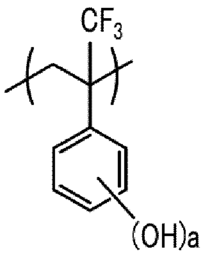

(B-24)

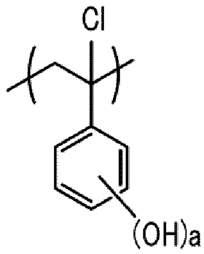

(B-25)

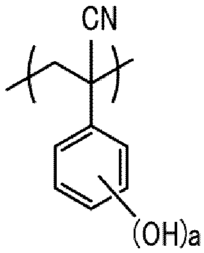

(B-26)

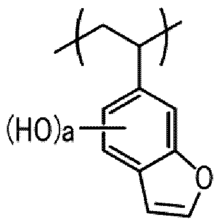

(B-27)

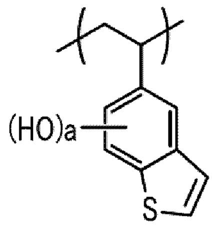

(B-28)

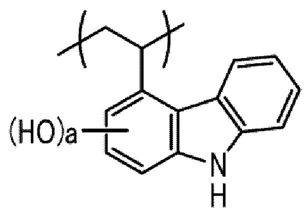

(B-29)

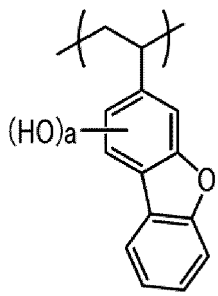

(B-30)

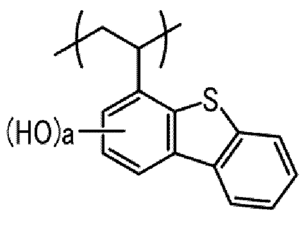

(B-31)

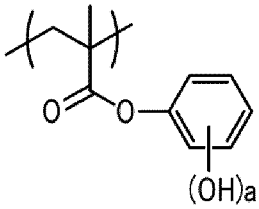

(B-32)

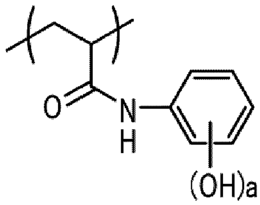

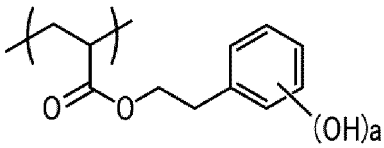

(B-33) (B-34)

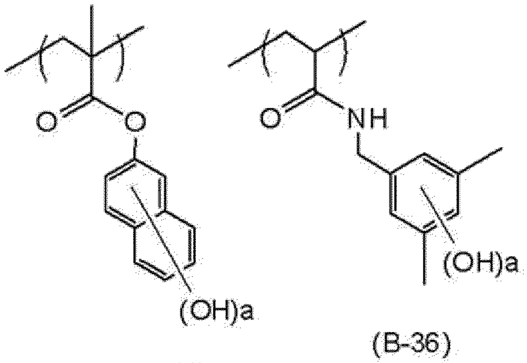

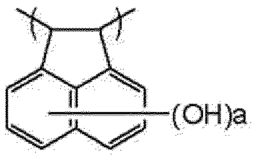

(B-37)

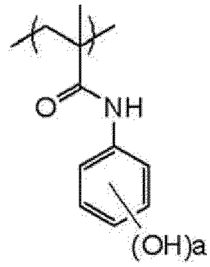

(B-35) (B-36) (B-38)

Moreover, among the repeating units, the repeating units specifically described below are preferable. In the formulae, R represents a hydrogen atom or a methyl group, and a represents 2 or 3.

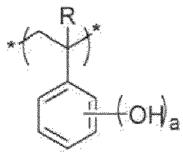

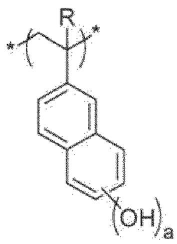

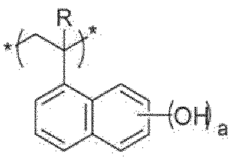

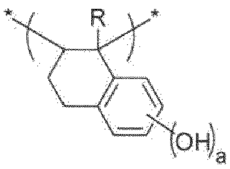

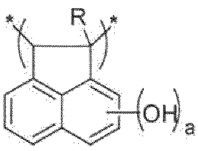

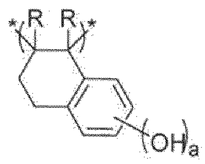

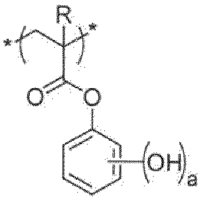

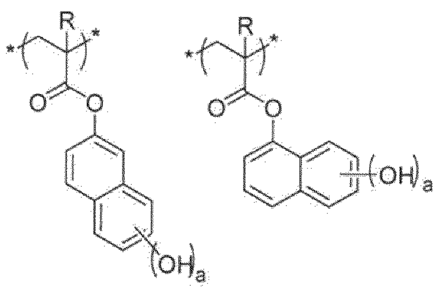

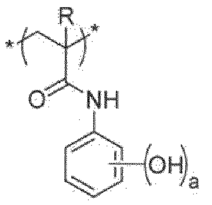
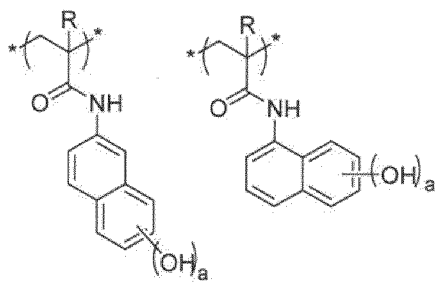

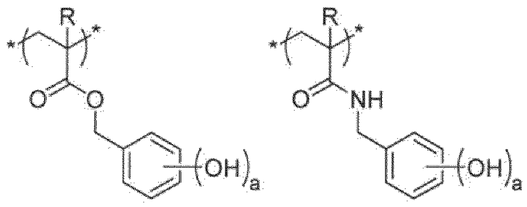

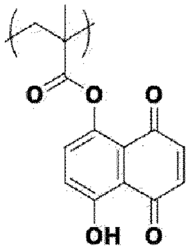
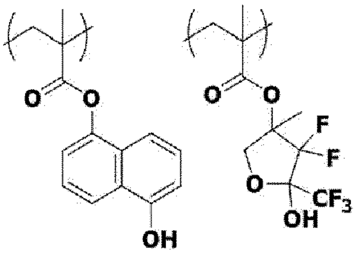
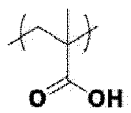
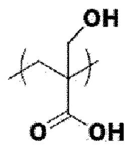

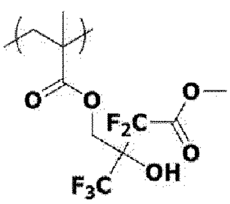
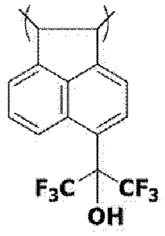
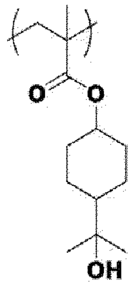
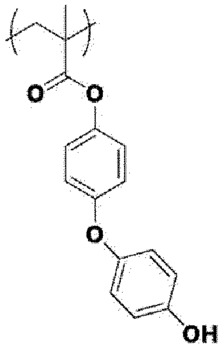

The content of the repeating unit having an acid group is preferably 10% by mass or more, and more preferably 15% by mass or more with respect to all repeating units in the resin (A). Further, an upper limit value thereof is preferably 70% by mass or less, more preferably 65% by mass or less, and still more preferably 60% by mass or less.

<Repeating Unit Having Fluorine Atom or Iodine Atom>

The resin (A) may have a repeating unit having a fluorine atom or an iodine atom in addition to the above-mentioned <Repeating Unit Having Acid-Decomposable Group>, <Specific Repeating Unit>, and <Repeating Unit Having Acid Group>. In addition, <Repeating Unit Having Fluorine Atom or Iodine Atom> as mentioned herein is preferably different from other kinds of repeating units belonging to the group A, such as <Repeating Unit Sultone Group or Carbonate Group> and <Repeating Unit Having Photoacid Generating Group>, which will be described later.

As the repeating unit having a fluorine atom or an iodine atom, a repeating unit represented by Formula (C) is preferable.

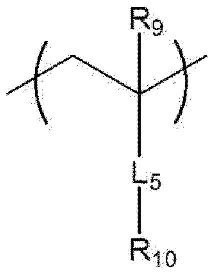

(C)

$L_5$ represents a single bond or an ester group.

$R_9$ represents a hydrogen atom, or an alkyl group which may have a fluorine atom or an iodine atom.

$R_{10}$ represents a hydrogen atom, an alkyl group which may have a fluorine atom or an iodine atom, a cycloalkyl group which may have a fluorine atom or an iodine atom, an aryl group which may have a fluorine atom or an iodine atom, or a group formed by combination thereof.

The repeating unit having a fluorine atom or an iodine atom will be exemplified below.

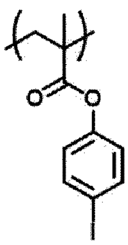
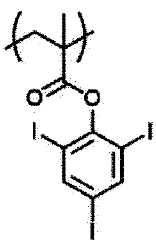
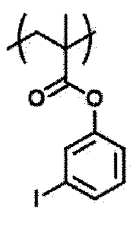
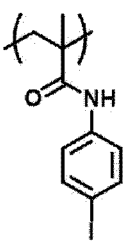
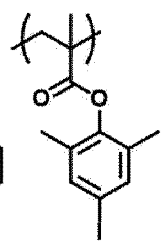
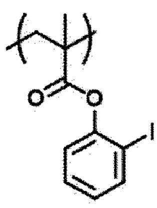

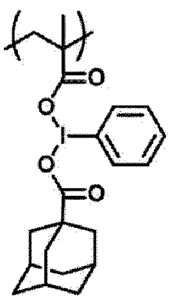
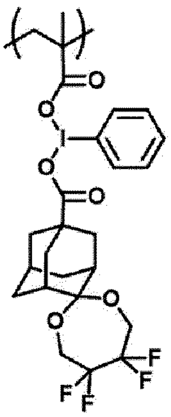
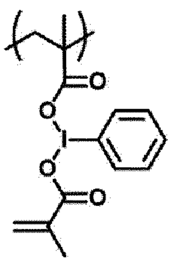

The content of the repeating unit having a fluorine atom or an iodine atom is preferably 5% by mass or more, and more preferably 10% by mass or more with respect to all repeating units in the resin (A). Further, an upper limit value thereof is preferably 50% by mass or less, more preferably 45% by mass or less, and still more preferably 40% by mass or less.

The total content of the repeating units including at least one of a fluorine atom or an iodine atom in the repeating units of the resin (A) is preferably 20% by mass or more, more preferably 30% by mass or more, and still more preferably 40% by mass or more with respect to all repeating units of the resin (A). An upper limit value thereof is not particularly limited, but is, for example, 100% by mass or less.

In addition, examples of the repeating unit including at least one of a fluorine atom or an iodine atom include a repeating unit represented by General Formula (A-1X) in a specific repeating unit, a repeating unit which has a fluorine atom or an iodine atom, and has an acid group, and a repeating unit having a fluorine atom or an iodine atom.

<Repeating Unit Having Sultone Group or Carbonate Group>

The resin (A) may include a repeating unit having at least one selected from the group consisting of a sultone group and a carbonate group (hereinafter also collectively referred to as a "repeating unit having a sultone group or a carbonate group").

It is also preferable that the repeating unit having a sultone group or a carbonate group has no acid group such as a hexafluoropropanol group.

(Repeating Unit Having Sultone Group)

The sultone group is not limited as long as it has a sultone structure.

As the sultone structure, 5- to 7-membered ring sultone structures are preferable, and among these, 5- to 7-membered ring sultone structures to which another ring structure is fused to form a bicyclo structure or spiro structure are more preferable.

The resin (A) preferably has a repeating unit having a sultone group, formed by extracting one or more hydrogen atoms from a ring member atom of a sultone structure represented by any of General Formulae (SL1-1) to (SL1-3). Further, the sultone group may be directly bonded to the main chain. For example, a ring member atom of the sultone group may constitute the main chain of the resin (A).

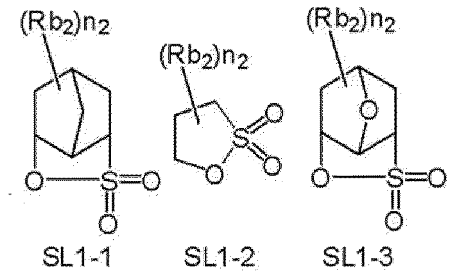

SL1-1 SL1-2 SL1-3

The sultone structural moiety may have a substituent ($Rb_2$). Preferred examples of the substituent ($Rb_2$) include an alkyl group having 1 to 8 carbon atoms, a cycloalkyl group having 4 to 7 carbon atoms, an alkoxy group having 1 to 8 carbon atoms, an alkoxycarbonyl group having 1 to 8 carbon atoms, a carboxyl group, a halogen atom, a hydroxyl group, a cyano group, and an acid-decomposable group. n2 represents an integer of 0 to 4. In a case where n2 is 2 or more, $Rb_2$'s which are present in plural number may be the same as or different from each other, and $Rb_2$'s which are present in plural number may be bonded to each other to form a ring.

Examples of the repeating unit having a group having a sultone structure represented by any of General Formulae (SL1-1) to (SL1-3) include a repeating unit represented by General Formula (AI).

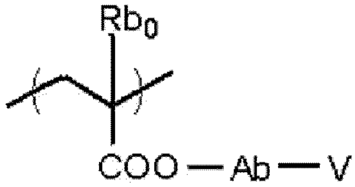

(AI)

In General Formula (AI), $Rb_0$ represents a hydrogen atom, a halogen atom, or an alkyl group having 1 to 4 carbon atoms.

Preferred examples of the substituent which may be contained in the alkyl group of $Rb_0$ include a hydroxyl group and a halogen atom.

Examples of the halogen atom of $Rb_0$ include a fluorine atom, a chlorine atom, a bromine atom, and an iodine atom. As $Rb_0$, a hydrogen atom or a methyl group is preferable.

Ab represents a single bond, an alkylene group, a divalent linking group having a monocyclic or polycyclic alicyclic hydrocarbon structure, an ether group, an ester group, a carbonyl group, a carboxyl group, or a divalent group formed by combination thereof. Among those, the single bond or a linking group represented by $-Ab_1-CO_2-$ is preferable. $Ab_1$ is a linear or branched alkylene group, or a monocyclic or polycyclic cycloalkylene group, and is preferably a methylene group, an ethylene group, a cyclohexylene group, an adamantylene group, or a norbornylene group.

V represents a group formed by extracting one hydrogen atom from ring member atoms of a sultone structure represented by any of General Formulae (SL1-1) to (SL1-3).

In a case where optical isomers of the repeating unit having a sultone group are present, any of the optical isomers may be used. In addition, one optical isomer may be used alone or a mixture of a plurality of the optical isomers may be used. In a case where one optical isomer is mainly used, the optical purity (ee) thereof is preferably 90 or more, and more preferably 95 or more.

As the carbonate group, a cyclic carbonic acid ester group is preferable.

As the repeating unit having a cyclic carbonic acid ester group, a repeating unit represented by General Formula (A-1) is preferable.

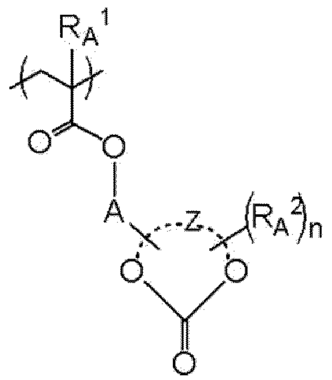

(A-1)

In General Formula (A-1), $R_A^1$ represents a hydrogen atom, a halogen atom, or a monovalent organic group (preferably a methyl group).

n represents an integer of 0 or more.

$R_A^2$ represents a substituent. In a case where n is 2 or more, $R_A^2$ which are present in a plural number may be the same as or different from each other.

A represents a single bond or a divalent linking group. As the divalent linking group, an alkylene group, a divalent linking group having a monocyclic or polycyclic alicyclic hydrocarbon structure, an ether group, an ester group, a carbonyl group, a carboxyl group, or a divalent group formed by combination thereof is preferable.

Z represents an atomic group that forms a monocycle or polycycle with a group represented by -O-CO-O- in the formula.

The repeating unit having a sultone group, a carbonate group will be exemplified below.

(in the formulae, Rx represents H, $CH_3$, $CH_2OH$, or $CF_3$)

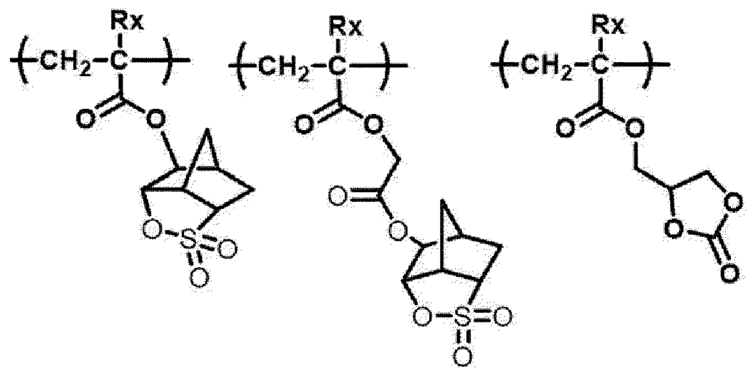

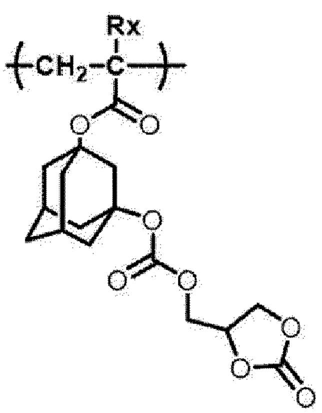

The total content of the repeating units having one or more of the sultone group and the carbonate group is preferably 1% by mass or more, and more preferably 10% by mass or more with respect to all repeating units in the resin (A). In addition, an upper limit value thereof is preferably 85% by mass or less, more preferably 80% by mass or less, still more preferably 70% by mole or less, and particularly preferably 60% by mass or less.

<Repeating Unit Having Photoacid Generating Group>

The resin (A) may have, as a repeating unit other than those above, a repeating unit having a group that generates an acid upon irradiation with actinic rays or radiation (hereinafter also referred to as a "photoacid generating group").

In this case, it can be considered that the repeating unit having a photoacid generating group corresponds to a compound that generates an acid upon irradiation with actinic rays or radiation which will be described later (also

referred to as a "photoacid generator").

Examples of such a repeating unit include a repeating unit represented by General Formula (4).

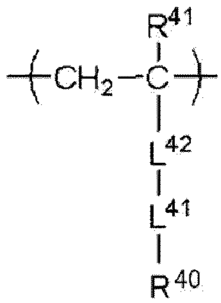

(4)

$R^{41}$ represents a hydrogen atom or a methyl group. $L^{41}$ represents a single bond or a divalent linking group. $L^{42}$ represents a divalent linking group. $R^{40}$ represents a structural moiety that decomposes upon irradiation with actinic rays or radiation to generate an acid in a side chain.

The repeating unit having a photoacid generating group is exemplified below.

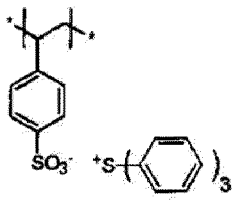
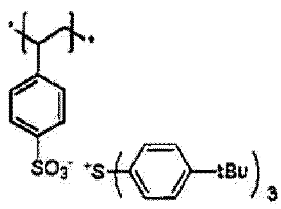
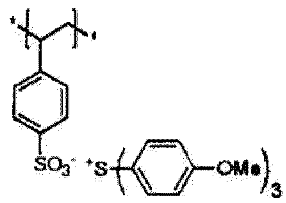

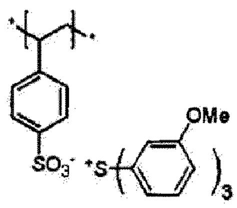
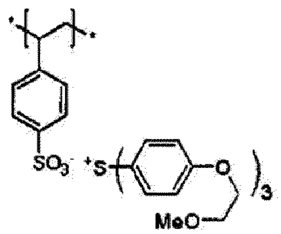
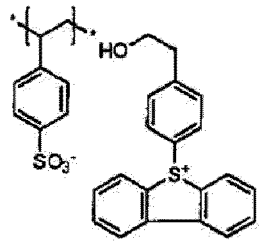

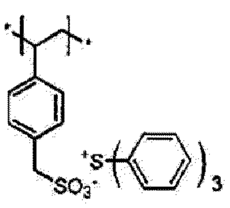
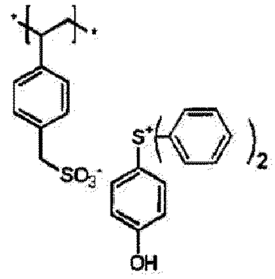
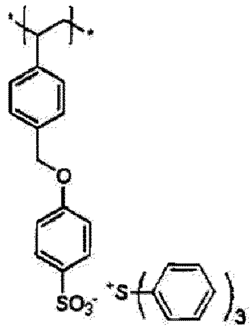
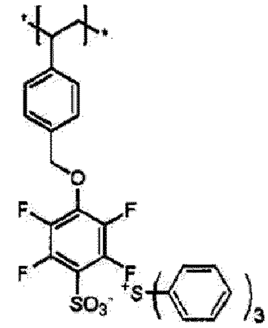
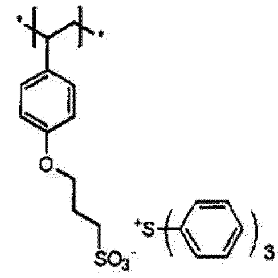
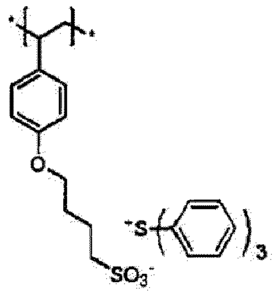
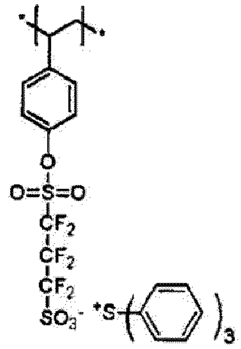
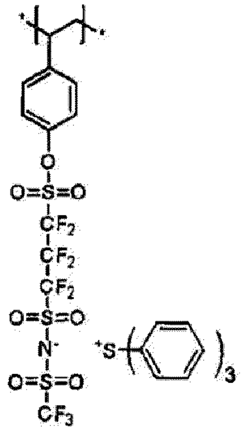
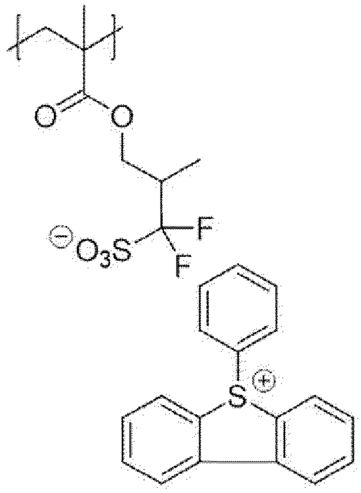
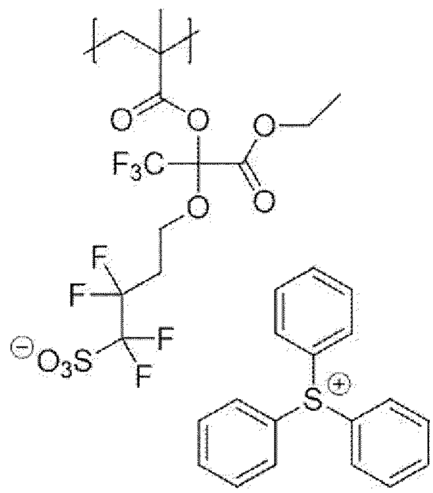

In addition, examples of the repeating unit represented by General Formula (4) include the repeating units described in paragraphs [0094] to [0105] of JP2014-041327A.

The content of the repeating unit having a photoacid generating group is preferably 1% by mass or more, and more preferably 5% by mass or more, with respect to all repeating units in the resin (A). Further, an upper limit value thereof is preferably 40% by mass or less, more preferably 35% by mass or less, and still more preferably 30% by mass or less.

<Repeating Unit Represented by General Formula (V-1) or General Formula (V-2)>

The resin (A) may have a repeating unit represented by General Formula (V-1) or General Formula (V-2).

The repeating unit represented by General Formula (V-1) and General Formula (V-2) is preferably a repeating unit different from the above-mentioned various repeating units.

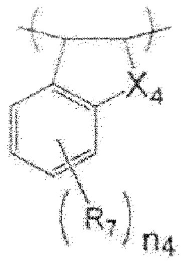

(V-1)

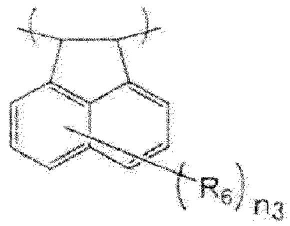

(V-2)

In the formulae,

$R_6$ and $R_7$ each independently represent a hydrogen atom, a hydroxyl group, an alkyl group, an alkoxy group, an acyloxy group, a cyano group, a nitro group, an amino group, a halogen atom, an ester group (-OCOR or -COOR: R is an alkyl group or fluorinated alkyl group having 1 to 6 carbon atoms), or a carboxyl group. As the alkyl group, a linear, branched, or cyclic alkyl group having 1 to 10 carbon atoms is preferable.

$n_3$ represents an integer of 0 to 6.

$n_4$ represents an integer of 0 to 4.

$X_4$ is a methylene group, an oxygen atom, or a sulfur atom.

The repeating unit represented by General Formula (V-1) or (V-2) will be exemplified below.

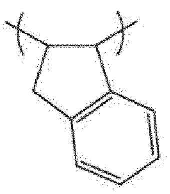

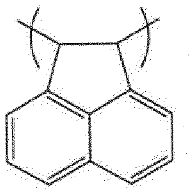

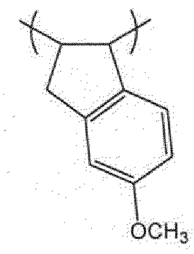

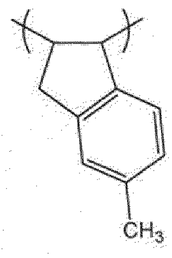

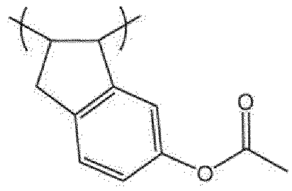

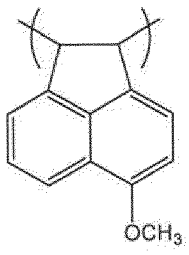

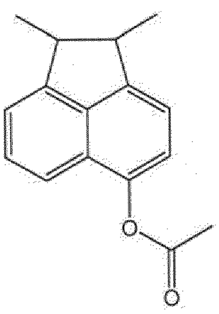

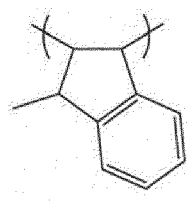

<Repeating Unit for Reducing Mobility of Main Chain>

The resin (A) preferably has a high glass transition temperature (Tg) from the viewpoint that excessive diffusion of an acid generated or pattern collapse during development can be suppressed. The Tg is preferably higher than 90°C, more preferably higher than 100°C, still more preferably higher than 110°C, and particularly preferably higher than 125°C. Further, since an excessively high Tg causes a decrease in a dissolution rate in a developer, the Tg is preferably 400°C

or lower, and more preferably 350°C or lower.

Furthermore, in the present specification, the glass transition temperature (Tg) of a polymer such as the resin (A) is calculated by the following method. First, each Tg of homopolymers consisting of only the respective repeating units included in the polymer is calculated by the Bicerano method. Hereinafter, the Tg calculated is referred to as a "Tg of the repeating unit. Next, a mass ratio (%) of each repeating unit with respect to the all repeating units in the polymer is calculated. Then, the Tg at each mass ratio is calculated using a Fox's equation (described in Materials Letters 62 (2008) 3152, and the like), and these are summed to obtain the Tg (°C) of the polymer.

The Bicerano method is described in Prediction of polymer properties, Marcel Dekker Inc., New York (1993), and the like. The calculation of a Tg by the Bicerano method can be carried out using MDL Polymer (MDL Information Systems, Inc.), which is software for estimating physical properties of a polymer.

In order to raise the Tg of the resin (A) (preferably to raise the Tg to higher than 90°C), it is preferable to reduce the mobility of the main chain of the resin (A). Examples of a method for lowering the mobility of the main chain of the resin (A) include the following (a) to (e) methods.

(a) Introduction of a bulky substituent into the main chain
(b) Introduction of a plurality of substituents into the main chain
(c) Introduction of a substituent causing an interaction between the resins (A) into the vicinity of the main chain
(d) Formation of the main chain in a cyclic structure
(e) Linking of a cyclic structure to the main chain

Furthermore, the resin (A) preferably has a repeating unit in which the homopolymer exhibits a Tg of 130°C or higher.

In addition, the type of the repeating unit in which the homopolymer exhibits a Tg of 130°C or higher is not particularly limited, and may be any of repeating units in which the homopolymer exhibits a Tg of 130°C or higher, as calculated by a Bicerano method. Further, depending on the types of the functional groups in the repeating units represented by each of Formula (A) to Formula (E) which will be described later, it is determined that the repeating unit corresponds to a repeating unit in which the homopolymer exhibits a Tg of 130°C or higher.

(Repeating Unit Represented by Formula (A))

A specific example of a unit for accomplishing (a) above may be a method in which a repeating unit represented by Formula (A) is introduced into the resin (A).

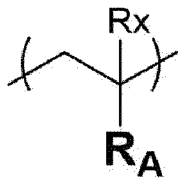

(A)

In Formula (A), $R_A$ represents a group having a polycyclic structure. $R_x$ represents a hydrogen atom, a methyl group, or an ethyl group. The group having a polycyclic structure is a group having a plurality of ring structures, and the plurality of ring structures may or may not be fused.

Specific examples of the repeating unit represented by Formula (A) include the following repeating units.

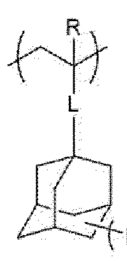

(A-1)

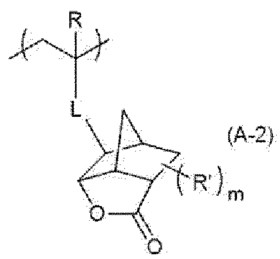

(A-2)

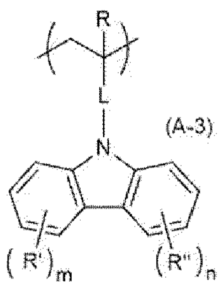

(A-3)

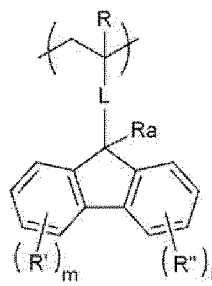

(A-4)

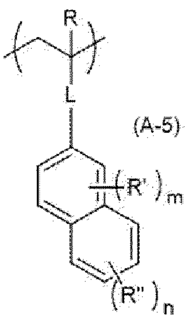
(A-5)

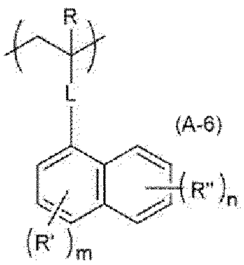
(A-6)

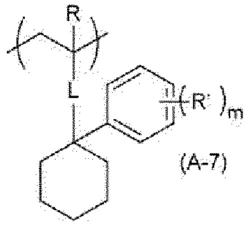
(A-7)

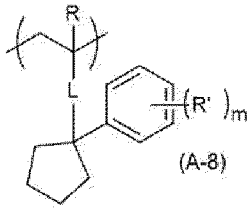
(A-8)

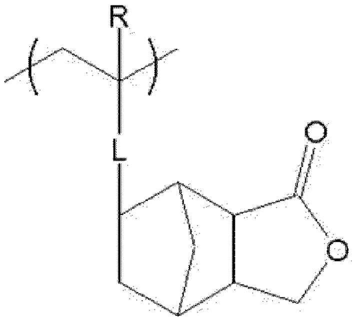
(A-9)

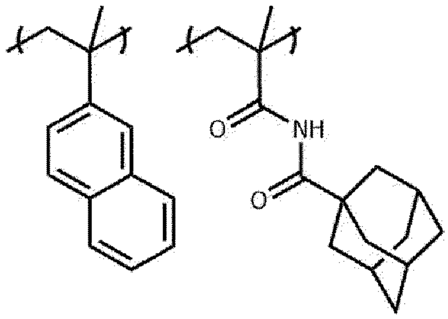

In the formulae, R represents a hydrogen atom, a methyl group, or an ethyl group.

Ra represents a hydrogen atom, an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR‴ or -COOR‴: R‴ is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. In addition, a hydrogen atom bonded to the carbon atom in the group represented by Ra may be substituted with a fluorine atom or an iodine atom.

Moreover, R' and R" each independently represent an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR‴ or -COOR‴: R‴ is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. In addition, a hydrogen atom bonded to the carbon atom in the groups represented by each of R' and R" may be substituted with a fluorine atom or an iodine atom.

L represents a single bond or a divalent linking group. Examples of the divalent linking group include -COO-, -CO-, -O-, -S-, -SO-, $-SO_2-$, an alkylene group, a cycloalkylene group, an alkenylene group, and a linking group in which a plurality of these groups are linked.

m and n each independently represent an integer of 0 or more. The upper limits of m and n are not particularly limited, but are preferably 2 or less in many cases, and 1 or less in more cases.

(Repeating Unit Represented by Formula (B))

A specific example of a unit for accomplishing (b) above may be a method in which a repeating unit represented

by Formula (B) is introduced into the resin (A).

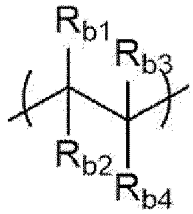 (B)

In Formula (B), $R_{b1}$ to $R_{b4}$ each independently represent a hydrogen atom or an organic group, and at least two or more of $R_{b1}$, ..., or $R_{b4}$ represent an organic group.

Furthermore, in a case where at least one of the organic groups is a group in which a ring structure is directly linked to the main chain in the repeating unit, the types of the other organic groups are not particularly limited.

In addition, in a case where all the organic groups are not a group in which a ring structure is directly linked to the main chain in the repeating unit, at least two or more of the organic groups are substituents having a number of the constituent atoms excluding hydrogen atoms of 3 or more.

Specific examples of the repeating unit represented by Formula (B) include the following repeating units.

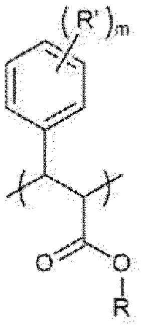 (B-1) 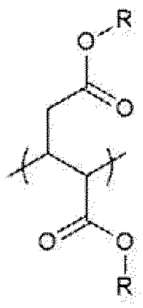 (B-2) 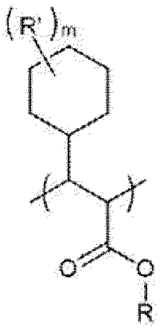 (B-3) 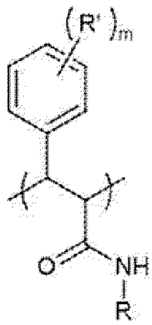 (B-4)

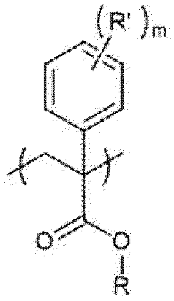 (B-5) 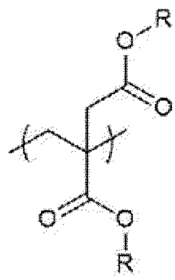 (B-6)

In the formulae, R’s each independently represent a hydrogen atom or an organic group. Examples of the organic group include an organic group such as an alkyl group, a cycloalkyl group, an aryl group, an aralkyl group, and an alkenyl group, each of which may have a substituent.

R"s each independently represent an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR" or -COOR": R" is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. In addition, a hydrogen atom bonded to the carbon atom in the group represented by R’ may be substituted with a fluorine atom or an iodine atom.

m represents of an integer of 0 or more. The upper limit of m is not particularly limited, but is 2 or less in many cases, and 1 or less in more cases.

(Repeating Unit Represented by Formula (C))

A specific example of a unit for accomplishing (c) above may be a method in which a repeating unit represented by Formula (C) is introduced into the resin (A).

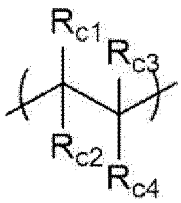

(C)

In Formula (C), $R_{c1}$ to $R_{c4}$ each independently represent a hydrogen atom or an organic group, and at least one of $R_{c1}$, ..., or $R_{c4}$ is a group having a hydrogen-bonding hydrogen atom with a number of atoms of 3 or less from the main chain carbon. Among those, it is preferable that the group has hydrogen-bonding hydrogen atoms with a number of atoms of 2 or less (on a side closer to the vicinity of the main chain) to cause an interaction between the main chains of the resin (A).

Specific examples of the repeating unit represented by Formula (C) include the following repeating units.

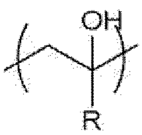

(C-1)

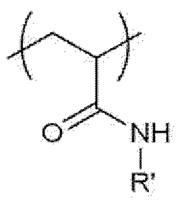

(C-2)

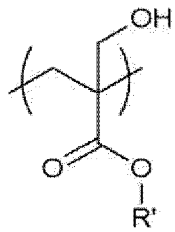

(C-3)

In the formulae, R represents an organic group. Examples of the organic group include an alkyl group, a cycloalkyl group, an aryl group, an aralkyl group, an alkenyl group, and an ester group (-OCOR or -COOR: R represents an alkyl group or fluorinated alkyl group having 1 to 20 carbon atoms), each of which may have a substituent.

R' represents a hydrogen atom or an organic group. Examples of the organic group include an organic group such as an alkyl group, a cycloalkyl group, an aryl group, an aralkyl group, and an alkenyl group. In addition, a hydrogen atom in the organic group may be substituted with a fluorine atom or an iodine atom.

(Repeating Unit Represented by Formula (D))

A specific example of a unit for accomplishing (d) above may be a method in which a repeating unit represented by Formula (D) is introduced into the resin (A).

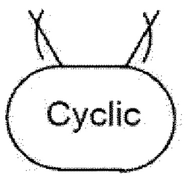

(D)

In Formula (D), "Cyclic" is a group that forms a main chain with a cyclic structure. The number of the ring-constituting atoms is not particularly limited.

Specific examples of the repeating unit represented by Formula (D) include the following repeating units.

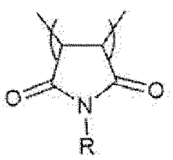

(D-1)

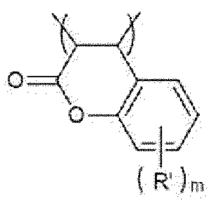

(D-2)

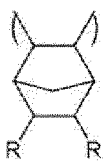

(D-3)

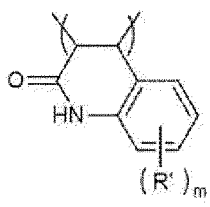

(D-4)

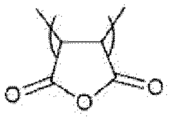 (D-5) 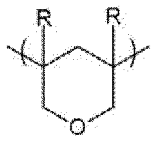 (D-6) 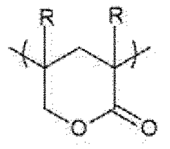 (D-7) 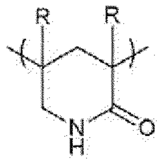 (D-8)

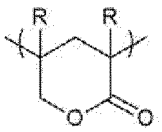 (D-9) 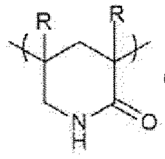 (D-10) 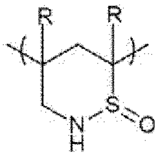 (D-11) 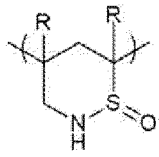 (D-12)

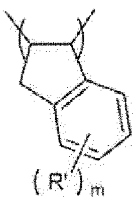 (D-13) 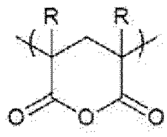 (D-14) 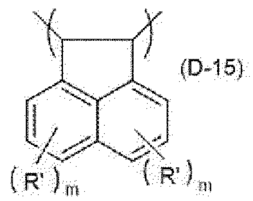 (D-15) 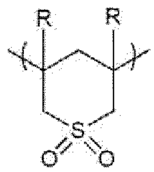 (D-16)

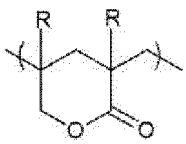 (D-17) 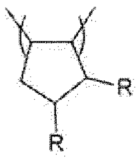 (D-18) 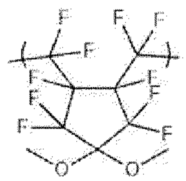 (D-19)

In the formulae, R's each independently represent a hydrogen atom, an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR" or -COOR": R" is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. In addition, a hydrogen atom bonded to a carbon atom in the group represented by R may be substituted with a fluorine atom or an iodine atom.

In the formulae, R"s each independently represent an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR" or -COOR": R" is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. In addition, a hydrogen atom bonded to the carbon atom in the group represented by R' may be substituted with a fluorine atom or an iodine atom.

m represents of an integer of 0 or more. The upper limit of m is not particularly limited, but is 2 or less in many cases, and 1 or less in more cases.

(Repeating Unit Represented by Formula (E))

A specific example of a unit for accomplishing (e) above may be a method in which a repeating unit represented by Formula (E) is introduced into the resin (A). The repeating unit represented by Formula (E) preferably does not include the above-mentioned specific repeating unit.

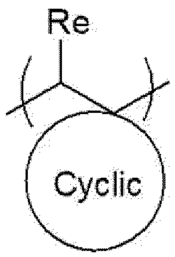

(E)

In Formula (E), Re's each independently represent a hydrogen atom or an organic group. Examples of the organic group include an alkyl group, a cycloalkyl group, an aryl group, an aralkyl group, and an alkenyl group, which may have a substituent.

"Cyclic" is a cyclic group including a carbon atom of the main chain. The number of the atoms included in the cyclic group is not particularly limited.

Specific examples of the repeating unit represented by Formula (E) include the following repeating units.

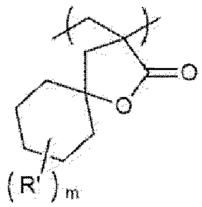 (E-1) 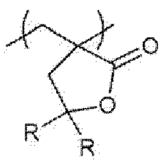 (E-2) 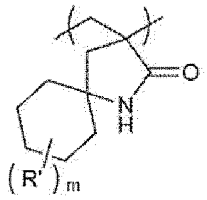 (E-3) 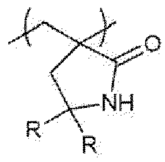 (E-4)

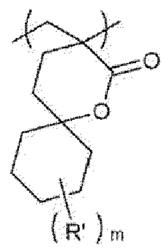 (E-5) 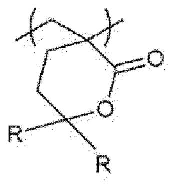 (E-6) 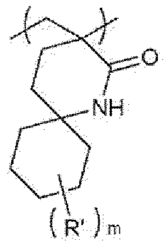 (E-7) 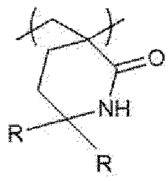 (E-8)

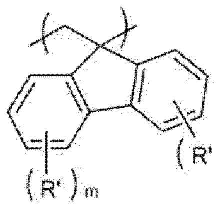 (E-9) 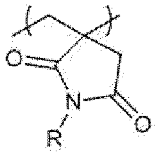 (E-10) 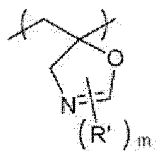 (E-11) 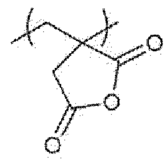 (E-12)

In the formulae, R's each independently represent a hydrogen atom, an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR" or -COOR": R" is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. In addition, a hydrogen atom bonded to a carbon atom in the group represented by R may be substituted with a fluorine atom or an iodine atom.

R"s each independently represent a hydrogen atom, an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR" or -COOR": R" is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. In addition, a hydrogen atom bonded to the carbon atom in the group represented by R' may be substituted with a fluorine atom or an iodine atom.

m represents of an integer of 0 or more. The upper limit of m is not particularly limited, but is 2 or less in many cases, and 1 or less in more cases.

In addition, in Formula (E-2), Formula (E-4), Formula (E-6), and Formula (E-8), two R's may be bonded to each

other to form a ring.

The content of the repeating unit represented by Formula (E) is preferably 5% by mass or more, and more preferably 10% by mass or more with respect to all repeating units in the resin (A). In addition, an upper limit value thereof is preferably 60% by mass or less, and more preferably 55% by mass or less.

<Repeating Unit Having at Least One Group selected from Sultone Group, Carbonate Group, Hydroxyl Group, Cyano Group, or Alkali-Soluble Group>

The resin (A) may have a repeating unit having at least one group selected from a sultone group, a carbonate group, a hydroxyl group, a cyano group, or an alkali-soluble group.

Examples of the repeating unit having a sultone group, or a carbonate group contained in the resin (A) include the repeating units described in <Repeating Unit Having Sultone Group or Carbonate Group> mentioned above. A preferred content thereof is also the same as described in <Repeating Unit Having Sultone Group or Carbonate Group> mentioned above.

The resin (A) may have a repeating unit having a hydroxyl group or a cyano group. As a result, the adhesiveness to a substrate and the affinity for a developer are improved.

The repeating unit having a hydroxyl group or a cyano group is preferably a repeating unit having an alicyclic hydrocarbon structure substituted with a hydroxyl group or a cyano group.

The repeating unit having a hydroxyl group or a cyano group preferably has no acid-decomposable group. Examples of the repeating unit having a hydroxyl group or a cyano group include repeating units represented by General Formulae (AIIa) to (AIId).

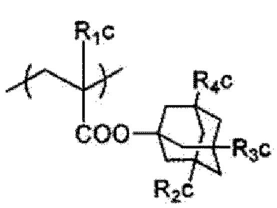
(A I I a)

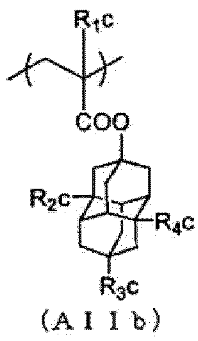
(A I I b)

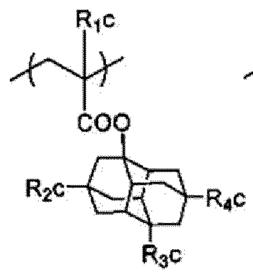
(A I I c)

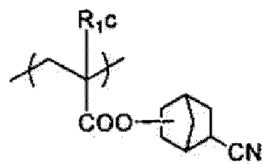
(A I I d)

In General Formulae (AIIa) to (AIId),

$R_{1c}$ represents a hydrogen atom, a methyl group, a trifluoromethyl group, or a hydroxymethyl group.

$R_{2c}$ to $R_{4c}$ each independently represent a hydrogen atom, a hydroxyl group, or a cyano group. It should be noted that at least one of $R_{2c}$, ..., or $R_{4c}$ represents a hydroxyl group or a cyano group. It is preferable that one or two of $R_{2c}$, to $R_{4c}$ are hydroxyl groups, and the rest are hydrogen atoms. It is more preferable that two of $R_{2c}$, to $R_{4c}$, are hydroxyl groups and the rest are hydrogen atoms.

The content of the repeating unit having a hydroxyl group or a cyano group is preferably 5% by mass or more, and more preferably 10% by mass or more with respect to all repeating units in the resin (A). Further, an upper limit value thereof is preferably 40% by mass or less, more preferably 35% by mass or less, and still more preferably 30% by mass or less.

Specific examples of the repeating unit having a hydroxyl group or a cyano group are shown below, but the present invention is not limited thereto.

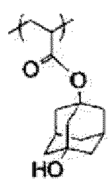 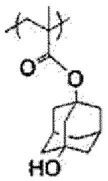 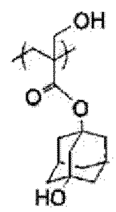 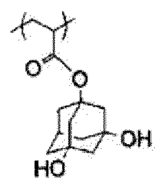 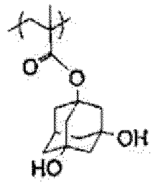 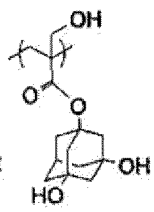

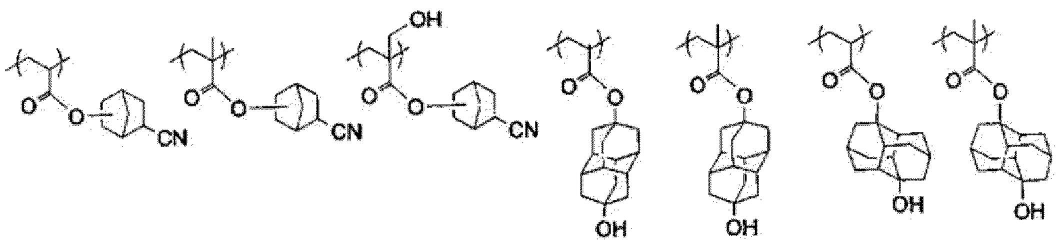

The resin (A) may have a repeating unit having an alkali-soluble group.

Examples of the alkali-soluble group include a carboxyl group, a sulfonamide group, a sulfonylimide group, a bissulfonylimide group, or an aliphatic alcohol group (for example, a hexafluoroisopropanol group) in which an $\alpha$-position is substituted with an electron-withdrawing group, and the carboxyl group is preferable. In a case where the resin (A) includes a repeating unit having an alkali-soluble group, the resolution for use in contact holes is increased.

Examples of the repeating unit having an alkali-soluble group include a repeating unit in which an alkali-soluble group is directly bonded to the main chain of a resin such as a repeating unit with acrylic acid and methacrylic acid, or a repeating unit in which an alkali-soluble group is bonded to the main chain of the resin via a linking group. Further, the linking group may have a monocyclic or polycyclic cyclic hydrocarbon structure.

The repeating unit having an alkali-soluble group is preferably a repeating unit with acrylic acid or methacrylic acid.

The content of the repeating unit having an alkali-soluble group is preferably 3% by mass or more, and more preferably 5% by mass or more, with respect to all repeating units in the resin (A). An upper limit value thereof is preferably 20% by mass or less, more preferably 15% by mass or less, and still more preferably 10% by mass or less.

Specific examples of the repeating unit having an alkali-soluble group are shown below, but the present invention is not limited thereto. In the specific examples, Rx represents H, $CH_3$, $CH_2OH$, or $CF_3$.

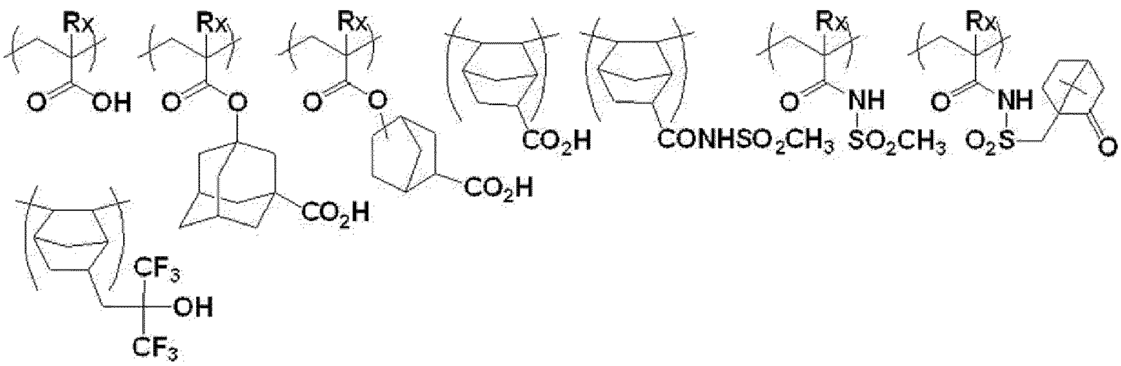

<Repeating Unit Having Alicyclic Hydrocarbon Structure and Not Exhibiting Acid Decomposability>

The resin (A) may have a repeating unit having an alicyclic hydrocarbon structure and not exhibiting acid decomposability. This can reduce the elution of low-molecular-weight components from the resist film into an immersion liquid during liquid immersion exposure. Examples of such the repeating unit include repeating units derived from 1-adamantyl (meth)acrylate, diadamantyl (meth)acrylate, tricyclodecanyl (meth)acrylate, and cyclohexyl (meth)acrylate.

<Repeating Unit Represented by General Formula (III) Having Neither Hydroxyl Group Nor Cyano Group>

The resin (A) may have a repeating unit represented by General Formula (III), which has neither a hydroxyl group nor a cyano group.

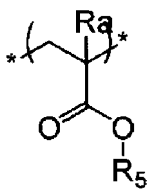
(III)

In General Formula (III), $R_5$ represents a hydrocarbon group having at least one cyclic structure and having neither a hydroxyl group nor a cyano group.

Ra represents a hydrogen atom, an alkyl group, or a $-CH_2-O-Ra_2$ group. In the formula, $Ra_2$ represents a hydrogen atom, an alkyl group, or an acyl group.

The cyclic structure contained in $R_5$ includes a monocyclic hydrocarbon group and a polycyclic hydrocarbon group. Examples of the monocyclic hydrocarbon group include a cycloalkyl group having 3 to 12 carbon atoms (more preferably 3 to 7 carbon atoms) or a cycloalkenyl group having 3 to 12 carbon atoms.

Examples of the polycyclic hydrocarbon group include a ring-assembled hydrocarbon group and a crosslinked cyclic hydrocarbon group.

Examples of the crosslinked cyclic hydrocarbon ring include a bicyclic hydrocarbon ring, a tricyclic hydrocarbon ring, and a tetracyclic hydrocarbon ring. Further, examples of the crosslinked cyclic hydrocarbon ring also include a fused ring formed by fusing a plurality of 5-to 8-membered cycloalkane rings.

As the crosslinked cyclic hydrocarbon group, a norbornyl group, an adamantyl group, a bicyclooctanyl group, or a tricyclo$[5,2,1,0^{2,6}]$decanyl group is preferable, and the norbornyl group or the adamantyl group is more preferable.

The alicyclic hydrocarbon group may have a substituent, and examples of the substituent include a halogen atom, an alkyl group, a hydroxyl group protected by a protective group, and an amino group protected by a protective group.

The halogen atom is preferably a bromine atom, a chlorine atom, or a fluorine atom.

As the alkyl group, a methyl group, an ethyl group, a butyl group, or a t-butyl group is preferable.

The alkyl group may further have a substituent, and examples of the substituent include a halogen atom, an alkyl group, a hydroxyl group protected by a protective group, and an amino group protected by a protective group.

Examples of the protective group include an alkyl group, a cycloalkyl group, an aralkyl group, a substituted methyl group, a substituted ethyl group, an alkoxycarbonyl group, and an aralkyloxycarbonyl group.

As the alkyl group, an alkyl group having 1 to 4 carbon atoms is preferable.

As the substituted methyl group, a methoxymethyl group, a methoxythiomethyl group, a benzyloxymethyl group, a t-butoxymethyl group, or a 2-methoxyethoxymethyl group is preferable.

The substituted ethyl group is preferably a 1-ethoxyethyl group or a 1-methyl-1-methoxyethyl group.

As the acyl group, an aliphatic acyl group having 1 to 6 carbon atoms, such as a formyl group, an acetyl group, a propionyl group, a butyryl group, an isobutyryl group, a valeryl group, and a pivaloyl group, is preferable.

As the alkoxycarbonyl group, an alkoxycarbonyl group having 1 to 4 carbon atoms is preferable.

The content of the repeating unit represented by General Formula (III), which has neither a hydroxyl group nor a cyano group, is preferably 0% to 40% by mass, and more preferably 0% to 20% by mass with respect to all repeating units in the resin (A).

Specific examples of the repeating unit represented by General Formula (III) are shown below, but the present invention is not limited thereto. In the formulae, Ra represents H, $CH_3$, $CH_2OH$, or $CF_3$.

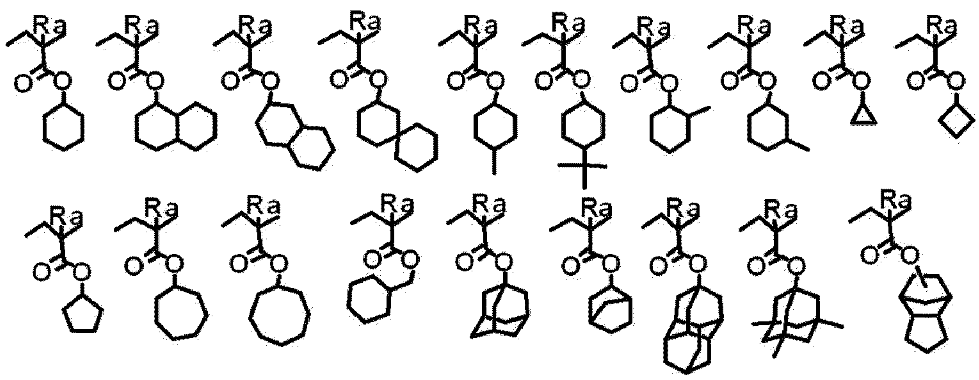

<Other Repeating Units>

The resin (A) may further have a repeating unit other than the above-mentioned repeating units.

For example, the resin (A) may have a repeating unit selected from the group consisting of a repeating unit having an oxathiane ring group, a repeating unit having an oxazolone ring group, a repeating unit having a dioxane ring group, and a repeating unit having a hydantoin ring group.

Such repeating units will be exemplified below.

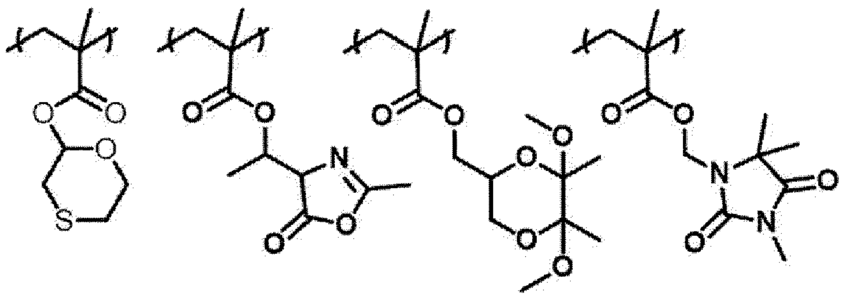

The resin (A) may have a variety of repeating structural units, in addition to the repeating structural units described above, for the purpose of adjusting dry etching resistance, suitability for a standard developer, adhesiveness to a substrate, a resist profile, resolving power, heat resistance, sensitivity, and the like.
The resin (A) can be synthesized in accordance with an ordinary method (for example, radical polymerization).
The weight-average molecular weight of the resin (A) as a value expressed in terms of polystyrene by a GPC method is preferably 1,000 to 200,000, more preferably 3,000 to 20,000, and still more preferably 5,000 to 15,000. By setting the weight-average molecular weight of the resin (A) to 1,000 to 200,000, deterioration of heat resistance and dry etching resistance can be further suppressed. In addition, deterioration of developability and deterioration of film forming property due to high viscosity can also be further suppressed.
The dispersity (molecular weight distribution) of the resin (A) is usually 1 to 5, preferably 1 to 3, more preferably 1.2 to 3.0, and still more preferably 1.2 to 2.0. The smaller the dispersity, the more excellent the resolution and the resist shape, and the smoother the side wall of the resist pattern, the more excellent the roughness.
The content of the resin (A) in the resist composition of the embodiment of the present invention is preferably 50% to 99.9% by mass, and more preferably 60% to 99.0% by mass with respect to the total solid content of the composition.
In addition, the resin (A) may be used alone or in combination of two or more kinds thereof.

[Photoacid Generator]

The resist composition may include a photoacid generator. The photoacid generator is a compound that generates an acid upon exposure with EUV light.
The photoacid generator may be in a form of a low-molecular-weight compound or in a form incorporated into a part of a polymer. Further, a combination of the form of a low-molecular-weight compound and the form incorporated into a part of a polymer may also be used.
In a case where the photoacid generator (A) of the present invention is in the form of the low-molecular-weight compound, the molecular weight is preferably 3,000 or less, more preferably 2,000 or less, and still more preferably 1,000 or less.
In a case where the photoacid generator is in the form incorporated into a part of a polymer, it may be incorporated into the resin (A) or into a resin that is different from the resin (A).
In the present invention, the photoacid generator is preferably a low-molecular-weight compound.
The photoacid generator is not particularly limited as long as it is a known photoacid generator, but a compound that generates an organic acid upon irradiation with EUV light is preferable, and a photoacid generator having a fluorine atom or an iodine atom in the molecule is more preferable.
Examples of the organic acid include sulfonic acids (an aliphatic sulfonic acid, an aromatic sulfonic acid, and a camphor sulfonic acid), carboxylic acids (an aliphatic carboxylic acid, an aromatic carboxylic acid, and an aralkylcarboxylic acid), a carbonylsulfonylimide acid, a bis(alkylsulfonyl)imide acid, and a tris(alkylsulfonyl)methide acid.
The volume of an acid generated from the photoacid generator is not particularly limited, but from the viewpoint of suppression of diffusion of an acid generated to the unexposed area upon exposure and improvement of the resolution, the volume is preferably 240 Å$^3$ or more, more preferably 300 Å$^3$ or more, and still more preferably 350 Å$^3$ or more, and particularly preferably 400 Å$^3$ or more. Incidentally, from the viewpoint of the sensitivity or the solubility in an application solvent, the volume of the acid generated from the photoacid generator is preferably 1,500 Å$^3$ or less, more preferably 1,000 Å$^3$ or less, and still more preferably 700 Å$^3$ or less.
The value of this volume is determined using "WinMOPAC" produced by Fujitsu Limited. For the computation of the value of this volume, first, the chemical structure of the acid according to each example is input, next, using this structure as the initial structure, the most stable conformation of each acid is determined by molecular force field computation using a Molecular Mechanics (MM) 3 method, and thereafter, with respect to the most stable conformation, molecular orbital computation using a Parameterized Model number 3 (PM3) method is performed, whereby the "accessible volume" of each acid can be computed.

The structure of an acid generated from the photoacid generator is not particularly limited, but from the viewpoint that the diffusion of the acid is suppression and the resolution is improved, it is preferable that the interaction between the acid generated from the photoacid generator and the resin (A) is strong. From this viewpoint, in a case where the acid generated from the photoacid generator is an organic acid, it is preferable that a polar group is further contained, in addition to an organic acid group such as a sulfonic acid group, a carboxylic acid group, a carbonylsulfonylimide acid group, a bissulfonylimide acid group, and a trissulfonylmethide acid group.

Examples of the polar group include an ether group, an ester group, an amide group, an acyl group, a sulfo group, a sulfonyloxy group, a sulfonamide group, a thioether group, a thioester group, a urea group, a carbonate group, a carbamate group, a hydroxyl group, and a mercapto group.

The number of the polar groups contained in the acid generated is not particularly limited, and is preferably 1 or more, and more preferably 2 or more. It should be noted that from the viewpoint that excessive development is suppressed, the number of the polar groups is preferably less than 6, and more preferably less than 4.

As the photoacid generator, photoacid generators that generate acids, as exemplified below, are preferable. Further, in some of the examples, the computed values of the volumes are added (unit: $A^3$).

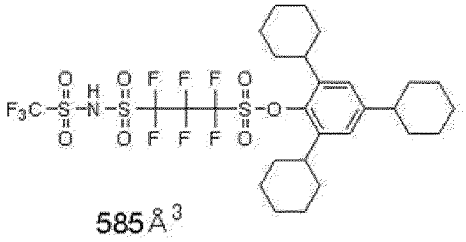

585Å$^3$

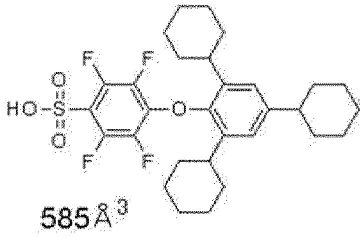

585Å$^3$

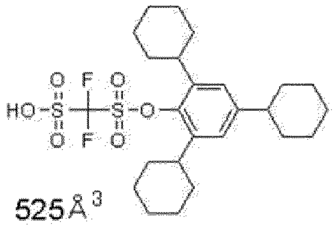

525Å$^3$

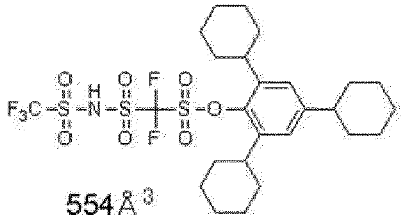

554Å$^3$

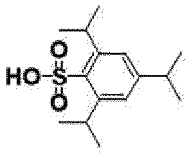

303Å$^3$

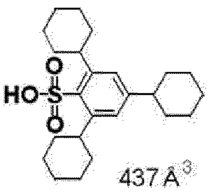

437Å$^3$

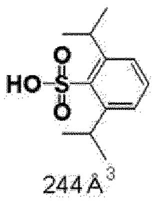

244Å$^3$

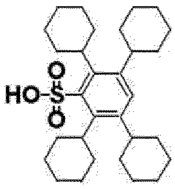

529Å$^3$

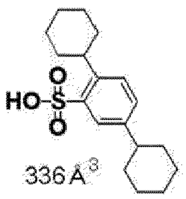

336Å$^3$

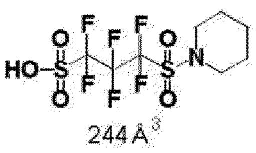

244Å$^3$

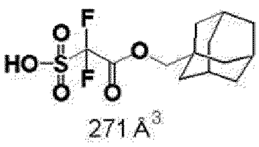

271Å$^3$

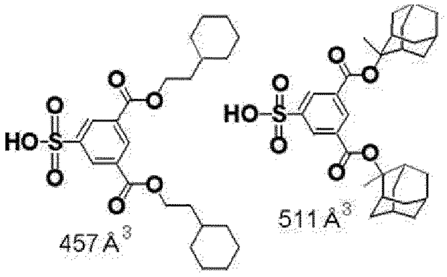

457 Å$^3$ 511 Å$^3$

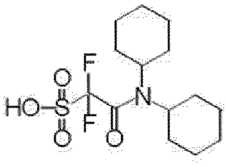

311 Å$^3$

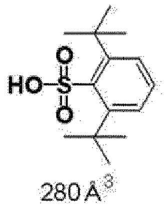

280 Å$^3$

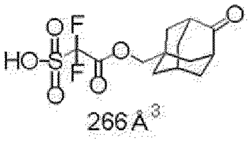

266 Å$^3$

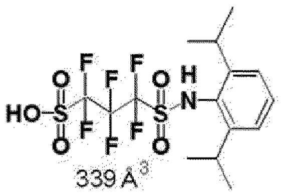

339 Å$^3$

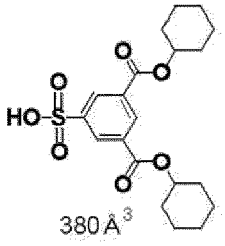

380 Å$^3$

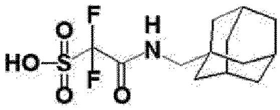

277 Å$^3$

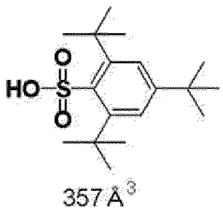

357 Å$^3$

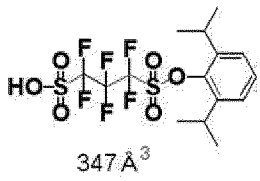

347 Å$^3$

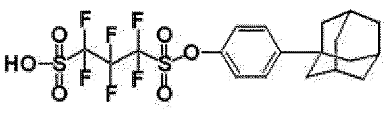

380 Å$^3$

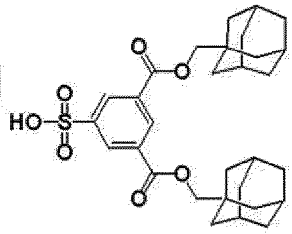

519 Å$^3$

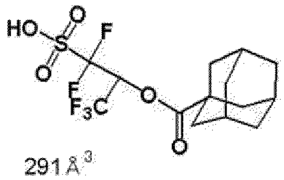

291 Å$^3$

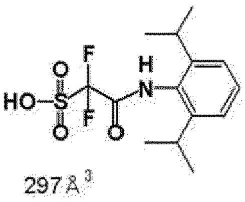

297 Å$^3$

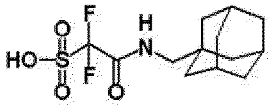

277 Å$^3$

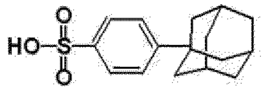

281 Å$^3$

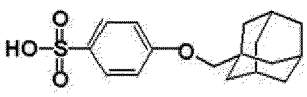

310 Å$^3$

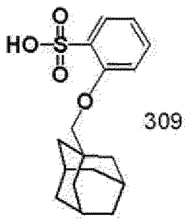

309 Å$^3$

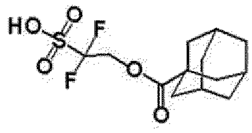

270 Å$^3$

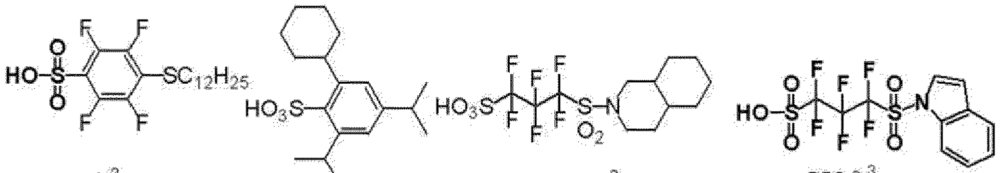

393 Å$^3$ 350 Å$^3$ 311 Å$^3$ 250 Å$^3$

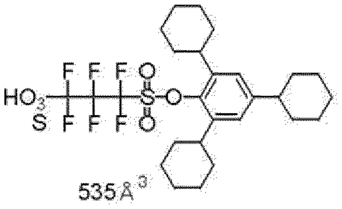

535 Å$^3$

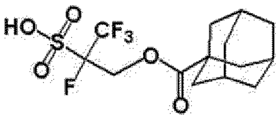

290 Å$^3$

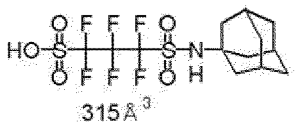

315 Å$^3$

Among those, the photoacid generator is preferably a photoacid generator including an anionic moiety and a cationic moiety from the viewpoint that the effect of the present invention is more excellent.

More specifically, the photoacid generator is preferably a compound represented by General Formula (ZI) or General Formula (ZII).

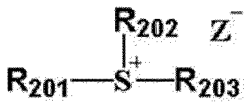

(ZI)

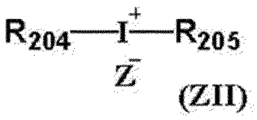

(ZII)

In General Formula (ZI),

$R_{201}$, $R_{202}$, and $R_{203}$ each independently represent an organic group.

The number of carbon atoms of the organic group as each of $R_{201}$, $R_{202}$, and $R_{203}$ is preferably 1 to 30, and more preferably 1 to 20.

In addition, two of $R_{201}$ to $R_{203}$ may be bonded to each other to form a ring structure, and the ring may include an oxygen atom, a sulfur atom, an ester bond, an amide bond, or a carbonyl group. Examples of the group formed by the bonding of two of $R_{201}$ to $R_{203}$ include an alkylene group (for example, a butylene group and a pentylene group).

$Z^-$ represents a non-nucleophilic anion (anion having a remarkably low ability of causing a nucleophilic reaction).

Examples of the non-nucleophilic anion include a sulfonate anion (an aliphatic sulfonate anion, an aromatic sulfonate anion, a camphor sulfonate anion, and the like), a carboxylate anion (an aliphatic carboxylate anion, an aromatic carboxylate anion, an aralkyl carboxylate anion, and the like), a sulfonylimide anion, a bis(alkylsulfonyl)imide anion, and a tris(alkylsulfonyl)methide anion.

The aliphatic moiety in the aliphatic sulfonate anion and the aliphatic carboxylate anion may be an alkyl group or a cycloalkyl group, and is preferably a linear or branched alkyl group having 1 to 30 carbon atoms or a cycloalkyl group having 3 to 30 carbon atoms.

As the aromatic ring group in the aromatic sulfonate anion and the aromatic carboxylate anion, an aryl group having 6 to 14 carbon atoms is preferable, and examples thereof include a phenyl group, a tolyl group, and a naphthyl group.

Specific examples of the substituent which may be contained in the alkyl group, the cycloalkyl group, and the aryl group exemplified above include a nitro group, a halogen atom such as fluorine atom, a carboxyl group, a hydroxyl group, an amino group, a cyano group, an alkoxy group (preferably having 1 to 15 carbon atoms), a cycloalkyl group (preferably having 3 to 15 carbon atoms), an aryl group (preferably having 6 to 14 carbon atoms), an alkoxycarbonyl group (preferably having 2 to 7 carbon atoms), an acyl group (preferably having 2 to 12 carbon atoms), an alkoxycarbonyloxy group (preferably having 2 to 7 carbon atoms), an alkylthio group (preferably having 1 to 15 carbon atoms), an alkylsulfonyl group (preferably having 1 to 15 carbon atoms), an alkyliminosulfonyl group (preferably having 1 to 15 carbon atoms), an aryloxysulfonyl group (preferably having 6 to 20 carbon atoms), an alkylaryloxysulfonyl group (preferably having 7 to 20 carbon atoms), a cycloalkylaryloxysulfonyl group (preferably having 10 to 20 carbon atoms), an alkyloxyalkyloxy group (preferably having 5 to 20 carbon atoms), and a cycloalkylalkyloxyalkyloxy group (preferably having 8 to 20 carbon atoms).

As the aralkyl group in the aralkyl carboxylate anion, an aralkyl group having 7 to 12 carbon atoms is preferable, and examples thereof include a benzyl group, a phenethyl group, a naphthylmethyl group, a naphthylethyl group, and

a naphthylbutyl group.

Examples of the sulfonylimide anion include a saccharin anion.

As the alkyl group in the bis(alkylsulfonyl)imide anion and the tris(alkylsulfonyl)methide anion, an alkyl group having 1 to 5 carbon atoms is preferable. Examples of the substituent of the alkyl group include a halogen atom, an alkyl group substituted with a halogen atom, an alkoxy group, an alkylthio group, an alkyloxysulfonyl group, an aryloxysulfonyl group, and a cycloalkylaryloxysulfonyl group, and the fluorine atom or the alkyl group substituted with a fluorine atom is preferable.

In addition, the alkyl groups in the bis(alkylsulfonyl)imide anion may be bonded to each other to form a ring structure. Thus, the acid strength is increased.

Examples of the other non-nucleophilic anions include fluorinated phosphorus (for example, $PF_6^-$), fluorinated boron (for example, $BF_4^-$), and fluorinated antimony (for example, $SbF_6^-$).

As the non-nucleophilic anion, an aliphatic sulfonate anion in which at least $\alpha$-position of sulfonic acid is substituted with a fluorine atom, an aromatic sulfonate anion substituted with a fluorine atom or a group having a fluorine atom, a bis(alkylsulfonyl)imide anion in which an alkyl group is substituted with a fluorine atom, or a tris(alkylsulfonyl)methide anion in which an alkyl group is substituted with a fluorine atom is preferable. Among these, a perfluoroaliphatic sulfonate anion (more preferably having 4 to 8 carbon atoms) or a fluorine atom-containing benzenesulfonate anion is more preferable, and a nonafluorobutanesulfonate anion, a perfluorooctanesulfonate anion, a pentafluorobenzenesulfonate anion, or a 3,5-bis(trifluoromethyl)benzenesulfonate anion is still more preferable.

From the viewpoint of the acid strength, it is preferable that the pKa of the acid generated is -1 or less to improve the sensitivity.

Moreover, as the non-nucleophilic anion, an anion represented by General Formula (AN1) is also preferable.

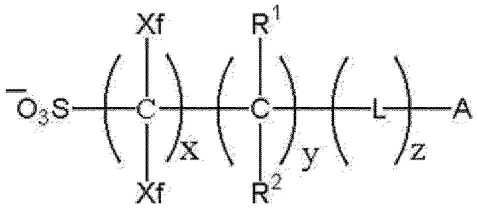

(AN1)

In the formulae,

Xf's each independently represent a fluorine atom or an alkyl group substituted with at least one fluorine atom.

$R^1$ and $R^2$ each independently represent a hydrogen atom, a fluorine atom, or an alkyl group, and in a case where $R^1$'s and $R^2$'s are present in plural numbers, they may be the same as or different from each other.

L represents a divalent linking group, and in a case where L's are present in plural number, they may be the same as or different from each other.

A represents a cyclic organic group.

x represents an integer of 1 to 20, y represent an integer of 0 to 10, and z represents an integer of 0 to 10.

General Formula (AN1) will be described in more detail.

As the alkyl group in the alkyl group substituted with a fluorine atom of Xf, an alkyl group having 1 to 10 carbon atoms is preferable, and an alkyl group having 1 to 4 carbon atoms is more preferable. In addition, as the alkyl group in the alkyl group substituted with a fluorine atom of Xf a perfluoroalkyl group is preferable.

Xf is preferably a fluorine atom or a perfluoroalkyl group having or 1 to 4 carbon atoms. Specific examples of Xf include a fluorine atom, $CF_3$, $C_2F_5$, $C_3F_7$, $C_4F_9$, $CH_2CF_3$, $CH_2CH_2CF_3$, $CH_2C_2F_5$, $CH_2CH_2C_2F_5$, $CH_2C_3F_7$, $CH_2CH_2C_3F_7$, $CH_2C_4F_9$, and $CH_2CH_2C_4F_9$, and among these, the fluorine atom or $CF_3$ is preferable. In particular, it is preferable that both Xf's are a fluorine atom.

The alkyl group of each of $R^1$ and $R^2$ may have a substituent (preferably a fluorine atom), and the number of carbon atoms in the substituent is preferably 1 to 4. As the substituent, a perfluoroalkyl group having 1 to 4 carbon atoms is preferable. Specific examples of the alkyl group having a substituent of each of $R^1$ and $R^2$ include $CF_3$, $C_2F_5$, $C_3F_7$, $C_4F_9$, $C_5F_{11}$, $C_6F_{13}$, $C_7F_{15}$, $C_8F_{17}$, $CH_2CF_3$, $CH_2CH_2CF_3$, $CH_2C_2F_5$, $CH_2CH_2C_2F_5$, $CH_2C_3F_7$, $CH_2CH_2C_3F_7$, $CH_2C_4F_9$, and $CH_2CH_2C_4F_9$, and among these, $CF_3$ is preferable.

As each of $R^1$ and $R^2$, the fluorine atom or $CF_3$ is preferable.

x is preferably an integer of 1 to 10, and more preferably 1 to 5.

y is preferably an integer of 0 to 4, and more preferably 0.

z is preferably an integer of 0 to 5, and more preferably an integer of 0 to 3.

The divalent linking group of L is not particularly limited, and examples thereof include -COO-, -CO-, -O-, -S-,

-SO-, $-SO_2-$, an alkylene group, a cycloalkylene group, an alkenylene group, a linking group obtained by linking a plurality of these groups to each other, with the linking group having 12 or less carbon atoms in total being preferable. Among those, -COO-, -OCO-, -CO-, or -O- is more preferable, and -COO- or -OCO- is still more preferable.

The cyclic organic group of A is not particularly limited as long as it has a cyclic structure, and examples thereof include an alicyclic group, an aromatic ring group, and a heterocyclic group (including not only a heterocyclic group having aromaticity but also a heterocyclic group having no aromaticity).

The alicyclic group may be either a monocycle or a polycycle, and is preferably a monocyclic cycloalkyl group such as a cyclopentyl group, a cyclohexyl group, and a cyclooctyl group, or a polycyclic cycloalkyl group such as a norbornyl group, a tricyclodecanyl group, a tetracyclodecanyl group, a tetracyclododecanyl group, and an adamantyl group. Among those, an alicyclic group with a bulky structure, having 7 or more carbon atoms, such as a norbornyl group, a tricyclodecanyl group, a tetracyclodecanyl group, a tetracyclododecanyl group, and an adamantyl group is preferable from the viewpoints the in-film diffusion in a heating step after exposure can be suppressed and a mask error enhancement factor (MEEF) is improved.

Examples of the aromatic ring group include a benzene ring, a naphthalene ring, a phenanthrene ring, and an anthracene ring.

Examples of the heterocyclic group include a group derived from a furan ring, a thiophene ring, a benzofuran ring, a benzothiophene ring, a dibenzofuran ring, a dibenzothiophene ring, a pyridine ring, or the like. Among those, the group derived from the furan ring, the thiophene ring, or the pyridine ring is preferable.

Moreover, the cyclic organic group also includes a lactone structure, and specific examples thereof include the above-mentioned lactone structures represented by General Formulae (LC1-1) to (LC1-17).

The cyclic organic group may have a substituent. Examples of the substituent include an alkyl group (which may be in any of linear, branched, and cyclic forms, and preferably has 1 to 12 carbon atoms), a cycloalkyl group (which may be either a monocycle or a polycycle; may be a spiro ring in a case where the cycloalkyl group is polycyclic; and preferably has 3 to 20 carbon atoms), an aryl group (preferably having 6 to 14 carbon atoms), a hydroxyl group, an alkoxy group, an ester group, an amide group, a urethane group, a ureide group, a thioether group, a sulfonamide group, and a sulfonic acid ester group. Incidentally, the carbon constituting the cyclic organic group (the carbon contributing to ring formation) may be a carbonyl carbon.

Examples of the organic group of each of $R_{201}$, $R_{202}$, and $R_{203}$ include an aryl group, an alkyl group, and a cycloalkyl group.

It is preferable that at least one of $R_{201}$, $R_{202}$, or $R_{203}$ is an aryl group, and it is more preferable that all of $R_{201}$, $R_{202}$, and $R_{203}$ are aryl groups. As the aryl group, not only a phenyl group, a naphthyl group, or the like but also a heteroaryl group such as an indole residue and a pyrrole residue is also available.

As the alkyl group of each of $R_{201}$ to $R_{203}$, a linear or branched alkyl group having 1 to 10 carbon atoms is preferable, and a methyl group, an ethyl group, an n-propyl group, an i-propyl group, an n-butyl group, or the like is more preferable.

As the cycloalkyl group of each of $R_{201}$ to $R_{203}$, a cycloalkyl group having 3 to 10 carbon atoms is preferable, and a cyclopropyl group, a cyclobutyl group, a cyclopentyl group, a cyclohexyl group, or a cycloheptyl group is more preferable.

Examples of the substituent which may be contained in these groups include a nitro group, a halogen atom such as a fluorine atom, a carboxyl group, a hydroxyl group, an amino group, a cyano group, an alkoxy group (preferably having 1 to 15 carbon atoms), a cycloalkyl group (preferably having 3 to 15 carbon atoms), an aryl group (preferably having 6 to 14 carbon atoms), an alkoxycarbonyl group (preferably having 2 to 7 carbon atoms), an acyl group (preferably having 2 to 12 carbon atoms), and an alkoxycarbonyloxy group (preferably having 2 to 7 carbon atoms).

In General Formula (ZII),

$R_{204}$ and $R_{205}$ each independently represent an aryl group, an alkyl group, or a cycloalkyl group.

As the aryl group, the alkyl group, and the cycloalkyl group of each of $R_{204}$ and $R_{205}$ have the same definitions as the aryl group, the alkyl group, and the cycloalkyl group, respectively, of each of $R_{201}$ to $R_{203}$ in General Formula (ZI) as described above.

Examples of the substituent which may be contained in each of the aryl group, the alkyl group, and the cycloalkyl group of each of $R_{204}$ and $R_{205}$ include the same ones which may be contained in the above-mentioned groups as the aryl group, the alkyl group, and the cycloalkyl group of each of $R_{201}$ to $R_{203}$ in the above-mentioned General Formula (ZI).

$Z^-$ represents a non-nucleophilic anion, and examples thereof include the same ones as described as the non-nucleophilic anion of $Z^-$ in General Formula (ZI).

With regard to the photoacid generator, reference can be made to paragraphs [0368] to [0377] of JP2014-41328A and paragraphs [0240] to [0262] of JP2013-228681A (corresponding to paragraph [0339] of the specification of US2015/004533A), the contents of which are incorporated herein by reference. In addition, specific preferred examples of the photoacid generator include, but are not limited to, the following compounds.

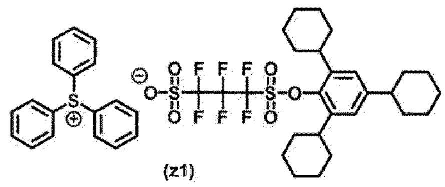
(z1)

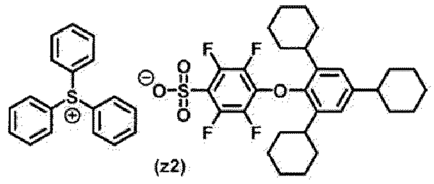
(z2)

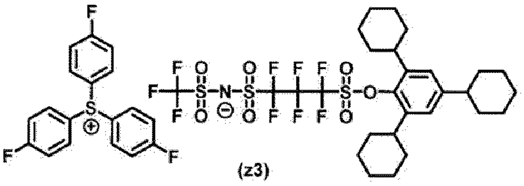
(z3)

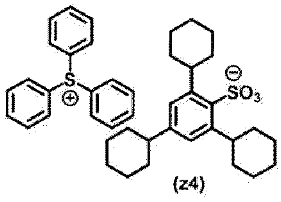
(z4)

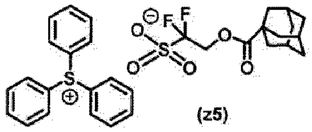
(z5)

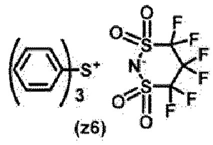
(z6)

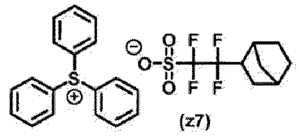
(z7)

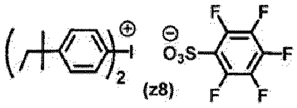
(z8)

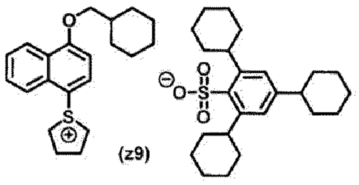
(z9)

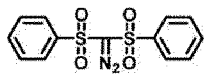
(z10)

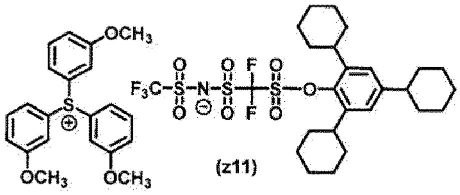
(z11)

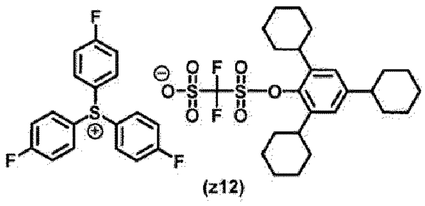
(z12)

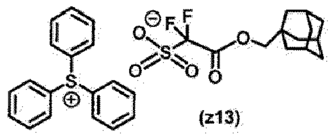
(z13)

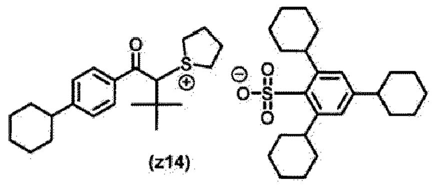
(z14)

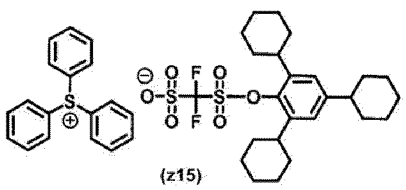
(z15)

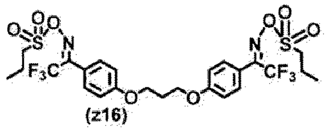
(z16)

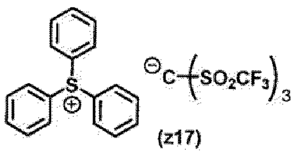
(z17)

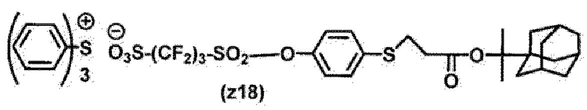
(z18)

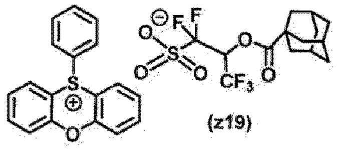
(z19)

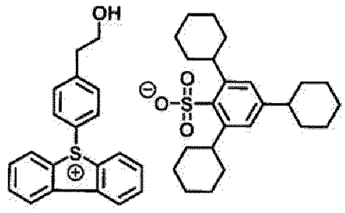
(z20)

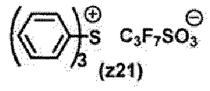
(z21)

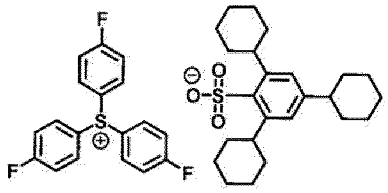
(z22)

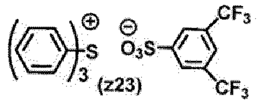
(z23)

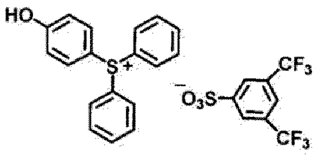
(z24)

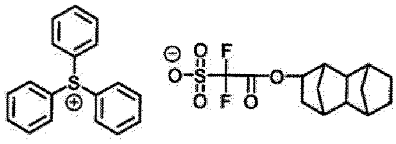
(z25)

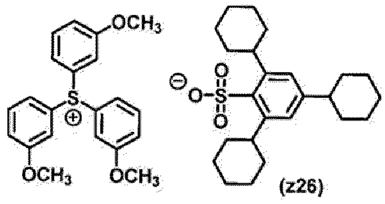
(z26)

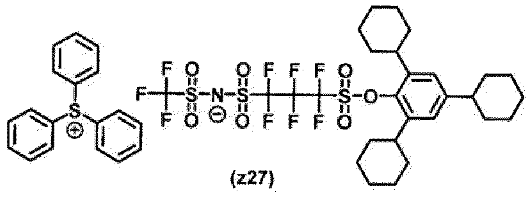
(z27)

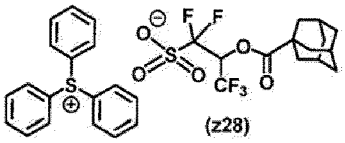
(z28)

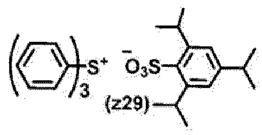
(z29)

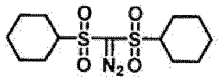
(z30)

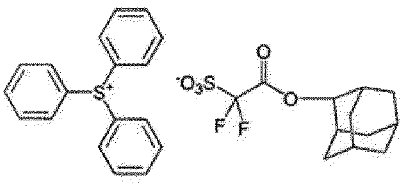
(z31)

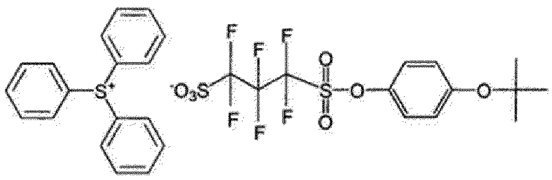
(z32)

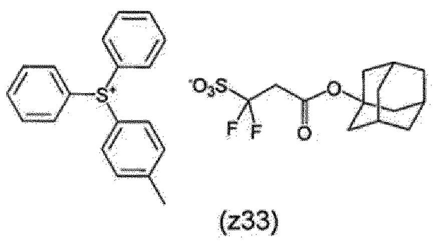

(z33)

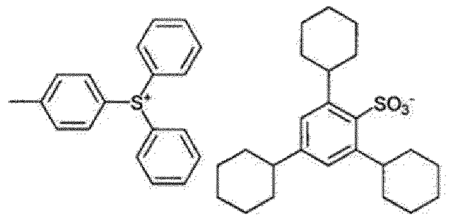

(z34)

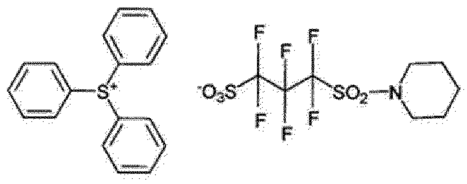

(z35)

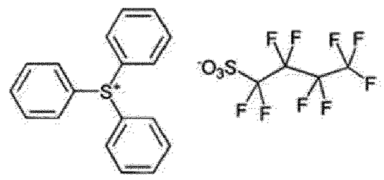

(z36)

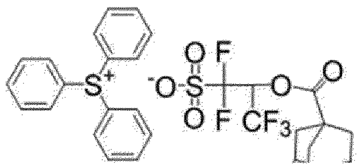

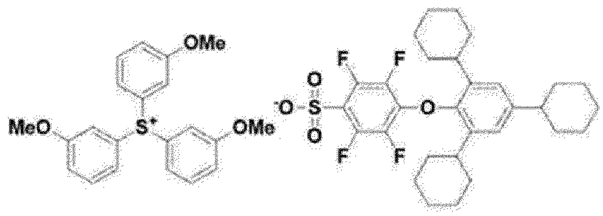

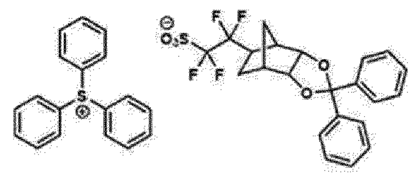

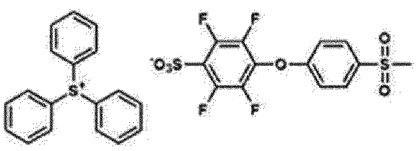

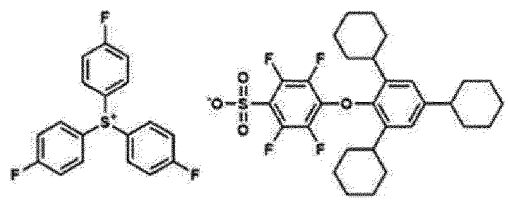

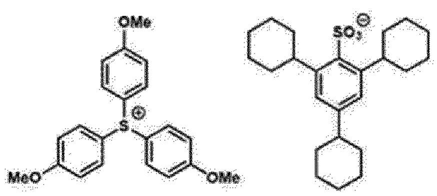

The content of the photoacid generator in the resist composition is not particularly limited, but from the viewpoint that the effects of the present invention are more excellent, the content is preferably 5% to 50% by mass, more preferably 10% to 40% by mass, and still more preferably 10% to 35% by mass with respect to the total solid content of the composition.

The photoacid generators may be used alone or in combination of two or more kinds thereof. In a case where two or more kinds of the photoacid generators are used in combination, the total amount thereof is preferably within the range.

[Solvent]

The resist composition may include a solvent.

The solvent preferably includes at least one solvent of (M1) propylene glycol monoalkyl ether carboxylate, or (M2) at least one selected from the group consisting of a propylene glycol monoalkyl ether, a lactic acid ester, an acetic acid ester, an alkoxypropionic acid ester, a chain ketone, a cyclic ketone, a lactone, and an alkylene carbonate as a solvent. The solvent may further include components other than the component (M1) and the component (M2).

The present inventors have found that by using such a solvent and the above-mentioned resin in combination, the coating properties of the composition are improved, and a pattern with a small number of defects due to development can also be formed. A reason therefor is not necessarily clear, but the present inventors have thought that these solvents have a good balance among the solubility, the boiling point, and the viscosity of the above-mentioned resin, and therefore, unevenness of the film thickness of a composition film, generation of precipitates during spin coating, and the like can be suppressed.

As the component (M1), at least one selected from the group consisting of propylene glycol monomethyl ether acetate (PGMEA), propylene glycol monomethyl ether propionate, and propylene glycol monoethyl ether acetate is preferable, and propylene glycol monomethyl ether acetate (PGMEA) is more preferable.

As the component (M2), the following ones are preferable.

As the propylene glycol monoalkyl ether, propylene glycol monomethyl ether (PGME) or propylene glycol monoethyl ether is preferable.

As the lactic acid ester, ethyl lactate, butyl lactate, or propyl lactate is preferable.

As the acetic acid ester, methyl acetate, ethyl acetate, butyl acetate, isobutyl acetate, propyl acetate, isoamyl acetate, methyl formate, ethyl formate, butyl formate, propyl formate, or 3-methoxybutyl acetate is preferable.

In addition, butyl butyrate is also preferable.

As the alkoxypropionic acid ester, methyl 3-methoxypropionate (MMP) or ethyl 3-ethoxypropionate (EEP) is preferable.

As the chain ketone, 1-octanone, 2-octanone, 1-nonanone, 2-nonanone, acetone, 2-heptanone, 4-heptanone, 1-hexanone, 2-hexanone, diisobutyl ketone, phenylacetone, methyl ethyl ketone, methyl isobutyl ketone, acetylacetone, acetonylacetone, ionone, diacetonyl alcohol, acetyl carbinol, acetophenone, methyl naphthyl ketone, or methyl amyl ketone is preferable.

As the cyclic ketone, methyl cyclohexanone, isophorone, or cyclohexanone is preferable.

As the lactone, γ-butyrolactone is preferable.

As the alkylene carbonate, propylene carbonate is preferable.

As the component (M2), propylene glycol monomethyl ether (PGME), ethyl lactate, ethyl 3-ethoxypropionate, methyl amyl ketone, cyclohexanone, butyl acetate, pentyl acetate, γ-butyrolactone, or propylene carbonate is more preferable.

In addition to the components, it is preferable to use an ester-based solvent having 7 or more carbon atoms (preferably 7 to 14 carbon atoms, more preferably 7 to 12 carbon atoms, and still more preferably 7 to 10 carbon atoms) and 2 or less heteroatoms.

Preferred examples of the ester-based solvent having 7 or more carbon atoms and 2 or less heteroatoms include amyl acetate, 2-methylbutyl acetate, 1-methylbutyl acetate, hexyl acetate, pentyl propionate, hexyl propionate, butyl propionate, isobutyl isobutyrate, heptyl propionate, and butyl butanoate, and isoamyl acetate is preferable.

As the component (M2), a component having a flash point (hereinafter also referred to as fp) of 37°C or higher is preferably used. As such a component (M2), propylene glycol monomethyl ether (fp: 47°C), ethyl lactate (fp: 53°C), ethyl 3-ethoxypropionate (fp: 49°C), methyl amyl ketone (fp: 42°C), cyclohexanone (fp: 44°C), pentyl acetate (fp: 45°C), methyl 2-hydroxyisobutyrate (fp: 45°C), γ-butyrolactone (fp: 101°C), or propylene carbonate (fp: 132°C) is preferable. Among those, propylene glycol monoethyl ether, ethyl lactate, pentyl acetate, or cyclohexanone is more preferable, and propylene glycol monoethyl ether or ethyl lactate is still more preferable.

In addition, the "flash point" herein is intended to mean the value described in a reagent catalog of Tokyo Chemical Industry Co., Ltd. or Sigma-Aldrich Co. LLC.

It is preferable that the solvent includes the component (M1). It is more preferable that the solvent substantially consists of only the component (M1) or is a mixed solvent of the component (M1) and other components. In a case where the solvent is the mixed solvent, it is still more preferable that the solvent includes both the component (M1) and the component (M2).

The mass ratio (M1/M2) of the content of the component (M1) to the component (M2) is preferably in the range of "100/0" to "15/85", more preferably in the range of "100/0" to "40/60", and still more preferably in the range of "100/0" to "60/40". That is, the solvent includes only the component (M1) or includes both of the component (M1) and the component (M2), and a mass ratio thereof is preferably as follows. That is, in the latter case, the mass ratio of the component (M1) to the component (M2) is preferably 15/85 or more, more preferably 40/60 or more, and still more

preferably 60/40 or more. In a case of employing such a configuration, it is possible to further reduce the number of defects due to development.

Moreover, in a case where both of the component (M1) and the component (M2) are included in the solvent, the mass ratio of the component (M1) to the component (M2) is set to, for example, 99/1 or less.

As described above, the solvent may further include components other than the components (M1) and (M2). In this case, the content of the components other than the components (M1) and (M2) is preferably in the range of 5% to 30% by mass with respect to the total mass of the solvent.

The content of the solvent in the resist composition is preferably set so that the concentration of solid contents is 30% by mass or less, more preferably set so that the concentration of solid contents is 10% by mass or less, and more preferably set so that the concentration of solid contents is 5.0% by mass or less. By setting the concentration of solid contents within the range, there is also an advantage that the coating properties of the resist composition are further improved and the range of the A value (Requirement 1) can be easily adjusted.

[Acid Diffusion Control Agent]

The composition of the embodiment of the present invention preferably includes an acid diffusion control agent. The acid diffusion control agent acts as a quencher that suppresses a reaction of the acid-decomposable resin in the unexposed area by excessive generated acids by trapping the acids generated from a photoacid generator and the like upon exposure. For example, a basic compound (DA), a compound (DB) having basicity that is reduced or lost upon irradiation with actinic rays or radiation, an onium salt (DC) which is a relatively weak acid with respect to an acid generator, or the like can be used as the acid diffusion control agent.

As the basic compound (DA), compounds having structures represented by General Formulae (A) to (E) are preferable.

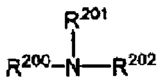
(A)

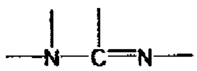
(B)

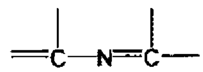
(C)

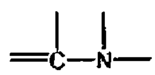
(D)

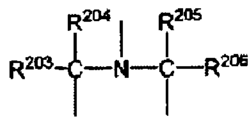
(E)

In General Formula (A) and General Formula (E), $R^{200}$, $R^{201}$, and $R^{202}$ may be the same as or different from each other, and each represent a hydrogen atom, an alkyl group (preferably having 1 to 20 carbon atoms), a cycloalkyl group (preferably having 3 to 20 carbon atoms), or an aryl group (preferably having 6 to 20 carbon atoms), in which $R^{201}$ and $R^{202}$ may be bonded to each other to form a ring.

With regard to the alkyl group, the alkyl group having a substituent is preferably an aminoalkyl group having 1 to 20 carbon atoms, a hydroxyalkyl group having 1 to 20 carbon atoms, or a cyanoalkyl group having 1 to 20 carbon atoms.

$R^{203}$, $R^{204}$, $R^{205}$, and $R^{206}$ may be the same as or different from each other, and each represent an alkyl group having 1 to 20 carbon atoms.

It is more preferable that the alkyl groups in General Formula (A) and General Formula (E) are unsubstituted.

As the basic compound (DA), guanidine, aminopyrrolidine, pyrazole, pyrazoline, piperazine, aminomorpholine, aminoalkylmorpholine, piperidine, or the like is preferable. Among these, a compound having an imidazole structure, a diazabicyclo structure, an onium hydroxide structure, an onium carboxylate structure, a trialkylamine structure, an aniline structure, or a pyridine structure; an alkylamine derivative having a hydroxyl group and/or an ether bond; an aniline derivative having a hydroxyl group and/or an ether bond; or the like is more preferable.

Examples of the compound having an imidazole structure include imidazole, 2,4,5-triphenylimidazole, and benzimidazole. Examples of the compound having a diazabicyclo structure include 1,4-diazabicyclo[2.2.2]octane, 1,5-diazabicyclo[4.3.0]non-5-ene, and 1,8-diazabicyclo[5.4.0]undec-7-ene. Examples of the compound having an onium hydroxide structure include triarylsulfonium hydroxide, phenacylsulfonium hydroxide, and sulfonium hydroxide having a 2-oxoalkyl group. Specific examples thereof include triphenylsulfonium hydroxide, tris(t-butylphenyl)sulfonium hydroxide, bis(t-butylphenyl)iodonium hydroxide, phenacylthiophenium hydroxide, and 2-oxopropylthiophenium hydroxide. The compound having an onium carboxylate structure is formed by carboxylation of an anionic moiety of a compound having an onium hydroxide structure, and examples thereof include acetate, adamantane-1-carboxylate, and perfluoroalkyl carboxylate. Examples of the compound having a trialkylamine structure include tri(n-butyl)amine and tri(n-octyl)amine. Examples of the aniline compound include 2,6-diisopropylaniline, N,N-dimethylaniline, N,N-dibutylaniline, and N,N-dihexylaniline. Examples of the alkylamine derivative having a hydroxyl group and/or an ether bond include ethanolamine, diethanolamine, triethanolamine, and tris(methoxyethoxyethyl)amine. Examples of the aniline derivative having a hydroxyl group and/or an ether bond include N,N-bis(hydroxyethyl)aniline.

Preferred examples of the basic compound (DA) include an amine compound having a phenoxy group and an ammonium salt compound having a phenoxy group.

As the amine compound, a primary, secondary, or tertiary amine compound can be used, and an amine compound in which at least one alkyl group is bonded to a nitrogen atom is preferable. The amine compound is more preferably a tertiary amine compound. Any amine compound is available as long as at least one alkyl group (preferably having 1 to 20 carbon atoms) is bonded to a nitrogen atom, and a cycloalkyl group (preferably having 3 to 20 carbon atoms) or an aryl group (preferably having 6 to 12 carbon atoms), in addition to the alkyl group, may be bonded to the nitrogen atom.

In addition, the amine compound preferably has an oxyalkylene group. The number of the oxyalkylene groups is preferably 1 or more, more preferably 3 to 9, and still more preferably 4 to 6, within the molecule. Among the oxyalkylene groups, an oxyethylene group ($-CH_2CH_2O-$) or an oxypropylene group ($-CH(CH_3)CH_2O-$ or $-CH_2CH_2CH_2-O-$) is preferable, and the oxyethylene group is more preferable.

Examples of the ammonium salt compound include primary, secondary, tertiary, and quaternary ammonium salt compounds, and an ammonium salt compound in which at least one alkyl group is bonded to a nitrogen atom is preferable. Any ammonium salt compound is available as long as at least one alkyl group (preferably having 1 to 20 carbon atoms) is bonded to a nitrogen atom, and a cycloalkyl group (preferably having 3 to 20 carbon atoms) or an aryl group (preferably having 6 to 12 carbon atoms) may be bonded to the nitrogen atom, in addition to the alkyl group.

It is preferable that the ammonium salt compound has an oxyalkylene group. The number of the oxyalkylene groups is preferably 1 or more, more preferably 3 to 9, and still more preferably 4 to 6, within the molecule. Among oxyalkylene groups, an oxyethylene group ($-CH_2CH_2O-$) or an oxypropylene group ($-CH(CH_3)CH_2O-$ or $-CH_2CH_2CH_2O-$) is preferable, and the oxyethylene group is more preferable.

Examples of the anion of the ammonium salt compound include a halogen atom, a sulfonate, a borate, and a phosphate, and among these, the halogen atom or the sulfonate is preferable. As the halogen atom, chloride, bromide, or iodide is preferable. As the sulfonate, an organic sulfonate having 1 to 20 carbon atoms is preferable. Examples of the organic sulfonate include alkyl sulfonate and aryl sulfonate, having 1 to 20 carbon atoms. The alkyl group of the alkyl sulfonate may have a substituent, and examples of the substituent include a fluorine atom, a chlorine atom, a bromine atom, an alkoxy group, an acyl group, and an aromatic ring group. Specific examples of the alkyl sulfonate include methanesulfonate, ethanesulfonate, butanesulfonate, hexanesulfonate, octanesulfonate, benzyl sulfonate, trifluoromethanesulfonate, pentafluoroethanesulfonate, and nonafluorobutanesulfonate. Examples of the aryl group of the aryl sulfonate include a benzene ring group, a naphthalene ring group, and an anthracene ring group. As the substituent which can be contained in the benzene ring group, the naphthalene ring group, and the anthracene ring group, a linear or branched alkyl group having 1 to 6 carbon atoms or a cycloalkyl group having 3 to 6 carbon atoms is preferable. Specific examples of the linear or branched alkyl group and the cycloalkyl group include a methyl group, an ethyl group, an n-propyl group, an isopropyl group, an n-butyl group, an i-butyl group, a t-butyl group, an n-hexyl group, and a cyclohexyl group. Examples of other substituents include an alkoxy group having 1 to 6 carbon atoms, a halogen atom, a cyano group, a nitro group, an acyl group, and an acyloxy group.

The amine compound having a phenoxy group and the ammonium salt compound having a phenoxy group are each a compound having a phenoxy group at the terminal on the opposite side to the nitrogen atom of the alkyl group which is contained in the amine compound or the ammonium salt compound.

Examples of a substituent of the phenoxy group include an alkyl group, an alkoxy group, a halogen atom, a cyano group, a nitro group, a carboxyl group, a carboxylic acid ester group, a sulfonic acid ester group, an aryl group, an aralkyl group, an acyloxy group, and an aryloxy group. The substitution position of the substituent may be any of 2- to 6-positions. The number of the substituents may be any one of 1 to 5.

This compound preferably has at least one oxyalkylene group between the phenoxy group and the nitrogen atom. The number of the oxyalkylene groups is preferably 1 or more, more preferably 3 to 9, and still more preferably 4 to 6, within the molecule. Among oxyalkylene groups, an oxyethylene group ($-CH_2CH_2O-$) or an oxypropylene group ($-CH(CH_3)CH_2O-$ or $-CH_2CH_2CH_2O-$) is preferable, and the oxyethylene group is more preferable.

The amine compound having a phenoxy group can be obtained by heating a mixture of a primary or secondary amine having a phenoxy group and a haloalkyl ether to perform a reaction, then adding an aqueous solution of a strong base (for example, sodium hydroxide, potassium hydroxide, and tetraalkylammonium) to a reaction system, and extracting the reaction product with an organic solvent (for example, ethyl acetate and chloroform). Alternatively, the amine compound having a phenoxy group can also be obtained by heating a mixture of a primary or secondary amine and a haloalkyl ether having a phenoxy group at a terminal to perform a reaction, then adding an aqueous solution of a strong base to the reaction system, and extracting the reaction product with an organic solvent.

Moreover, a superorganic base can also be used as the basic compound (DA).

Examples of the superorganic base include guanidine bases such as tetramethylguanidine and polyguanidine (including guanidine and guanidine derivatives such as substituted forms thereof and polyguanides), amidine-based and guanidine-based polynitrogen polyheterocyclic compounds and polymer-carrying strong bases thereof, typified by

diazabicyclononene (DBN), diazabicycloundecene (DBU), triazabicyclodecene (TBD), N-methyl-triazabicyclodecene (MTBD), and the like, phosphazene (Schweisinger) bases, and proazaphosphatran (Verkade) bases.

The compound (DB) having basicity that is reduced or lost upon irradiation with actinic rays or radiation (hereinafter also referred to as a "compound (DB)") is a compound which has a proton-accepting functional group, and decomposes under irradiation with actinic rays or radiation to exhibit deterioration in proton-accepting properties, no proton-accepting properties, or a change from the proton-accepting properties to acidic properties.

The proton-accepting functional group refers to a functional group having a group capable of electrostatically interacting with a proton or an electron, and for example, means a functional group with a macrocyclic structure, such as a cyclic polyether, or a functional group having a nitrogen atom having an unshared electron pair not contributing to $\pi$-conjugation. The nitrogen atom having an unshared electron pair not contributing to $\pi$-conjugation is, for example, a nitrogen atom having a partial structure represented by the following general formula.

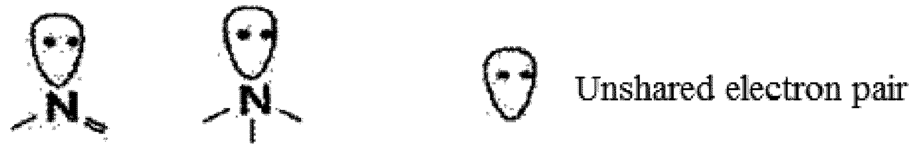


Preferred examples of the partial structure of the proton-accepting functional group include a crown ether structure, an azacrown ether structure, primary to tertiary amine structures, a pyridine structure, an imidazole structure, and a pyrazine structure.

The compound (DB) decomposes upon irradiation with actinic rays or radiation to generate a compound exhibiting deterioration in proton-accepting properties, no proton-accepting properties, or a change from the proton-accepting properties to acidic properties. Here, an expression of generating a compound which exhibits deterioration in proton-accepting properties, no proton-accepting properties, or a change from the proton-accepting properties to acidic properties is a change of proton-accepting properties due to the proton being added to the proton-accepting functional group. Specifically, the expression means a decrease in the equilibrium constant at chemical equilibrium in a case where a proton adduct is generated from the compound (DB) having the proton-accepting functional group and the proton.

With regard to specific examples of the compound (DB), reference can be made to those described in paragraphs [0421] to [0428] of JP2014-41328A or paragraphs [0108] to [0116] of JP2014-134686A, the contents of which are incorporated herein by reference.

As the onium salt (DC) which is a weak acid relative to the acid generator, compounds represented by General Formulae (d1-1) to (d1-3) are preferable.

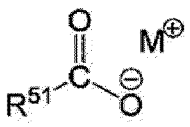
(d1-1)

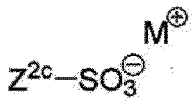
(d1-2)

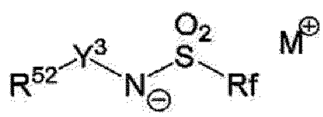
(d1-3)

In the formula, $R^{51}$ is a hydrocarbon group which may have a substituent, $Z^{2c}$ is a hydrocarbon group having 1 to 30 carbon atoms, which may have a substituent (provided that carbon adjacent to S is not substituted with a fluorine atom), $R^{52}$ is an organic group, $Y^3$ is a linear, branched or cyclic alkylene group or an arylene group, Rf is a hydrocarbon group including a fluorine atom, and $M^+$'s are each independently an ammonium cation, a sulfonium cation, or an iodonium cation.

$R^{51}$ is preferably an aryl group which may have a substituent, more preferably an aryl group having a fluorine atom-containing substituent (a fluoroalkyl group such as a trifluoromethyl group), and still more preferably a phenyl group having a fluorine atom-containing substituent. The number of fluorine atoms contained in $R^{51}$ is preferably 1 to 12, and more preferably 3 to 9.

As the sulfonium cation or the iodonium cation represented by $M^+$, the sulfonium cation in General Formula (ZI) and the iodonium cation in General Formula (ZII) are preferable.

Specific examples of an acid diffusion control agent are shown below, but the present invention is not limited thereto.

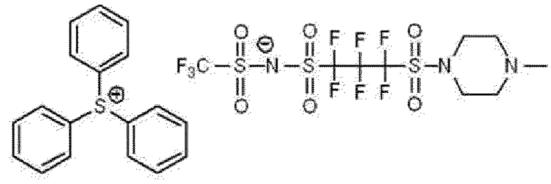
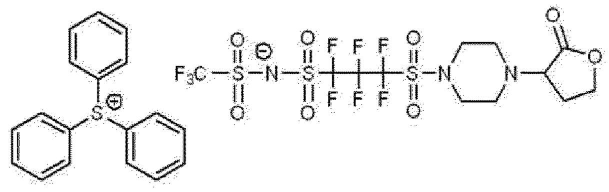

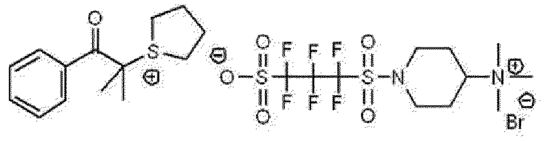
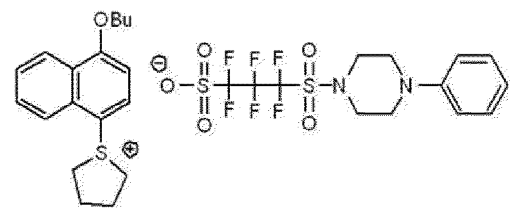

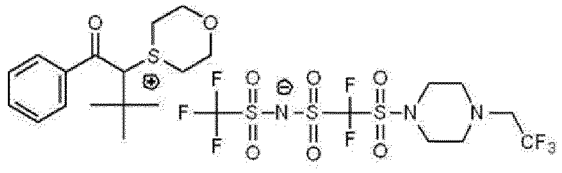
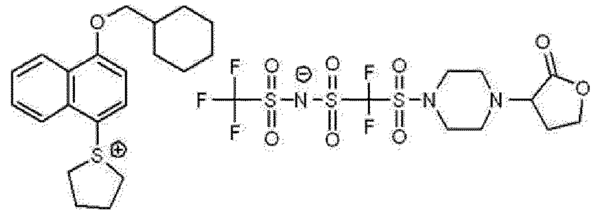

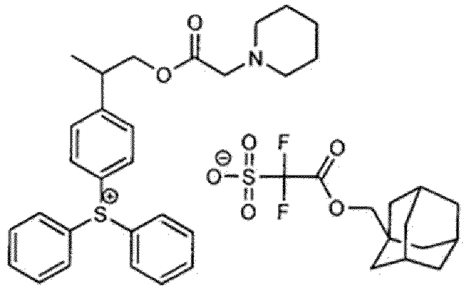
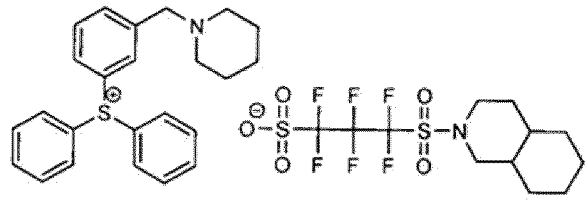

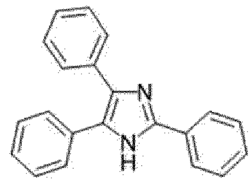
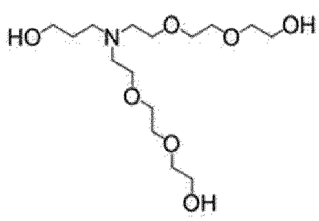

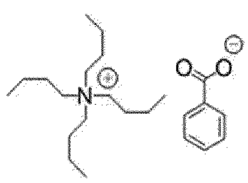
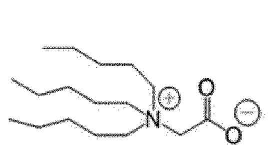
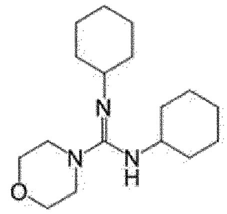
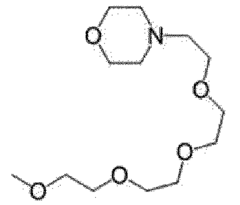

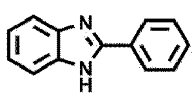

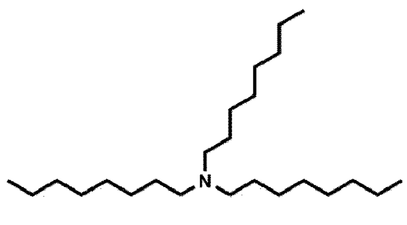

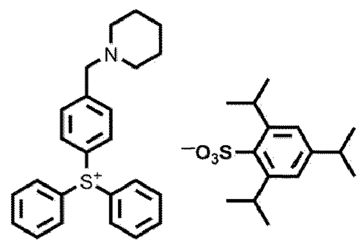

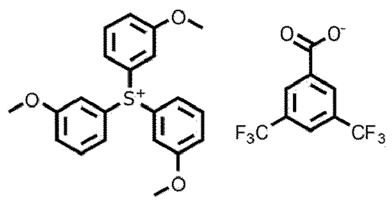

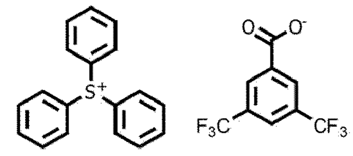

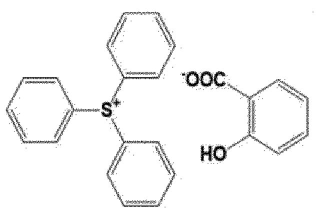

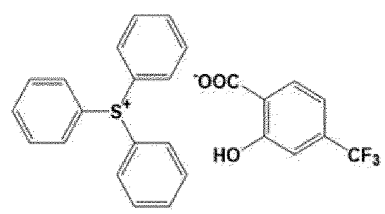

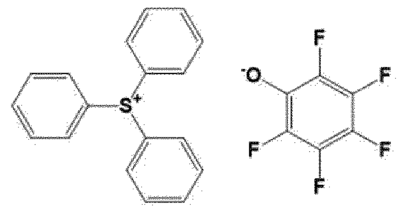

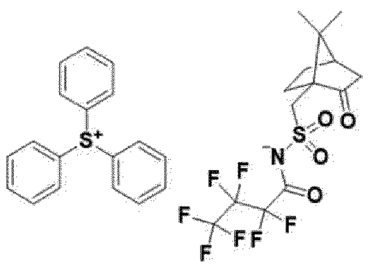

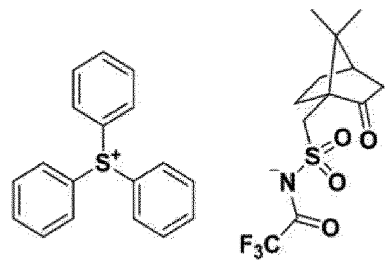

The content of the acid diffusion control agent in the resist composition is preferably 0.001% to 20% by mass, and more preferably 0.01% to 10% by mass with respect to the total solid content of the composition.

The acid diffusion control agents may be used alone or in combination of two or more kinds thereof.

The ratio of the photoacid generator and the acid diffusion control agent in the resist composition, photoacid generator/acid diffusion control agent (molar ratio), is preferably 2.5 to 300. From the viewpoints of the sensitivity and the resolution, the molar ratio is preferably 2.5 or more, and from the viewpoint of suppression of reduction in the resolution as the resist pattern is thickened with aging after exposure until the heating treatment, the molar ratio is preferably 300 or less. The photoacid generator/acid diffusion control agent (molar ratio) is more preferably 5.0 to 200, and still more preferably 7.0 to 150.

Examples of the acid diffusion control agent include the compounds (amine compounds, amide group-containing compounds, urea compounds, nitrogen-containing heterocyclic compounds, and the like) described in paragraphs [0140] to [0144] of JP2013-11833A.

[Hydrophobic Resin]

The resist composition may include a hydrophobic resin other than the resin (A), in addition to the resin (A).

Although it is preferable that the hydrophobic resin is designed to be unevenly distributed on a surface of the resist film, it does not necessarily need to have a hydrophilic group in its molecule as different from the surfactant, and may not contribute to uniform mixing of polar materials and nonpolar materials.

Examples of the effect of addition of the hydrophobic resin include a control of static and dynamic contact angles of a surface of the resist film with respect to water and suppression of out gas.

The hydrophobic resin preferably has any one or more of a "fluorine atom", a "silicon atom", and a "$CH_3$ partial

structure which is contained in a side chain moiety of a resin" from the viewpoint of uneven distribution on the film surface layer, and more preferably has two or more kinds thereof. Incidentally, the hydrophobic resin preferably has a hydrocarbon group having 5 or more carbon atoms. These groups may be contained in the main chain of the resin or may be substituted in the side chain.

In a case where hydrophobic resin includes a fluorine atom and/or a silicon atom, the fluorine atom and/or the silicon atom in the hydrophobic resin may be included in the main chain or the side chain of the resin.

In a case where the hydrophobic resin includes a fluorine atom, as a partial structure having a fluorine atom, an alkyl group having a fluorine atom, a cycloalkyl group having a fluorine atom, or an aryl group having a fluorine atom is preferable.

The alkyl group having a fluorine atom (preferably having 1 to 10 carbon atoms, and more preferably having 1 to 4 carbon atoms) is a linear or branched alkyl group in which at least one hydrogen atom is substituted with a fluorine atom, and may further have a substituent other than a fluorine atom.

The cycloalkyl group having a fluorine atom is a monocyclic or polycyclic cycloalkyl group in which at least one hydrogen atom is substituted with a fluorine atom, and may further have a substituent other than a fluorine atom.

Examples of the aryl group having a fluorine atom include an aryl group such as a phenyl group and a naphthyl group, in which at least one hydrogen atom is substituted with a fluorine atom, and the aryl group may further have a substituent other than the fluorine atom.

Examples of the repeating unit having a fluorine atom or a silicon atom include those exemplified in paragraph [0519] of US2012/0251948A1.

Moreover, it is also preferable that the hydrophobic resin includes a $CH_3$ partial structure in the side chain moiety as described above.

Here, the $CH_3$ partial structure contained in the side chain moiety in the hydrophobic resin includes a $CH_3$ partial structure contained in an ethyl group, a propyl group, and the like.

On the other hand, a methyl group bonded directly to the main chain of the hydrophobic resin (for example, an a-methyl group in the repeating unit having a methacrylic acid structure) makes only a small contribution of uneven distribution to the surface of the hydrophobic resin due to the effect of the main chain, and it is therefore not included in the $CH_3$ partial structure in the present invention.

With regard to the hydrophobic resin, reference can be made to the description in paragraphs [0348] to [0415] of JP2014-010245A, the contents of which are incorporated herein by reference.

In addition, the resins described in JP2011-248019A, JP2010-175859A, and JP2012-032544A can also be preferably used as the hydrophobic resin.

In a case where the resist composition includes a hydrophobic resin, the content of the hydrophobic resin is preferably 0.01% to 20% by mass, and more preferably 0.1% to 15% by mass with respect to the total solid content of the composition.

[Surfactant]

The resist composition may include a surfactant. By incorporation of the surfactant, the adhesiveness is more excellent and a pattern having reduced development defects can be obtained.

As the surfactant, fluorine- and/or silicon-based surfactants are preferable.

Examples of the fluorine-based and/or silicon-based surfactants include the surfactants described in paragraph [0276] of the specification of US2008/0248425A. Further, EFTOP EF301 or EF303 (manufactured by Shin-Akita Chemical Co., Ltd.); FLORAD FC430, 431, or 4430 (manufactured by Sumitomo 3M Japan Limited); MEGAFACE F171, F173, F176, F189, F113, F110, F177, F120, or R08 (manufactured by DIC Corporation); SURFLON S-382, SC101, 102, 103, 104, 105, or 106 (manufactured by Asahi Glass Co., Ltd.); TROYSOL S-366 (manufactured by Troy Chemical Industries, Inc.); GF-300 or GF-150 (manufactured by Toagosei Co., Ltd.); SURFLON S-393 (manufactured by AGC Seimi Chemical Co., Ltd.); EFTOP EF121, EF122A, EF122B, RF122C, EF125M, EF135M, EF351, EF352, EF801, EF802, or EF601 (manufactured by JEMCO Inc.); PF636, PF656, PF6320, or PF6520 (manufactured by OMNOVA Solutions Inc.); KH-20 (manufactured by Asahi Kasei Co., Ltd.); or FTX-204G, 208G, 218G, 230G, 204D, 208D, 212D, 218D, or 222D (manufactured by NEOS COMPANY LIMITED) may be used. In addition, Polysiloxane Polymer KP-341 (manufactured by Shin-Etsu Chemical Co., Ltd.) can also be used as the silicon-based surfactant.

Furthermore, as the surfactant, a compound synthesized a fluoroaliphatic compound produced by a telomerization method (also referred to as a telomer method) or an oligomerization method (also referred to as an oligomer method) may be used, in addition to the known surfactants as shown above. Specifically, a polymer comprising a fluoroaliphatic group derived from the fluoroaliphatic compound may also be used as the surfactant. The fluoroaliphatic compound can be synthesized in accordance with the method described in JP2002-90991A.

In addition, a surfactant other than the fluorine-based surfactant and/or the silicon-based surfactants described in paragraph [0280] of the specification of US2008/0248425A may be used.

These surfactants may be used alone or in combination of two or more kinds thereof.

In a case where the resist composition includes a surfactant, the content of the surfactant is preferably 0.0001% to 2% by mass, and more preferably 0.0005% to 1% by mass with respect to the total solid content of the composition.

[Other Additives]

The resist composition may further include, in addition to the components, a dissolution inhibiting compound, a dye, a plasticizer, a photosensitizer, a light absorber, a compound promoting a solubility in a developer (for example, a phenol compound having a molecular weight of 1,000 or less or an alicyclic or aliphatic compound including a carboxyl group), or the like.

The resist composition may further include a dissolution inhibiting compound. Here, the "dissolution inhibiting compound" is intended to mean a compound having a molecular weight of 3,000 or less, whose solubility in an organic developer decreases by decomposition by the action of an acid.

[Pattern Forming Method]

The procedure of the pattern forming method using the resist composition is not particularly limited, but preferably has the following steps.

Step 1: A step of forming a resist film on a substrate, using a resist composition
Step 2: A step of exposing the resist film with EUV light
Step 3: A step of developing the exposed resist film using an alkali developer to form a pattern

Hereinafter, the procedure of each of the steps will be described in detail.

In addition, aspects using an alkali developer will be described below, but an aspect of forming a pattern using an organic solvent as a developer is also available.

<Step 1: Resist film Forming Step>

The step 1 is a step of forming a resist film on a substrate, using a resist composition.

The definition of the resist composition is as described above.

Examples of a method in which a resist film is formed on a substrate, using a resist composition, include a method in which a resist composition is applied onto a substrate.

In addition, it is preferable that the resist composition before the application is filtered through a filter, as desired. The pore size of the filter is preferably 0.1 μm or less, more preferably 0.05 μm or less, and still more preferably 0.03 μm or less. Further, the filter is preferably a polytetrafluoroethylene-, polyethylene-, or nylon-made filter.

The resist composition is applied to a substrate (examples: a silicon- or silicon dioxide-coated substrate) as used for the manufacture of an integrated circuit element, by an appropriate coating method such as a method using a spinner, a coater, or the like. The spin application using a spinner is preferable as the coating method. The rotation speed upon the spin application using a spinner is preferably 1,000 to 3,000 rpm.

After the application of the resist composition, the substrate may be dried to form a resist film. In addition, various base films (an inorganic film, an organic film, or an antireflection film) may be formed below the resist film, as desired.

Examples of the drying method include a method of performing drying by heating. Heating may be performed using a unit comprised in a typical exposing machine and/or developing machine, or may also be performed using a hot plate or the like. The heating temperature is preferably 80°C to 150°C, more preferably 80°C to 140°C, and still more preferably 80°C to 130°C. The heating time is preferably 30 to 1,000 seconds, more preferably 60 to 800 seconds, and still more preferably 60 to 600 seconds.

The film thickness of the resist film is not particularly limited, but from the viewpoint that a more accurate fine pattern can be formed, the film thickness is preferably 10 to 65 nm, more preferably 15 to 50 nm.

Moreover, a topcoat may be formed on the upper layer of the resist film using a topcoat composition.

It is preferable that the topcoat composition is not mixed with the resist film and can be uniformly applied onto the upper layer of the resist film.

In addition, it is preferable that the resist film is dried before forming the topcoat. Subsequently, a topcoat composition can be applied onto the obtained resist film by the same unit as for the method for forming the resist film, and further dried to form a topcoat.

The film thickness of the topcoat is preferably 10 to 200 nm, more preferably 20 to 100 nm, and still more preferably 40 to 80 nm.

The topcoat is not particularly limited, a topcoat known in the related art can be formed by the methods known in the related art, and the topcoat can be formed, based on the description in paragraphs [0072] to [0082] of JP2014-059543A, for example.
It is preferable that a topcoat including a basic compound as described in JP2013-61648A, for example, is formed on a resist film. Specific examples of the basic compound which can be included in the topcoat include a basic compound which may be included in the resist composition.
In addition, the topcoat preferably includes a compound including at least one of a group or bond selected from the group consisting of an ether bond, a thioether bond, a hydroxyl group, a thiol group, a carbonyl bond, and an ester bond.

<Step 2: Exposing Step>

The step 2 is a step of exposing the resist film with EUV light.
Examples of an exposing method include a method in which a resist film formed is irradiated with EUV light through a predetermined mask.
After exposure, it is preferable to perform baking (heating) before performing development. The reaction of the exposed area is promoted by baking, and the sensitivity and the pattern shape are improved.
The heating temperature is preferably 80°C to 150°C, more preferably 80°C to 140°C, and still more preferably 80°C to 130°C.
The heating time is preferably 10 to 1,000 seconds, more preferably 10 to 180 seconds, and still more preferably 30 to 120 seconds.
Heating may be performed using a unit comprised in a typical exposing machine and/or developing machine, or may also be performed using a hot plate or the like.
This step is also referred to as post-exposure baking.

<Step 3: Developing Step>

The step 3 is a step of developing the exposed resist film using an alkali developer to form a pattern.
Examples of the developing method include a method in which a substrate is immersed in a tank filled with a developer for a certain period of time (a dip method), a method in which development is performed by heaping a developer up onto the surface of a substrate by surface tension, and then leaving it to stand for a certain period of time (a puddle method), a method in which a developer is sprayed on the surface of a substrate (a spray method), and a method in which a developer is continuously jetted onto a substrate rotating at a constant rate while scanning a developer jetting nozzle at a constant rate (a dynamic dispense method).
In addition, a step of stopping development while replacing the solvent with another solvent may be performed after the developing step.
The developing time is not particularly limited as long as it is a period of time where the non-exposed area of a resin is sufficiently dissolved and is preferably 10 to 300 seconds, and more preferably 20 to 120 seconds.
The temperature of the developer is preferably 0°C to 50°C, and more preferably 15°C to 35°C.
As the alkali developer, an aqueous alkali solution including an alkali is preferably used. The type of the aqueous alkali solution is not particularly limited, but examples thereof include an aqueous alkali solution including a quaternary ammonium salt typified by tetramethylammonium hydroxide, an inorganic alkali, a primary amine, a secondary amine, a tertiary amine, an alcoholamine, a cyclic amine, or the like. Among those, the aqueous solutions of the quaternary ammonium salts typified by tetramethylammonium hydroxide (TMAH) are preferable as the alkali developer. To the alkali developer may be added an appropriate amount of alcohols, a surfactant, or the like. The alkali concentration of the alkali developer is usually 0.1% to 20% by mass. In addition, the pH of the alkali developer is usually 10.0 to 15.0.

<Other Steps>

The pattern forming method preferably includes a step of performing washing using a rinsing liquid after the step 3.
Examples of the rinsing liquid used in the rinsing step after the step of performing development using an alkali developer include pure water. In addition, an appropriate amount of a surfactant may be added to pure water.
An appropriate amount of a surfactant may be added to the rinsing liquid.
A method for the rinsing step is not particularly limited, but examples thereof include a method in which a rinsing liquid is continuously jetted on a substrate rotated at a constant rate (a rotation application method), a method in which a substrate is immersed in a tank filled with a rinsing liquid for a certain period of time (a dip method), and a method in which a rinsing liquid is sprayed on a substrate surface (a spray method).
Furthermore, the pattern forming method of the embodiment of the present invention may include a heating

step (post-baking) after the rinsing step. By the present step, the developer and the rinsing liquid remaining between the patterns and inside the pattern are removed by baking. Furthermore, an effect that the resist pattern is annealed to improve the surface roughness of a pattern is obtained by the present step. The heating step after the rinsing step is usually performed at a heating temperature of 40°C to 250°C (preferably 90°C to 200°C), usually for 10 seconds to 3 minutes (preferably for 30 seconds to 120 seconds).

Moreover, an etching treatment of a substrate may be carried out using the formed pattern as a mask.

That is, the substrate (or the underlayer film and the substrate) may be processed using the pattern formed in the step 3 as a mask, thereby forming a pattern on the substrate.

A method for processing the substrate (or the underlayer film and the substrate) is not particularly limited, but a method in which a pattern is formed on a substrate by subjecting the substrate (or the underlayer film and the substrate) to dry etching using the pattern formed in the step 3 as a mask is preferable.

The dry etching may be one-stage etching or multi-stage etching. In a case where the etching is etching including a plurality of stages, the etchings at the respective stages may be the same treatment or different treatment.

For etching, any of known methods can be used, and various conditions and the like are appropriately determined according to the type of a substrate, usage, and the like. The etching can be carried out, for example, in accordance with a Journal of The International Society for Optical Engineering (Proc. of SPIE), Vol. 6924, 692420 (2008), JP2009-267112A, and the like. In addition, etching can also be carried out in accordance with "Chapter 4 Etching" in "Semiconductor Process Text Book, 4th Ed., published in 2007, publisher: SEMI Japan".

Among those, the dry etching is preferably oxygen plasma etching.

It is preferable that various materials (for example, a solvent, a developer, a rinsing liquid, a composition for forming an antireflection film, and a composition for forming a topcoat) used in the resist composition and the pattern forming method of the embodiment of the present invention do not include impurities such as metals. The content of the impurities included in these materials is preferably 1 ppm by mass or less, more preferably 10 ppb by mass or less, still more preferably 100 ppt by mass or less, particularly preferably 10 ppt by mass or less, and most preferably 1 ppt by mass or less. Here, examples of the metal impurities include Na, K, Ca, Fe, Cu, Mg, Al, Li, Cr, Ni, Sn, Ag, As, Au, Ba, Cd, Co, Pb, Ti, V, W, and Zn.

Examples of a method for removing impurities such as metals from the various materials include filtration using a filter. As for the filter pore diameter, the pore size is preferably less than 100 nm, more preferably 10 nm or less, and still more preferably 5 nm or less. As the filter, a polytetrafluoroethylene-made filter, a polyethylene-made filter, or a nylon-made filter is preferable. The filter may be constituted with a composite material formed by combining the filter material with an ion exchange medium. As the filter, a filter which had been washed with an organic solvent in advance may be used. In the step of filtration using a filter, a plurality of kinds of filters may be connected in series or in parallel, and used. In a case of using the plurality of kinds of filters, a combination of filters having different pore diameters and/or materials may be used. In addition, various materials may be filtered plural times, and the step of filtering plural times may be a circulatory filtration step.

In the production of the resist composition, it is preferable that after dissolving the respective components such as a resin and a photoacid generator in a solvent, circulatory filtration is performed using a plurality of filters with different materials. For example, it is preferable to connect a polyethylene-made filter with a pore diameter of 50 nm, a nylon-made filter with a pore diameter of 10 nm, and a polyethylene-made filter with a pore diameter of 3 nm in permuted connection, and then perform circulatory filtration ten times or more. A smaller pressure difference among the filters is preferable, and the pressure difference is generally 0.1 MPa or less, preferably 0.05 MPa or less, and more preferably 0.01 MPa or less. A smaller pressure difference between the filter and the charging nozzle is also preferable, and the pressure difference is generally 0.5 MPa or less, preferably 0.2 MPa or less, and more preferably 0.1 MPa or less.

It is preferable to subject the inside of a device for producing the resist composition to gas replacement with inert gas such as nitrogen. Thus, it is possible to suppress active gas such as oxygen from being dissolved in the composition.

After being filtered by a filter, the resist composition is charged into a clean container. It is preferable that the resist composition charged in the container is subjected to refrigeration storage. Thus, it is possible to suppress performance deterioration over time. A shorter time from completion of the charge of the composition into the container to initiation of refrigeration storage is preferable, and the time is generally within 24 hours, preferably within 16 hours, more preferably within 12 hours, and still more preferably 10 hours. The storage temperature is preferably 0°C to 15°C, more preferably 0°C to 10°C, and still more preferably 0°C to 5°C.

In addition, examples of a method for reducing the impurities such as a metal included in various materials include a method of selecting raw materials having a low content of metals as raw materials constituting various materials, a method of subjecting raw materials constituting various materials to filtration using a filter, and a method of performing distillation under a condition for suppressing the contamination as much as possible by, for example, lining the inside of a device with TEFLON (registered trademark).

In addition to filtration using a filter, removal of impurities by an adsorbing material may be performed, or a

combination of filtration using a filter and an adsorbing material may be used. As the adsorbing material, known adsorbing materials may be used, and for example, inorganic adsorbing materials such as silica gel and zeolite, and organic adsorbing materials such as activated carbon can be used. It is necessary to prevent the incorporation of impurities such as a metal in the production process in order to reduce the impurities such as metals included in the various materials. Sufficient removal of metal impurities from a production device can be checked by measuring the content of metal components included in a washing liquid used to wash the production device. The content of the metal components included in the washing liquid after the use is preferably 100 parts per trillion (ppt) by mass or less, more preferably 10 ppt by mass or less, and still more preferably 1 ppt by mass or less.

An electrically conductive compound may be added to an organic treatment liquid such as a rinsing liquid in order to prevent failure of chemical liquid pipe and various parts (a filter, an O-ring, a tube, or the like) due to electrostatic charge, and subsequently generated electrostatic discharge. The electrically conductive compound is not particularly limited and examples thereof include methanol. The addition amount is not particularly limited, but from the viewpoint that preferred development characteristics or rinsing characteristics are maintained, the addition amount is preferably 10% by mass or less, and more preferably 5% by mass or less.

As the chemical liquid pipe, various pipes coated with stainless steel (SUS), or a polyethylene, polypropylene, or fluorine resin (a polytetrafluoroethylene or perfluoroalkoxy resin, or the like) that has been subjected to an antistatic treatment can be used. Similarly, a polyethylene resin, a polypropylene resin, or a fluorine resin (a polytetrafluoroethylene or perfluoroalkoxy resin, or the like) which has been subjected to an antistatic treatment can be used for a filter and an O-ring.

A method for improving the surface roughness of a pattern may be applied to a pattern formed by the method of the present invention. Examples of the method for improving the surface roughness of the pattern include the method of treating a pattern by a plasma of a hydrogen-containing gas disclosed in WO2014/002808A. Additional examples of the method include known methods as described in JP2004-235468A, US2010/0020297A, JP2008-83384A, and Proc. of SPIE Vol. 8328 83280N-1 "EUV Resist Curing Technique for LWR Reduction and Etch Selectivity Enhancement".

In a case where a pattern formed is in the form of a line, an aspect ratio determined by dividing a height of the pattern with a line width is preferably 2.5 or less, more preferably 2.1 or less, and still more preferably 1.7 or less.

In a case where a pattern formed is in the form of a trench (groove) pattern or a contact hole pattern, an aspect ratio determined by dividing a height of the pattern with the trench width or the hole diameter is preferably 4.0 or less, more preferably 3.5 or less, and still more preferably 3.0 or less.

The pattern forming method of the embodiment of the present invention can be used for guide pattern formation in a directed self-assembly (DSA) (see, for example, ACS Nano Vol. 4, No. 8, Pages 4815-4823).

In addition, a pattern thus formed by the method can be used as a core material (core) of the spacer process disclosed in, for example, JP1991-270227A (JP-H03-270227A) and JP2013-164509A.

Moreover, the present invention further relates to a method for manufacturing an electronic device, including the above-described pattern forming method, and an electronic device manufactured by the manufacturing method.

The electronic device of an embodiment of the present invention is suitably mounted on electric and electronic equipment (for example, home electronics, office automation (OA)-related equipment, media-related equipment, optical equipment, telecommunication equipment, and the like).

## Examples

Hereinafter, the present invention will be described in more detail with reference to Examples. The materials, the amounts of materials used, the proportions, the treatment details, the treatment procedure, and the like shown in Examples below may be appropriately modified as long as the modifications do not depart from the spirit of the present invention. Therefore, the scope of the present invention should not be construed as being limited to Examples shown below.

### [Various Components of Photosensitive Composition for EUV Light]

### [Resin X]

Resins X (resins P-1 to P-87) are shown in Table 1 and Table 2.

As resins P-1 to P-87, resins synthesized according to a method for synthesizing a resin P-1 (Synthesis Example 1) which will be described later were used. The repeating units, the compositional ratios (mass ratios), the weight-average molecular weights (Mw), and the dispersities (Mw/Mn) of the respective repeating units are shown in Table 1.

Furthermore, the weight-average molecular weight (Mw) and the dispersity (Mw/Mn) of the resins P-1 to P-87 were measured by GPC(carrier: tetrahydrofuran (THF)) (an amount expressed in terms of polystyrene). In addition, the compositional ratio (ratio based on % by mass) of the resin was measured by $^{13}C$-nuclear magnetic resonance (NMR).

In Table 1, the "Note" column shows the types of repeating units included in the resin. Specifically, the "Formula (A-1X)" column shows whether or not the resin includes the repeating unit represented by General Formula (A-1X); and a case where the resin includes the repeating unit represented by General Formula (A-1X) and a case where the resin does not include the repeating unit represented by General Formula (A-1X) are represented by "A" and "B", respectively.

Furthermore, the "Formula (A-2X) or Formula (A-3X)" column shows whether or not the repeating unit represented by General Formula (A-1X) includes the repeating unit represented by General Formula (A-2X) or General Formula (A-3X) in a case where the resin includes the repeating unit represented by General Formula (A-1X); and a case where the resin includes the repeating unit represented by General Formula (A-2X) or General Formula (A-3X) and a case where the resin does not include the repeating unit represented by General Formula (A-2X) or General Formula (A-3X) are represented by "A" and "B", respectively.

Moreover, the "Formula (A-1Y)" column shows whether or not the resin includes the repeating unit represented by Formula (A-1Y), and a case where the resin includes the repeating unit represented by Formula (A-1Y) and a case where the resin does not include the repeating unit represented by Formula (A-1Y) are represented by "A" and "B", respectively.

In addition, the "Lactone structure" column shows whether or not the resin includes a "repeating unit including a lactone structure", and a case where the resin includes a "repeating unit including a lactone structure" and a case where the resin does not include a "repeating unit including a lactone structure" are represented by "A" and "B", respectively.

Furthermore, the "Formula (A-2Z)" column shows whether or not "the repeating unit having lactone structure" includes the repeating unit represented by General Formula (A-2Z) in a case where the resin includes "the repeating unit having lactone structure", and a case where the resin includes the repeating unit represented by General Formula (A-2Z) and a case where the resin does not include the repeating unit represented by General Formula (A-2Z) are represented by "A" and "B", respectively.

[Table 1]

Table 1-1

| Resin | Compositional ratio (mass ratio) | Mw | Dispersity | Note | | | | |
|---|---|---|---|---|---|---|---|---|
| | | | | Formula (A-1X) | Formula (A-2X) or Formula (A-3X) | Formula (A-1Y) | Lactone structure | Formula (A-2Z) |
| P-1 | M-1/M-11/M-17 = 35/25/40 | 7,000 | 1.6 | A | A | B | A | A |
| P-2 | M-2/M-12/M-18 = 30/20/50 | 6,500 | 1.6 | A | A | B | A | A |
| P-3 | M-3/M-13/M-19 = 30/20/50 | 8,500 | 1.8 | A | B | B | A | A |
| P-4 | M-4/M-14/M-20 = 30/20/50 | 7,000 | 1.6 | A | B | B | A | A |
| P-5 | M-5/M-12/M-17 = 35/20/45 | 8,000 | 1.7 | A | B | B | A | A |
| P-6 | M-6/M-12/M-17 = 30/20/50 | 6,000 | 1.7 | B | - | A | A | A |
| P-7 | M-7/M-12/M-17 = 30/20/50 | 6,500 | 1.8 | B | - | A | A | A |
| P-8 | M-8/M-12/M-17 = 35/30/35 | 7,000 | 1.8 | B | - | A | A | A |
| P-9 | M-9/M-12/M-17 = 35/20/45 | 5,500 | 1.7 | B | - | A | A | A |

(continued)

| Resin | Compositional ratio (mass ratio) | Mw | Dispersity | Note | | | | |
|---|---|---|---|---|---|---|---|---|
| | | | | Formula (A-1X) | Formula (A-2X) or Formula (A-3X) | Formula (A-1Y) | Lactone structure | Formula (A-2Z) |
| P-10 | M-10/M-12/M-17 = 35/20/45 | 7,500 | 1.9 | B | - | A | A | A |
| p-11 | M-1/M-14/M-18 = 30/20/50 | 7,000 | 1.7 | A | A | B | A | A |
| P-12 | M-1/M-15/M-18 = 30/20/50 | 8,000 | 2 | A | A | B | A | B |
| P-13 | M-2/M-16/M-18 = 30/20/50 | 6,000 | 1.8 | A | A | B | A | B |
| P-14 | M-1/M-6/M-19 = 30/10/60 | 6,500 | 1.6 | A | A | A | B | - |
| P-15 | M-2/M-7/M-19 = 25/10/65 | 6,000 | 1.6 | A | A | A | B | - |
| P-16 | M-3/M-8/M-20 = 30/10/60 | 7,000 | 1.7 | A | B | A | B | - |
| P-17 | M-4/M-9/M-20 = 30/10/60 | 6,500 | 1.8 | A | B | A | B | - |
| P-18 | M-5/M-10/M-20 = 30/10/60 | 7,000 | 1.7 | A | B | A | B | - |
| P-19 | M-1/M-12/M-21 = 30/20/50 | 6,000 | 1.9 | A | A | B | A | A |
| P-20 | M-1/M-12/M-22 = 30/20/50 | 7,500 | 1.8 | A | A | B | A | A |
| P-21 | M-1/M-12/M-23 = 10/50/40 | 7,000 | 1.6 | A | A | B | A | A |
| P-22 | M-1/M-12/M-17/M-24 = 30/10/50/10 | 7,000 | 1.7 | A | A | B | A | A |
| P-23 | M-1/M-6/M-12/M-19 = 20/10/15/55 | 7,000 | 1.7 | A | A | A | A | A |
| P-24 | M-1/M-12/M-19 = 30/20/50 | 6,500 | 1.6 | A | A | B | A | A |
| P-25 | M-1/M-13/M-19 = 30/20/50 | 7,000 | 1.8 | A | A | B | A | A |
| P-26 | M-1/M-14/M-19 = 30/20/50 | 7,000 | 1.5 | A | A | B | A | A |
| P-27 | M-1/M-15/M-19 = 30/20/50 | 7,500 | 1.6 | A | A | B | A | B |
| P-28 | M-2/M-13/M-17 = 30/20/50 | 7,000 | 1.8 | A | A | B | A | A |
| P-29 | M-2/M-14/M-17 = 30/20/50 | 6,500 | 1.9 | A | A | B | A | A |

(continued)

| Resin | Compositional ratio (mass ratio) | Mw | Dispersity | Note | | | | |
|---|---|---|---|---|---|---|---|---|
| | | | | Formula (A-1X) | Formula (A-2X) or Formula (A-3X) | Formula (A-1Y) | Lactone structure | Formula (A-2Z) |
| P-30 | M-2/M-15/M-17 = 30/20/50 | 8,000 | 1.7 | A | A | B | A | B |
| P-31 | M-24/M-11/M-17 = 35/25/40 | 7,000 | 1.6 | B | - | B | A | A |
| P-32 | M-1/M-17 = 35/65 | 7,000 | 1.6 | A | A | B | B | - |
| P-33 | M'-1/M-12/M-17 = 30/20/50 | 7,000 | 1.6 | B | - | B | A | A |
| P-34 | M-1/M-11/M-17 = 3/42/55 | 7,000 | 1.6 | A | A | B | A | A |
| P-35 | M-1/M-11/M-17 = 50/10/40 | 7,000 | 1.6 | A | A | B | A | A |

[Table 2]

Table 1-2

| Resin | Compositional ratio (mass ratio) | Mw | Dispersity | Note | | | | |
|---|---|---|---|---|---|---|---|---|
| | | | | Formula (A-1X) | Formula (A-2X) or Formula (A-3X) | Formula (A-1Y) | Lactone structure | Formula (A-2Z) |
| P-36 | M-1/M-11/M-17 = 30/35/35 | 7,000 | 1.7 | A | A | B | A | A |
| P-37 | M-1/M-11/M-17 = 30/25/45 | 6,000 | 1.6 | A | A | B | A | A |
| P-38 | M-1/M-11/M-17 = 20/30/50 | 6,500 | 1.7 | A | A | B | A | A |
| P-39 | M-1/M-11/M-17 = 30/15/55 | 7,000 | 1.7 | A | A | B | A | A |
| P-40 | M-1/M-11/M-17 = 40/20/40 | 6,500 | 1.6 | A | A | B | A | A |
| P-41 | M-2/M-11/M-17 = 40/20/40 | 7,000 | 1.8 | A | A | B | A | A |
| P-42 | M-1/M-11/M-18 = 20/20/60 | 7,500 | 1.7 | A | A | B | A | A |
| P-43 | M-1/M-11/M-18 = 20/40/40 | 7,000 | 1.7 | A | A | B | A | A |
| P-44 | M-1/M-11/M-18 = 20/35/45 | 7,000 | 1.6 | A | A | B | A | A |
| P-45 | M-1/M-11/M-18 = 30/25/45 | 6,500 | 1.6 | A | A | B | A | A |

(continued)

| Resin | Compositional ratio (mass ratio) | Mw | Dispersity | Note | | | | |
|---|---|---|---|---|---|---|---|---|
| | | | | Formula (A-1X) | Formula (A-2X) or Formula (A-3X) | Formula (A-1Y) | Lactone structure | Formula (A-2Z) |
| P-46 | M-1/M-11/M-18 = 40/15/45 | 6,500 | 1.8 | A | A | B | A | A |
| P-47 | M-1/M-12/M-17 = 30/25/45 | 7,000 | 1.6 | A | A | B | A | A |
| P-48 | M-1/M-12/M-17 = 30/15/55 | 7,000 | 1.7 | A | A | B | A | A |
| P-49 | M-1/M-12/M-17 = 30/35/35 | 6,000 | 1.6 | A | A | B | A | A |
| P-50 | M-1/M-12/M-17 = 35/25/40 | 6,500 | 1.7 | A | A | B | A | A |
| P-51 | M-1/M-12/M-17 = 30/20/50 | 7,000 | 1.8 | A | A | B | A | A |
| P-52 | M-1/M-12/M-17 = 40/15/45 | 6,500 | 1.7 | A | A | B | A | A |
| P-53 | M-1/M-12/M-17 = 25/30/45 | 6,500 | 1.7 | A | A | B | A | A |
| P-54 | M-1/M-12/M-17 = 20/20/60 | 7,000 | 1.7 | A | A | B | A | A |
| P-55 | M-1/M-12/M-17 = 20/40/40 | 6,000 | 1.6 | A | A | B | A | A |
| P-56 | M-1/M-12/M-17 = 20/30/50 | 6,500 | 1.7 | A | A | B | A | A |
| P-57 | M-1/M-12/M-17 = 40/30/30 | 7,000 | 1.7 | A | A | B | A | A |
| P-58 | M-1/M-12/M-17 = 40/20/40 | 6,500 | 1.8 | A | A | B | A | A |
| P-59 | M-1/M-12/M-18 = 30/20/50 | 6,000 | 1.7 | A | A | B | A | A |
| P-60 | M-1/M-12/M-18 = 20/30/50 | 6,500 | 1.7 | A | A | B | A | A |
| P-61 | M-1/M-12/M-18 = 40/20/40 | 6,500 | 1.6 | A | A | B | A | A |
| P-62 | M-1/M-12/M-18 = 30/25/45 | 7,000 | 1.6 | A | A | B | A | A |
| P-63 | M-1/M-12/M-18 = 30/35/35 | 6,500 | 1.6 | A | A | B | A | A |
| P-64 | M-1/M-12/M-18 = 40/15/45 | 6,500 | 1.6 | A | A | B | A | A |
| P-65 | M-1/M-12/M-18 = 30/15/55 | 6,500 | 1.8 | A | A | B | A | A |
| P-66 | M-1/M-12/M-18 = 35/25/40 | 6,000 | 1.7 | A | A | B | A | A |

(continued)

| Resin | Compositional ratio (mass ratio) | Mw | Dispersity | Note | | | | |
|---|---|---|---|---|---|---|---|---|
| | | | | Formula (A-1X) | Formula (A-2X) or Formula (A-3X) | Formula (A-1Y) | Lactone structure | Formula (A-2Z) |
| P-67 | M-1/M-12/M-18 = 25/30/45 | 6,500 | 1.6 | A | A | B | A | A |
| P-68 | M-1/M-12/M-18 = 20/20/60 | 7,000 | 1.7 | A | A | B | A | A |
| P-69 | M-1/M-12/M-18 = 20/40/40 | 7,000 | 1.7 | A | A | B | A | A |
| P-70 | M-1/M-12/M-19 = 20/35/45 | 6,000 | 1.8 | A | A | B | A | A |
| P-71 | M-1/M-12/M-19 = 30/25/45 | 7,000 | 1.6 | A | A | B | A | A |
| P-72 | M-1/M-12/M-19 = 40/15/45 | 6,500 | 1.7 | A | A | B | A | A |
| P-73 | M-6/M-11/M-18 = 20/40/40 | 6,000 | 1.8 | B | - | A | A | A |
| P-74 | M-6/M-11/M-18 = 30/30/40 | 6,500 | 1.8 | B | - | A | A | A |
| P-75 | M-6/M-11/M-18 = 40/20/40 | 6,000 | 1.7 | B | - | A | A | A |
| P-76 | M-6/M-11/M-19 = 20/40/40 | 6,500 | 1.6 | B | - | A | A | A |
| P-77 | M-6/M-11/M-19 = 30/30/40 | 7,000 | 1.8 | B | - | A | A | A |
| P-78 | M-6/M-11/M-19 = 40/20/40 | 7,500 | 1.7 | B | - | A | A | A |
| P-79 | M-6/M-12/M-17 = 20/35/45 | 7,000 | 1.8 | B | - | A | A | A |
| P-80 | M-6/M-12/M-17 = 30/25/45 | 6,500 | 1.6 | B | - | A | A | A |
| P-81 | M-6/M-12/M-17 = 40/15/45 | 6,500 | 1.7 | B | - | A | A | A |
| P-82 | M-6/M-12/M-18 = 20/40/40 | 7,000 | 1.7 | B | - | A | A | A |
| P-83 | M-6/M-12/M-18 = 30/30/40 | 6,000 | 1.8 | B | - | A | A | A |
| P-84 | M-6/M-12/M-18 = 40/20/40 | 7,000 | 1.8 | B | - | A | A | A |
| P-85 | M-6/M-12/M-19 = 20/40/40 | 6,000 | 1.6 | B | - | A | A | A |
| P-86 | M-6/M-12/M-19 = 30/30/40 | 7,000 | 1.7 | B | - | A | A | A |
| P-87 | M-6/M-12/M-19 = 40/20/40 | 6,500 | 1.7 | B | - | A | A | A |

The structures of the raw material monomers constituting the resins P-1 to P-87 are shown below.

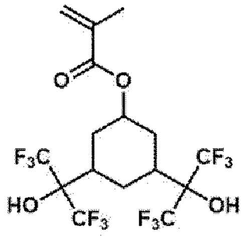

M-1

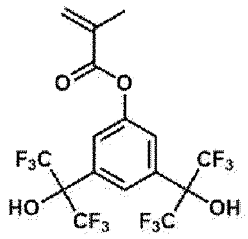

M-2

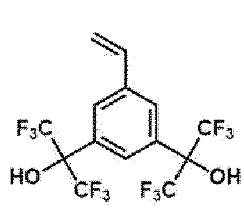

M-3

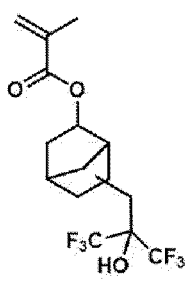

M-4

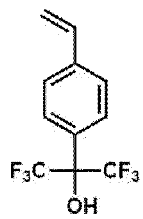

M-5

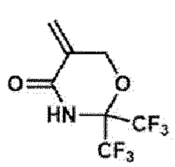

M-6

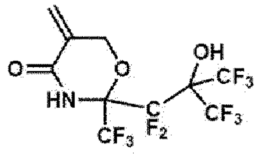

M-7

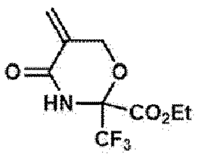

M-8

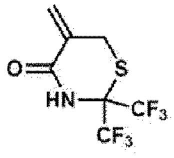

M-9

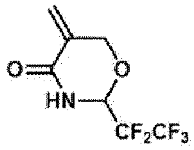

M-10

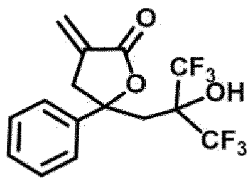

M'-1

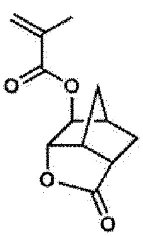

M-11

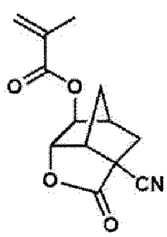

M-12

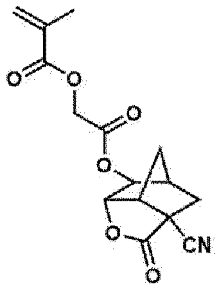

M-13

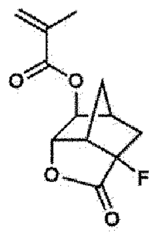

M-14

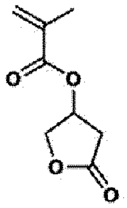

M-15

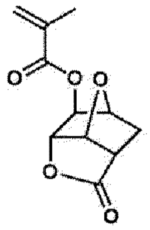

M-16

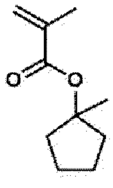

M-17

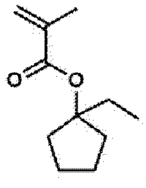

M-18

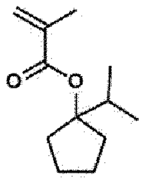

M-19

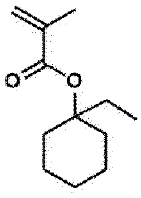

M-20

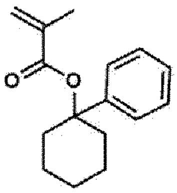

M-21

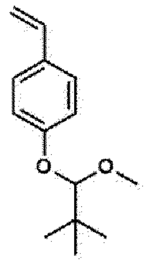

M-22

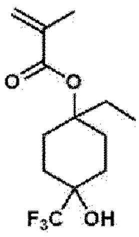

M-23

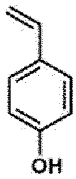

M-24

<Synthesis Example 1: Synthesis of Resin P-1>

18 g, 15 g, and 27 g, in order from the left side, of monomers corresponding to the respective repeating units (M-1/M-11/M-17) of a polymer P-1 and a polymerization initiator V-601 (manufactured by Wako Pure Chemical Industries, Co., Ltd.) (4.0 g) were dissolved in cyclohexanone (70 g). A solution thus obtained was taken as a monomer solution.

Cyclohexanone (70 g) was put into a reaction vessel, and the monomer solution was added dropwise to the reaction vessel for 4 hours in a system that had been adjusted to 85°C in a nitrogen gas atmosphere. The obtained reaction solution was stirred at 85°C for 2 hours in the reaction vessel and then left to be cooled until the reaction solution reached room temperature.

The reaction solution after being left to be cooled was added dropwise to a mixed liquid of methanol and water (methanol/water = 5/5 (mass ratio)) for 20 minutes and the precipitated powder was filtered. The obtained powder was dried to obtain a polymer P-1.

The compositional ratio (mass ratio) of the repeating units determined by an NMR method was 35/25/40. The weight-average molecular weight in terms of polystyrene as a standard and the dispersity (Mw/Mn) of the polymer P-1 were 7,000 and 1.6, respectively.

[Photoacid Generator]

The structures of photoacid generators (B-1 to B-10) shown in Table 2 are shown below.

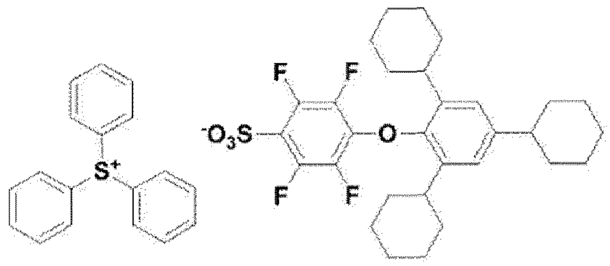

B-1

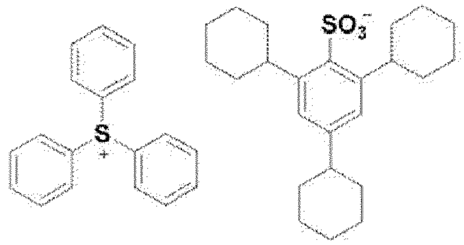

B-2

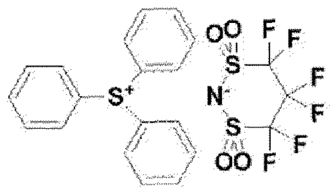

B-3

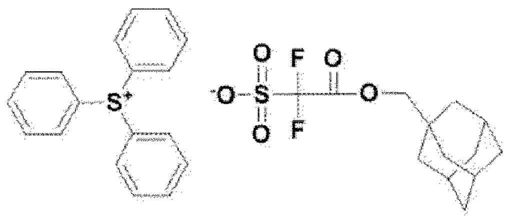

B-4

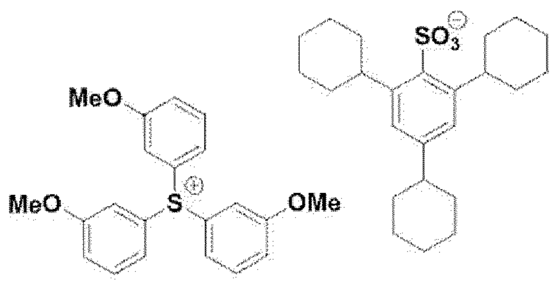

B-5

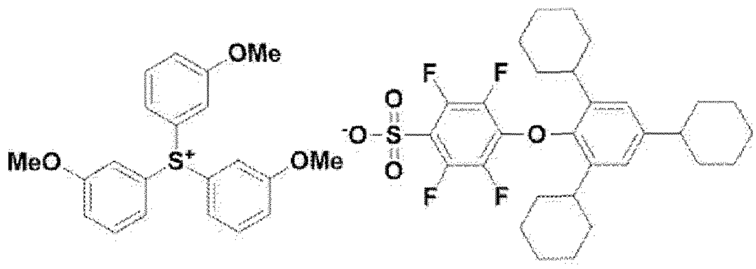

B-6

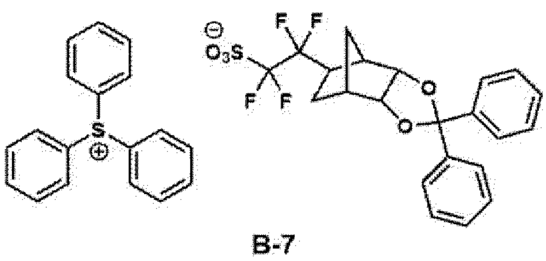

B-7

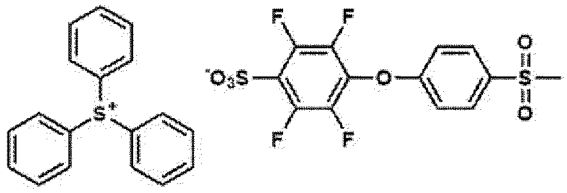

B-8

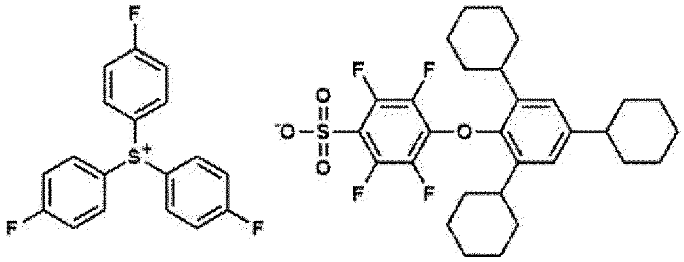

B-9

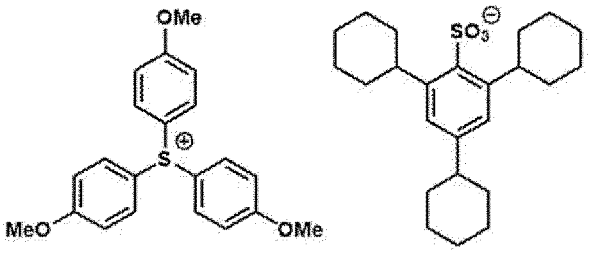

B-10

[Acid Diffusion Control Agent]

The structures of acid diffusion control agents (C-1 to C-9) shown in Table 2 are shown below.

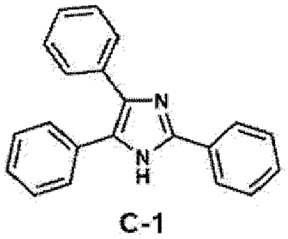

C-1

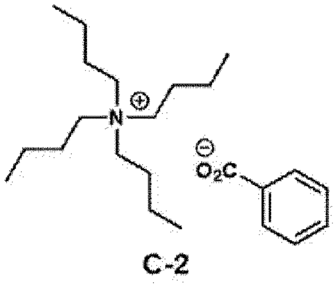

C-2

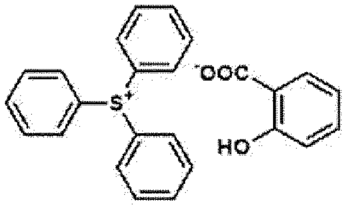

C-3

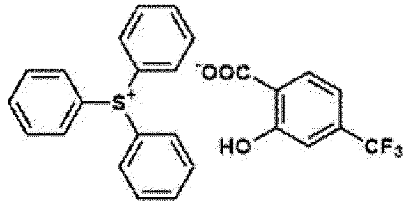

C-4

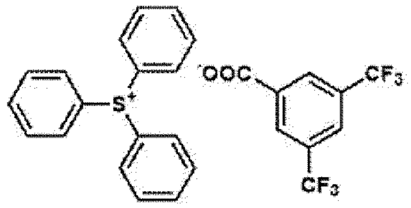
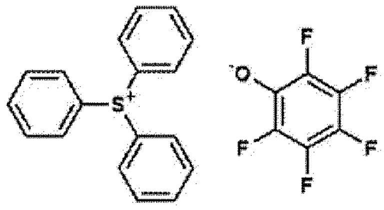

C-5 C-6

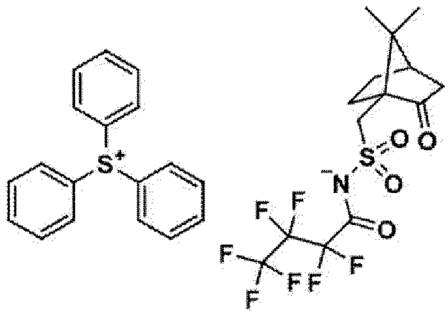

C-7

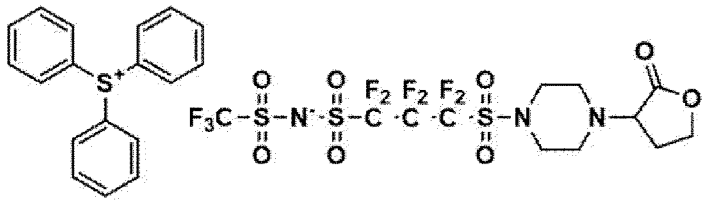

C-8

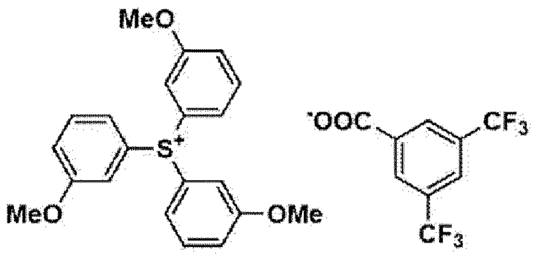

C-9

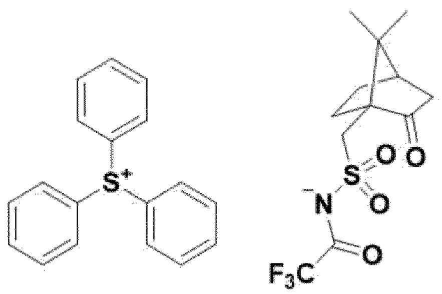

C-10

[Hydrophobic Resin]

The structure of the hydrophobic resin (ADP-1) shown in Table 2 is shown below.

In addition, the numerical values in the following formulae represent % by mole of the respective repeating units. The weight-average molecular weight (Mw) and the dispersity (Mw/Mn) of the hydrophobic resin ADP-1 were measured by GPC (carrier: tetrahydrofuran (THF)) (amount expressed in terms of polystyrene). In addition, the compositional ratio (ratio based on % by mole) of the resin was measured by $^{13}C$-nuclear magnetic resonance

(NMR).

[0375]

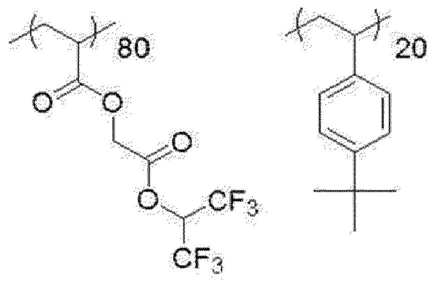

**ADP-1** Mw = 14,000
Mw/Mn = 1.7

The structure of the hydrophobic resins (ADP-2) and (ADP-3) shown in Table 2 is shown below.

In addition, the numerical values in the following formulae represent % by mole of the respective repeating units. The weight-average molecular weight (Mw) and the dispersity (Mw/Mn) of the hydrophobic resins ADP-2 and ADP-3 were measured by GPC (carrier: tetrahydrofuran (THF)) (amount expressed in terms of polystyrene). In addition, the compositional ratio (ratio based on % by mole) of the resin was measured by $^{13}C$-nuclear magnetic resonance (NMR).

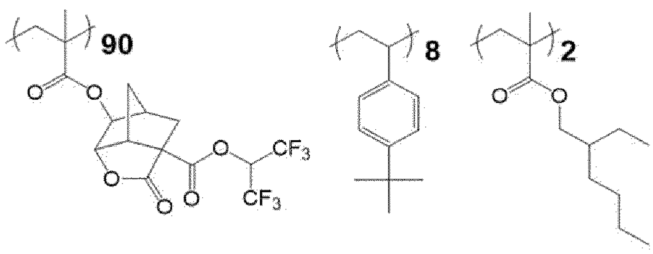

**ADP-2** Mw = 12,000
Mw/Mn = 1.8

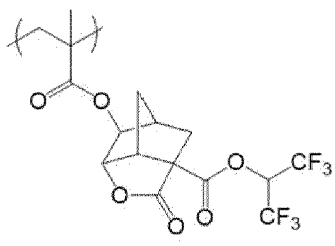

**ADP-3** Mw = 13,000
Mw/Mn = 1.7

[Solvent]

The solvents shown in Table 2 are shown below.

S-1: Propylene glycol monomethyl ether (PGME)
S-2: Propylene glycol monomethyl ether acetate (PGMEA)

S-3: Ethyl lactate
S-4: γ-Butyrolactone

[Preparation of Photosensitive Composition for EUV Light]

The respective components shown in Table 2 were mixed to have a concentration of solid contents (% by mass) described in Table 2. Next, the obtained mixed liquid was filtered through firstly a polyethylene-made filter having a pore diameter of 50 nm, a nylon-made filter having a pore diameter of 10 nm, and lastly a polyethylene-made filter having a pore diameter of 5 nm in this order to prepare a photosensitive composition for EUV light (hereinafter also referred to as a "resist composition"). In addition, in the resist composition, the solid content means all the components excluding the solvent. The obtained resist composition was used in Examples and Comparative Examples.
Furthermore, in Table 2, the content (% by mass) of each component means a content with respect to the total solid content.

[Table 3]

Table 2-1

| Resist composition | Concentration [%] of solid contents | Resin A | | Photoacid generator | | | | Acid diffusion control agent | | | | Hydrophobic resin | | Solvent (mass ratio) |
|---|---|---|---|---|---|---|---|---|---|---|---|---|---|---|
| | | Type | Content [% by mass] | Type | Content [%by mass] | Type | Content [% by mass] | Type | Content [% by mass] | Type | Content [% by mass] | Type | Content [% by mass] | |
| R-1 | 2.1 | P-1 | 76.6 | B-1 | 20.8 | - | - | C-5 | 2.6 | - | - | - | - | S-1/S-2 = 80/20 |
| R-2 | 2 | P-2 | 76.6 | B-1 | 20.8 | - | - | C-5 | 2.6 | - | - | - | - | S-1/S-2 = 80/20 |
| R-3 | 2.2 | P-3 | 77.3 | B-1 | 19.1 | - | - | C-5 | 3.6 | - | - | - | - | S-1/S-2 = 80/20 |
| R-4 | 1.9 | P-4 | 77.3 | B-1 | 19.1 | - | - | C-5 | 3.6 | - | - | - | - | S-1/S-2 = 80/20 |
| R-5 | 2.3 | P-5 | 76.6 | B-1 | 20.8 | - | - | C-5 | 2.6 | - | - | - | - | S-1/S-2 = 80/20 |
| R-6 | 2.2 | P-6 | 75.8 | B-1 | 21.6 | - | - | C-5 | 2.6 | - | - | - | - | S-1/S-2 = 80/20 |
| R-7 | 2.0 | P-7 | 74.8 | B-1 | 21.6 | - | - | C-5 | 2.6 | - | - | ADP-1 | 1.0 | S-1/S-2 = 80/20 |
| R-8 | 1.8 | P-8 | 75.8 | B-1 | 21.6 | - | - | C-5 | 2.6 | - | - | - | - | S-1/S-2 = 80/20 |
| R-9 | 1.7 | P-9 | 75.8 | B-1 | 21.6 | - | - | C-5 | 2.6 | - | - | - | - | S-1/S-2 = 80/20 |
| R-10 | 1.9 | P-10 | 75.8 | B-1 | 21.6 | - | - | C-5 | 2.6 | - | - | - | - | S-1/S-2 = 80/20 |
| R-11 | 2.0 | P-11 | 76.6 | B-1 | 20.8 | - | - | C-5 | 2.6 | - | - | - | - | S-1/S-2 = 80/20 |
| R-12 | 2.3 | P-12 | 76.6 | B-1 | 20.8 | - | - | C-5 | 2.6 | - | - | - | - | S-1/S-2 = 80/20 |
| R-13 | 1.8 | P-13 | 76.6 | B-1 | 20.8 | - | - | C-5 | 2.6 | - | - | - | - | S-1/S-2 = 80/20 |

(continued)

| Resist composition | Concentration [%] of solid contents | Resin A | | Photoacid generator | | | | Acid diffusion control agent | | | | Hydrophobic resin | | Solvent (mass ratio) |
|---|---|---|---|---|---|---|---|---|---|---|---|---|---|---|
| | | Type | Content [% by mass] | Type | Content [%by mass] | Type | Content [% by mass] | Type | Content [% by mass] | Type | Content [% by mass] | Type | Content [% by mass] | |
| R-14 | 1.6 | P-14 | 77.0 | B-1 | 19.9 | - | - | C-5 | 3.1 | - | - | - | - | S-1/S-2 = 80/20 |
| R-15 | 1.8 | P-15 | 77.0 | B-1 | 19.9 | - | - | C-5 | 3.1 | - | - | - | - | S-1/S-2 = 80/20 |
| R-16 | 2.2 | P-16 | 77.0 | B-1 | 19.9 | - | - | C-5 | 3.1 | - | - | - | - | S-1/S-2 = 80/20 |
| R-17 | 2.1 | P-17 | 77.0 | B-1 | 19.9 | - | - | C-5 | 3.1 | - | - | - | - | S-1/S-2 = 80/20 |
| R-18 | 2.0 | P-18 | 77.0 | B-1 | 19.9 | - | - | C-5 | 3.1 | - | - | - | - | S-1/S-2 = 80/20 |
| R-19 | 1.9 | P-19 | 77.0 | B-1 | 19.9 | - | - | C-5 | 3.1 | - | - | - | - | S-1/S-2 = 80/20 |
| R-20 | 1.9 | P-20 | 77.3 | B-1 | 19.1 | - | - | C-5 | 3.6 | - | - | - | - | S-1/S-2 = 80/20 |
| R-21 | 1.8 | P-21 | 76.0 | B-1 | 22.4 | - | - | C-5 | 1.6 | - | - | - | - | S-1/S-2 = 80/20 |
| R-22 | 2.0 | P-22 | 75.3 | B-1 | 21.6 | - | | C-5 | 3.1 | - | - | - | - | S-1/S-2 = 80/20 |
| R-23 | 2.1 | P-23 | 77.0 | B-1 | 19.9 | - | - | C-5 | 3.1 | - | - | - | - | S-1/S-2 = 80/20 |
| R-24 | 2.2 | P-24 | 76.6 | B-1 | 20.8 | - | - | C-5 | 2.6 | - | - | - | - | S-1/S-2 = 80/20 |
| R-25 | 2.1 | P-25 | 76.6 | B-1 | 20.8 | - | - | C-5 | 2.6 | - | - | - | - | S-1/S-2 = 80/20 |
| R-26 | 1.8 | P-26 | 76.6 | B-1 | 20.8 | - | - | C-5 | 2.6 | - | - | - | - | S-1/S-2 = 80/20 |

(continued)

| Resist composition | Concentration [%] of solid contents | Resin A | | Photoacid generator | | | | Acid diffusion control agent | | | | Hydrophobic resin | | Solvent (mass ratio) |
|---|---|---|---|---|---|---|---|---|---|---|---|---|---|---|
| | | Type | Content [% by mass] | Type | Content [%by mass] | Type | Content [% by mass] | Type | Content [% by mass] | Type | Content [% by mass] | Type | Content [% by mass] | |
| R-27 | 1.9 | P-27 | 76.6 | B-1 | 20.8 | - | - | C-5 | 2.6 | - | - | - | - | S-1/S-2 = 80/20 |
| R-28 | 1.8 | P-28 | 76.6 | B-1 | 20.8 | - | - | C-5 | 2.6 | - | - | - | - | S-1/S-2 = 80/20 |
| R-29 | 2.0 | P-29 | 76.6 | B-1 | 20.8 | - | - | C-5 | 2.6 | - | - | - | - | S-1/S-2 = 80/20 |
| R-30 | 2.0 | P-30 | 76.6 | B-1 | 20.8 | - | - | C-5 | 2.6 | - | - | - | - | S-1/S-2 = 80/20 |
| R-31 | 2.1 | P-23 | 75.8 | B-1 | 20.8 | - | - | C-7 | 3.4 | - | - | - | - | S-1/S-2 = 80/20 |
| R-32 | 2.3 | P-23 | 79.9 | B-2 | 17.3 | - | - | C-7 | 2.8 | - | - | - | - | S-1/S-2/S-3 = 20/20/60 |
| R-33 | 2.1 | P-23 | 77.5 | B-1 | 15.8 | B-3 | 3.3 | C-7 | 3.4 | - | - | - | - | S-1/S-2 = 80/20 |
| R-34 | 2.0 | P-23 | 81.7 | B-4 | 13.5 | - | - | C-7 | 4.8 | - | - | - | - | S-1/S-2 = 80/20 |
| R-35 | 2.2 | P-23 | 77.5 | B-5 | 19.7 | - | - | C-7 | 2.8 | - | - | - | - | S-1/S-2/S-3 = 20/20/60 |
| R-36 | 1.9 | P-23 | 73.7 | B-6 | 23.9 | - | - | C-9 | 2.4 | - | - | - | - | S-1/S-2 = 80/20 |
| R-37 | 1.9 | P-23 | 78.2 | B-7 | 18.4 | - | - | C-7 | 3.4 | - | - | - | - | S-1/S-2 = 80/20 |
| R-38 | 2.0 | P-23 | 80.0 | B-8 | 16.6 | - | - | C-7 | 3.4 | - | - | - | - | S-1/S-2 = 80/20 |

(continued)

| Resist composition | Concentration [%] of solid contents | Resin A | | Photoacid generator | | | | Acid diffusion control agent | | | | Hydrophobic resin | | Solvent (mass ratio) |
|---|---|---|---|---|---|---|---|---|---|---|---|---|---|---|
| | | Type | Content [% by mass] | Type | Content [%by mass] | Type | Content [% by mass] | Type | Content [% by mass] | Type | Content [% by mass] | Type | Content [% by mass] | |
| R-39 | 2.4 | P-23 | 74.5 | B-9 | 22.1 | - | - | C-7 | 3.4 | - | - | - | - | S-1/S-2 = 80/20 |
| R-40 | 1.5 | P-23 | 76.8 | B-10 | 20.4 | - | - | C-7 | 2.8 | - | - | - | - | S-1/S-2/S-3 = 20/20/60 |
| R-41 | 1.8 | P-2 | 75.5 | B-6 | 23.0 | - | - | C-1 | 1.5 | - | - | - | - | S-1/S-2 = 80/20 |
| R-42 | 1.9 | P-2 | 75.2 | B-6 | 23.0 | - | - | C-2 | 1.8 | - | - | - | - | S-1/S-2 = 80/20 |
| R-43 | 1.9 | P-2 | 75.0 | B-6 | 23.0 | - | - | C-3 | 2.0 | | - | - | - | S-1/S-2 = 80/20 |
| R-44 | 1.8 | P-2 | 74.7 | B-6 | 23.0 | - | - | C-4 | 2.3 | - | - | - | - | S-1/S-2 = 80/20 |
| R-45 | 2.0 | P-2 | 74.8 | B-6 | 23.0 | - | - | C-6 | 2.2 | - | - | - | - | S-1/S-2 = 80/20 |
| R-46 | 2.0 | P-2 | 73.6 | B-6 | 23.0 | - | - | C-7 | 3.4 | - | - | - | - | S-1/S-2 = 80/20 |
| R-47 | 2.0 | P-2 | 72.7 | B-6 | 23.0 | - | - | C-8 | 4.3 | - | - | | - | S-1/S-2 = 80/20 |
| R-48 | 2.0 | P-2 | 73.9 | B-6 | 23.0 | - | - | C-9 | 3.1 | - | - | - | - | S-1/S-2 = 80/20 |
| R-49 | 2.0 | P-2 | 75.0 | B-6 | 23.0 | - | - | C-1 | 0.7 | C-5 | 1.3 | - | - | S-1/S-2 = 80/20 |
| R-50 | 2.0 | P-31 | 76.6 | B-1 | 20.8 | - | - | C-5 | 2.6 | - | - | - | - | S-1/S-2 = 80/20 |
| R-51 | 2.0 | P-32 | 76.6 | B-1 | 20.8 | - | - | C-5 | 2.6 | - | - | - | - | S-1/S-2 = 80/20 |

(continued)

| Resist composition | Concentration [%] of solid contents | Resin A | | Photoacid generator | | | | Acid diffusion control agent | | | | Hydrophobic resin | | Solvent (mass ratio) |
|---|---|---|---|---|---|---|---|---|---|---|---|---|---|---|
| | | Type | Content [% by mass] | Type | Content [%by mass] | Type | Content [% by mass] | Type | Content [% by mass] | Type | Content [% by mass] | Type | Content [% by mass] | |
| R-52 | 2.0 | P-33 | 76.6 | B-1 | 20.8 | - | - | C-5 | 2.6 | - | - | - | - | S-1/S-2 = 80/20 |
| R-53 | 2.0 | P-34 | 76.6 | B-1 | 20.8 | - | - | C-5 | 2.6 | - | - | - | - | S-1/S-2 = 80/20 |
| R-54 | 2.0 | P-35 | 76.6 | B-1 | 20.8 | - | - | C-5 | 2.6 | - | - | - | - | S-1/S-2 = 80/20 |

[Table 4]

Table 2-2

| Resist composition | Concentration [%] of solid contents | Resin A | | Photoacid generator | | | | Acid diffusion control agent | | | | Hydrophobic resin | | Solvent (mass ratio) |
|---|---|---|---|---|---|---|---|---|---|---|---|---|---|---|
| | | Type | Content [%by mass] | Type | Content [%by mass] | Type | Content [%by mass] | Type | Content [% by mass] | Type | Content [%by mass] | Type | Content [% by mass] | |
| R-55 | 2.1 | P-36 | 77.0 | B-1 | 19.9 | - | - | C-5 | 3.1 | - | - | - | - | S-1/S-2/S-4 = 80/10/10 |
| R-56 | 2.0 | P-37 | 71.0 | B-1 | 19.9 | - | - | C-7 | 4.1 | - | - | ADP-2 | 5.0 | S-1/S-2/S-4 = 80/10/10 |
| R-57 | 2.1 | P-38 | 72.6 | B-1 | 20.8 | - | - | C-5 | 2.6 | - | - | ADP-2 | 4.0 | S-1/S-2 = 80/20 |
| R-58 | 2.1 | P-39 | 76.5 | B-1 | 21.2 | - | - | C-5 | 2.3 | - | - | - | - | S-1/S-2 = 80/20 |
| R-59 | 2.0 | P-40 | 74.5 | B-1 | 19.9 | - | - | C-7 | 4.1 | - | - | ADP-1 | 1.5 | S-1/S-2/S-4 = 80/10/10 |
| R-60 | 2.0 | P-41 | 77.0 | B-1 | 19.9 | - | - | C-5 | 3.1 | - | - | - | - | S-1/S-2 = 80/20 |
| R-61 | 2.1 | P-42 | 67.3 | B-6 | 23.9 | - | - | C-7 | 2.8 | - | - | ADP-2 | 6.0 | S-1/S-2/S-4 = 80/10/10 |
| R-62 | 2.1 | P-43 | 72.6 | B-1 | 19.9 | - | - | C-10 | 3.5 | - | - | ADP-3 | 4.0 | S-1/S-2/S-4 = 80/10/10 |
| R-63 | 2.2 | P-44 | 73.0 | B-1 | 19.9 | - | - | C-5 | 3.1 | - | - | ADP-2 | 4.0 | S-1/S-2/S-4 = 80/15/5 |
| R-64 | 2.1 | P-45 | 73.0 | B-1 | 19.9 | - | - | C-7 | 4.1 | - | - | ADP-3 | 3.0 | S-1/S-2/S-4 = 80/10/10 |

(continued)

| Resist composition | Concentration [%] of solid contents | Resin A | | Photoacid generator | | | | Acid diffusion control agent | | | | Hydrophobic resin | | Solvent (mass ratio) |
|---|---|---|---|---|---|---|---|---|---|---|---|---|---|---|
| | | Type | Content [%by mass] | Type | Content [%by mass] | Type | Content [%by mass] | Type | Content [% by mass] | Type | Content [%by mass] | Type | Content [% by mass] | |
| R-65 | 2.0 | P-46 | 74.8 | B-6 | 22.1 | - | - | C-5 | 3.1 | - | - | - | - | S-1/S-2 = 80/20 |
| R-66 | 2.2 | P-47 | 69.7 | B-1 | 21.3 | - | - | C-7 | 3.0 | - | - | ADP-2 | 6.0 | S-1/S-2/S-4 = 80/10/10 |
| R-67 | 2.0 | P-48 | 76.6 | B-1 | 21.4 | - | - | C-4 | 2.0 | - | - | - | - | S-1/S-2/S-4 = 80/15/5 |
| R-68 | 2.1 | P-49 | 71.0 | B-1 | 19.9 | - | - | C-7 | 4.1 | - | - | ADP-2 | 5.0 | S-1/S-2/S-4 = 80/15/5 |
| R-69 | 2.1 | P-50 | 71.6 | B-1 | 19.9 | - | - | C-10 | 3.5 | - | - | ADP-2 | 5.0 | S-1/S-2/S-4 = 80/15/5 |
| R-70 | 2.1 | P-51 | 74.5 | B-6 | 22.6 | - | - | C-5 | 2.9 | - | - | - | - | S-1/S-2 = 80/20 |
| R-71 | 2.0 | P-52 | 71.0 | B-1 | 19.9 | - | - | C-7 | 4.1 | - | - | ADP-3 | 5.0 | S-1/S-2/S-4 = 80/15/5 |
| R-72 | 2.1 | P-53 | 77.0 | B-1 | 19.9 | - | - | C-5 | 3.1 | - | - | - | - | S-1/S-2/S-4 = 80/10/10 |
| R-73 | 2.2 | P-54 | 68.0 | B-1 | 21.6 | - | - | C-10 | 2.4 | - | - | ADP-2 | 8.0 | S-1/S-2 = 80/20 |
| R-74 | 2.0 | P-55 | 69.0 | B-1 | 19.9 | - | - | C-7 | 4.1 | - | - | ADP-2 | 7.0 | S-1/S-2 = 80/20 |

(continued)

| Resist composition | Concentration [%] of solid contents | Resin A | | Photoacid generator | | | | Acid diffusion control agent | | | | Hydrophobic resin | | Solvent (mass ratio) |
|---|---|---|---|---|---|---|---|---|---|---|---|---|---|---|
| | | Type | Content [%by mass] | Type | Content [%by mass] | Type | Content [%by mass] | Type | Content [% by mass] | Type | Content [%by mass] | Type | Content [% by mass] | |
| R-75 | 2.0 | P-56 | 71.0 | B-1 | 19.9 | - | - | C-7 | 4.1 | - | - | ADP-2 | 5.0 | S-1/S-2/S-4 = 80/15/5 |
| R-76 | 2.2 | P-57 | 76.0 | B-1 | 19.9 | - | - | C-7 | 4.1 | - | - | - | - | S-1/S-2/S-4 = 80/15/5 |
| R-77 | 2.1 | P-58 | 72.0 | B-1 | 19.9 | - | - | C-7 | 4.1 | - | - | ADP-2 | 4.0 | S-1/S-2/S-4 = 80/15/5 |
| R-78 | 1.9 | P-59 | 76.8 | B-1 | 20.3 | - | - | C-5 | 2.9 | - | - | - | - | S-1/S-2 = 80/20 |
| R-79 | 2.0 | P-60 | 77.0 | B-1 | 19.9 | - | - | C-5 | 3.1 | - | - | ADP-3 | 4.0 | S-1/S-2/S-4 = 80/15/5 |
| R-80 | 2.2 | P-61 | 68.0 | B-1 | 19.9 | - | - | C-7 | 4.1 | - | - | ADP-2 | 8.0 | S-1/S-2/S-4 = 80/5/15 |
| R-81 | 2.0 | P-62 | 70.0 | B-1 | 19.9 | - | - | C-7 | 4.1 | - | - | ADP-3 | 6.0 | S-1/S-2/S-4 = 80/15/5 |
| R-82 | 2.0 | P-63 | 77.0 | B-1 | 19.9 | - | - | C-5 | 3.1 | - | - | - | - | S-1/S-2/S-4 = 80/10/10 |
| R-83 | 2.2 | P-64 | 69.7 | B-1 | 21.3 | - | - | C-7 | 3.0 | - | - | ADP-2 | 6.0 | S-1/S-2/S-4 = 80/10/10 |
| R-84 | 2.0 | P-65 | 77.7 | B-1 | 19.9 | - | - | C-3 | 2.4 | - | - | - | - | S-1/S-2 = 80/20 |

(continued)

| Resist composition | Concentration [%] of solid contents | Resin A | | Photoacid generator | | | | Acid diffusion control agent | | | | Hydrophobic resin | | Solvent (mass ratio) |
|---|---|---|---|---|---|---|---|---|---|---|---|---|---|---|
| | | Type | Content [%by mass] | Type | Content [%by mass] | Type | Content [%by mass] | Type | Content [% by mass] | Type | Content [%by mass] | Type | Content [% by mass] | |
| R-85 | 2.0 | P-66 | 71.0 | B-1 | 19.9 | - | - | C-7 | 4.1 | - | - | ADP-2 | 5.0 | S-1/S-2/S-4 = 80/10/10 |
| R-86 | 2.0 | P-67 | 76.4 | B-1 | 19.9 | - | - | C-9 | 3.7 | - | - | - | - | S-1/S-2/S-4 = 80/10/10 |
| R-87 | 1.9 | P-68 | 75.0 | B-1 | 16.6 | - | - | C-7 | 3.4 | - | - | ADP-3 | 5.0 | S-1/S-2/S-4 = 80/15/5 |
| R-88 | 2.1 | P-69 | 77.0 | B-1 | 19.9 | - | - | C-5 | 3.1 | - | - | - | - | S-1/S-2 = 80/20 |
| R-89 | 2.1 | P-70 | 71.0 | B-1 | 19.9 | - | - | C-7 | 4.1 | - | - | ADP-2 | 5.0 | S-1/S-2/S-4 = 80/10/10 |
| R-90 | 2.2 | P-71 | 77.0 | B-1 | 19.9 | - | - | C-5 | 3.1 | - | - | - | - | S-1/S-2/S-4 = 80/15/5 |
| R-91 | 2.0 | P-72 | 77.0 | B-1 | 19.9 | - | - | C-5 | 3.1 | - | - | - | - | S-1/S-2 = 80/20 |
| R-92 | 2.0 | P-73 | 71.0 | B-1 | 19.9 | - | - | C-7 | 4.1 | - | - | ADP-2 | 5.0 | S-1/S-2/S-4 = 80/10/10 |
| R-93 | 1.9 | P-74 | 74.8 | B-6 | 22.1 | - | - | C-5 | 3.1 | - | - | - | - | S-1/S-2 = 80/20 |
| R-94 | 1.9 | P-75 | 76.6 | B-1 | 19.9 | - | - | C-10 | 3.5 | - | - | - | - | S-1/S-2/S-4 = 80/15/5 |

(continued)

| Resist composition | Concentration [%] of solid contents | Resin A | | Photoacid generator | | | | Acid diffusion control agent | | | | Hydrophobic resin | | Solvent (mass ratio) |
|---|---|---|---|---|---|---|---|---|---|---|---|---|---|---|
| | | Type | Content [%by mass] | Type | Content [%by mass] | Type | Content [%by mass] | Type | Content [% by mass] | Type | Content [%by mass] | Type | Content [% by mass] | |
| R-95 | 2.0 | P-76 | 70.0 | B-1 | 19.9 | - | - | C-8 | 5.1 | - | - | ADP-2 | 5.0 | S-1/S-2/S-4 = 80/15/5 |
| R-96 | 2.0 | P-77 | 77.0 | B-1 | 19.9 | - | - | C-5 | 3.1 | - | - | - | - | S-1/S-2/S-4 = 80/10/10 |
| R-97 | 2.0 | P-78 | 70.8 | B-6 | 22.1 | - | - | C-7 | 4.1 | - | - | ADP-3 | 3.0 | S-1/S-2 = 80/20 |
| R-98 | 1.9 | P-79 | 75.8 | B-1 | 20.8 | - | - | C-7 | 3.4 | - | - | - | - | S-1/S-2/S-4 = 80/15/5 |
| R-99 | 2.2 | P-80 | 78.7 | B-7 | 17.6 | - | - | C-9 | 3.7 | - | - | - | - | S-1/S-2/S-4 = 80/10/10 |
| R-100 | 2.0 | P-81 | 71.6 | B-1 | 19.9 | - | - | C-10 | 3.5 | - | - | ADP-2 | 5.0 | S-1/S-2 = 80/20 |
| R-101 | 2.2 | P-82 | 77.7 | B-1 | 19.9 | - | - | C-3 | 2.4 | - | - | - | - | S-1/S-2/S-4 = 80/15/5 |
| R-102 | 2.2 | P-83 | 72.0 | B-1 | 19.9 | - | - | C-5 | 3.1 | - | - | ADP-2 | 5.0 | S-1/S-2 = 80/20 |
| R-103 | 1.9 | P-84 | 76.0 | B-1 | 19.9 | - | - | C-7 | 4.1 | - | - | - | - | S-1/S-2/S-4 = 80/10/10 |
| R-104 | 2.1 | P-85 | 77.0 | B-1 | 19.9 | - | - | C-5 | 3.1 | - | - | - | - | S-1/S-2 = 80/20 |
| R-105 | 2.1 | P-86 | 69.8 | B-6 | 22.1 | - | - | C-7 | 4.1 | - | - | ADP-2 | 4.0 | S-1/S-2 = 80/20 |

(continued)

| Resist composition | Concentration [%] of solid contents | Resin A | | Photoacid generator | | | | Acid diffusion control agent | | | | Hydrophobic resin | | Solvent (mass ratio) |
|---|---|---|---|---|---|---|---|---|---|---|---|---|---|---|
| | | Type | Content [%by mass] | Type | Content [%by mass] | Type | Content [%by mass] | Type | Content [% by mass] | Type | Content [%by mass] | Type | Content [% by mass] | |
| R-106 | 1.9 | P-87 | 76.4 | B-1 | 19.9 | - | - | C-9 | 3.7 | - | - | - | - | S-1/S-2/S-4 = 80/15/5 |

[Pattern Formation: EUV Exposure]

A resist composition described in Table 3 was applied onto a silicon wafer (12 inches) on which an underlayer film described in Table 3 (see the column of "Resist coating condition" for a base film) had been formed, and then a coating film thus obtained was heated under a baking condition described in Table 3 (see the column of "Resist film forming condition") to form a silicon wafer having a resist film (thickness 50 nm).

The silicon wafer having the resist film was subjected to pattern irradiation using an EUV exposure device (manufactured by Exitech Ltd., Micro Exposure Tool, NA 0.3, Quadrupole, an outer sigma of 0.89, and an inner sigma of 0.38). Further, a mask with a space size = 20 nm and a line:space = 3.5:1 was used as a reticle.

Thereafter, the resist film after exposure was baked under a post-exposure baking (PEB) condition described in Table 3 (see the "PEB and development condition" column).

The resist film after baking is developed by puddling with a developer shown in Table 3 (see "PEB and development condition" column) for 30 seconds and then rinsed by puddling with a rinsing liquid (see the "PEB and development condition" column) described in Table 3, and then the silicon wafer was rotated at a rotation speed of 4,000 rpm for 30 seconds and further baked at 120°C for 60 seconds to obtain a line-and-space pattern having a pitch of 90 nm and a space width of 25 nm.

[Underlayer Film]

Underlayer films (UL-1 and UL-2) shown in Table 3 are shown below.

UL-1: AL412 (manufactured by Brewer Science Ltd.)
UL-2: SHB-A940 (manufactured by Shin-Etsu Chemical Co., Ltd.)

[Developer and Rinsing Liquid]

The developer (D-1) and rinsing liquids (R-1 and R-2) shown in Table 3 are shown below.

D-1: A 2.38%-by-mass aqueous tetramethylammonium hydroxide solution
R-1: Pure water
R-2: FIRM Extreme 10 (manufactured by AZEM)

[Evaluation]

With regard to the obtained resist pattern, various evaluations shown below were performed.

[A Value]

With regard to an atom of the component derived from the total solid content included in the resist composition, an A value which is an EUV light absorption parameter determined by Formula (1) was calculated.

$$\text{Expression (1): } A = ([H] \times 0.04 + [C] \times 1.0 + [N] \times 2.1 + [O] \times 3.6 + [F] \times 5.6 + [S] \times 1.5 + [I] \times 39.5)/([H] \times 1 + [C] \times 12 + [N] \times 14 + [O] \times 16 + [F] \times 19 + [S] \times 32 + [I] \times 127)$$

[H], [C], [N], [O], [F], [S], and [I] were computed from the structures and the contents of the components included in the resist composition.

[Volume (Å) of Acid Generated from Photoacid Generator]

After structural optimization by molecular orbital computation (MOPAC-PM3), a space was divided with Winmostar (manufactured by Cross Abilities Co., Ltd.) (division size 0.02 Å), and a Van der Waals volume thereof was calculated by a Monte Carlo method.

[Sensitivity]

While changing the exposure dose, the space width of the line-and-space pattern was measured, and the

exposure dose as the space width reached 25 nm was determined and taken as a sensitivity ($mJ/cm^2$).

In Examples 1 to 101 and Comparative Examples 1 to 5, the sensitivity was 23 $\pm$ 3 $mJ/cm^2$.

[Bridge Defect Performance]

With regard to the line-and-space resist pattern resolved at an optimum exposure dose in the sensitivity evaluation, a 5-$\mu$m square was observed with a critical dimension scanning electron microscope, and the number of pattern failure (bridge defects) in which the resist remained in the space part and formed a bridge shape was measured and evaluated on the basis of a five-stage evaluation standard shown below. Further, from a practical viewpoint, it is preferable that the bridge defect performance is "4" or higher.

<Evaluation Standard>

"5": The number of bridge defects is less than 10.
"4": The number of bridge defects is 10 or more and less than 20.
"3": The number of bridge defects is 20 or more and less than 50.
"2": The number of bridge defects is 50 or more and less than 100.
"1": The number of bridge defects is 100 or more.

[Film Thickness Reduction Suppressing Properties]

With regard to a line-and-space resist pattern resolved at an optimum exposure dose in the sensitivity evaluation, a wafer was cut to observe the cross-section from the horizontal direction with a critical dimension scanning electron microscope, and the height of a pattern part (corresponding to the height of the unexposed area) was measured. From the obtained measured values, the residual film rate after development was determined by Expression (2) and evaluated on the basis of the four-stage evaluation standard shown below. Further, from a practical viewpoint, it is preferable that the film thickness reduction suppressing properties are "3" or higher.

Residual film rate after development (%) = (Height of pattern part after development)/(Film thickness (50 nm) of resist film before exposure) x 100

<Evaluation Standard>

"4": The residual film rate after development is 80% or more.
"3": The residual film rate after development is 70% or more and less than 80%.
"2": The residual film rate after development is 60% or more and less than 70%.
"1": The residual film rate after development is less than 60%.

[Dissolution Rate (Residual Film Rate of Unexposed Area)]

A resist composition described in Table 3 was applied onto a silicon wafer (12 inches) on which an underlayer film described in Table 3 (see the column of "Resist coating condition" for a base film) had been formed, and then a coating film thus obtained was heated under a baking condition described in Table 3 (see the column of "Resist film forming condition") to form a silicon wafer having a resist film (thickness 50 nm).

Thereafter, baking was performed under a post-exposure baking (PEB) condition shown in Table 3 (see the "PEB and development condition" column) without exposure.

The resist film after baking is developed by puddling with a developer shown in Table 3 (see "PEB and development condition" column) for 30 seconds and then rinsed by puddling with a rinsing liquid (see the "PEB and development condition" column) described in Table 3, and then the silicon wafer was rotated at a rotation speed of 4,000 rpm for 30 seconds and further baked at 120°C for 60 seconds to obtain an unexposed film.

The film thickness of the obtained unexposed film was measured, the residual film rate after development was determined from the obtained measured value by Expression (3), and the residual film rate was 90% or more.

Residual film rate after development (%) = (Film thickness after development)/(Film thickness (50 nm) after coating) x 100

[Table 5]

| Table 3-1 | Resist composition | Resist coating condition | | PEB and development condition | | | A value | Content [% by mass] of photoacid generator | Volume [A] of acid generated | Evaluation results | |
|---|---|---|---|---|---|---|---|---|---|---|---|
| | | Base film | Baking condition | PEB condition | Developer | Rinsing liquid | | | | Bridge defect suppressing properties | Film thickness reduction suppressing properties |
| Example 1 | R-1 | UL-1 | 120°C/60 sec | 120°C/60 sec | D-1 | R-1 | 0.13 | 20.8 | 585 | 5 | 4 |
| Example 2 | R-2 | UL-1 | 120°C/60 sec | 120°C/60 sec | D-1 | R-1 | 0.13 | 20.8 | 585 | 5 | 4 |
| Example 3 | R-3 | UL-1 | 100°C/60 sec | 120°C/60 sec | D-1 | R-1 | 0.13 | 19.1 | 585 | 5 | 3 |
| Example 4 | R-4 | UL-1 | 120°C/60 sec | 130°C/60 sec | D-1 | R-1 | 0.12 | 19.1 | 585 | 4 | 3 |
| Example 5 | R-5 | UL-1 | 100°C/60 sec | 110°C/60 sec | D-1 | R-1 | 0.13 | 20.8 | 585 | 5 | 3 |
| Example 6 | R-6 | UL-1 | 120°C/60 sec | 140°C/60 sec | D-1 | R-1 | 0.13 | 21.6 | 585 | 5 | 4 |
| Example 7 | R-7 | UL-1 | 120°C/60 sec | 140°C/60 sec | D-1 | R-1 | 0.13 | 21.6 | 585 | 5 | 4 |
| Example 8 | R-8 | UL-1 | 120°C/60 sec | 120°C/60 sec | D-1 | R-1 | 0.13 | 21.6 | 585 | 5 | 4 |
| Example 9 | R-9 | UL-2 | 120°C/60 sec | 130°C/60 sec | D-1 | R-1 | 0.13 | 21.6 | 585 | 5 | 4 |
| Example 10 | R-10 | UL-1 | 120°C/60 sec | 120°C/60 sec | D-1 | R-1 | 0.13 | 21.6 | 585 | 5 | 4 |
| Example 11 | R-11 | UL-1 | 100°C/60 sec | 110°C/60 sec | D-1 | R-1 | 0.13 | 20.8 | 585 | 5 | 4 |
| Example 12 | R-12 | UL-1 | 120°C/60 sec | 120°C/60 sec | D-1 | R-1 | 0.13 | 20.8 | 585 | 4 | 4 |

(continued)

| Table 3-1 | Resist composition | Resist coating condition | | PEB and development condition | | | A value | Content [% by mass] of photoacid generator | Volume [A] of acid generated | Evaluation results | |
|---|---|---|---|---|---|---|---|---|---|---|---|
| | | Base film | Baking condition | PEB condition | Developer | Rinsing liquid | | | | Bridge defect suppressing properties | Film thickness reduction suppressing properties |
| Example 13 | R-13 | UL-1 | 120°C/60 sec | 120°C/60 sec | D-1 | R-1 | 0.13 | 20.8 | 585 | 4 | 4 |
| Example 14 | R-14 | UL-1 | 120°C/60 sec | 120°C/60 sec | D-1 | R-1 | 0.13 | 19.9 | 585 | 5 | 4 |
| Example 15 | R-15 | UL-1 | 120°C/60 sec | 120°C/60 sec | D-1 | R-1 | 0.13 | 19.9 | 585 | 5 | 4 |
| Example 16 | R-16 | UL-1 | 120°C/60 sec | 120°C/60 sec | D-1 | R-1 | 0.13 | 19.9 | 585 | 5 | 3 |
| Example 17 | R-17 | UL-1 | 120°C/60 sec | 120°C/60 sec | D-1 | R-1 | 0.13 | 19.9 | 585 | 5 | 3 |
| Example 18 | R-18 | UL-1 | 120°C/60 sec | 120°C/60 sec | D-1 | R-1 | 0.13 | 19.9 | 585 | 5 | 3 |
| Example 19 | R-19 | UL-1 | 120°C/60 sec | 120°C/60 sec | D-1 | R-2 | 0.13 | 19.9 | 585 | 5 | 4 |
| Example 20 | R-20 | UL-1 | 120°C/60 sec | 120°C/60 sec | D-1 | R-1 | 0.13 | 19.1 | 585 | 5 | 4 |
| Example 21 | R-21 | UL-1 | 120°C/60 sec | 120°C/60 sec | D-1 | R-1 | 0.13 | 22.4 | 585 | 5 | 4 |
| Example 22 | R-22 | UL-1 | 90°C/60 sec | 90°C/60 sec | D-1 | R-1 | 0.13 | 21.6 | 585 | 5 | 4 |
| Example 23 | R-23 | UL-1 | 120°C/60 sec | 130°C/60 sec | D-1 | R-1 | 0.13 | 19.9 | 585 | 5 | 4 |
| Example 24 | R-24 | UL-1 | 120°C/60 sec | 120°C/60 sec | D-1 | R-1 | 0.13 | 20.8 | 585 | 5 | 4 |

(continued)

| Table 3-1 | Resist composition | Resist coating condition | | PEB and development condition | | | A value | Content [% by mass] of photoacid generator | Volume [A] of acid generated | Evaluation results | |
|---|---|---|---|---|---|---|---|---|---|---|---|
| | | Base film | Baking condition | PEB condition | Developer | Rinsing liquid | | | | Bridge defect suppressing properties | Film thickness reduction suppressing properties |
| Example 25 | R-25 | UL-1 | 120°C/60 sec | 120°C/60 sec | D-1 | R-1 | 0.13 | 20.8 | 585 | 5 | 4 |
| Example 26 | R-26 | UL-1 | 100°C/60 sec | 110°C/60 sec | D-1 | R-1 | 0.13 | 20.8 | S85 | 5 | 4 |
| Example 27 | R-27 | UL-1 | 120°C/60 sec | 120°C/60 sec | D-1 | R-1 | 0.13 | 20.8 | 585 | 4 | 4 |
| Example 28 | R-28 | UL-1 | 120°C/60 sec | 130°C/60 sec | D-1 | R-1 | 0.13 | 20.8 | 585 | 5 | 4 |
| Example 29 | R-29 | UL-1 | 120°C/60 sec | 120°C/60 sec | D-1 | R-1 | 0.13 | 20.8 | 585 | 5 | 4 |
| Example 30 | R-30 | UL-1 | 120°C/60 sec | 120°C/60 sec | D-1 | R-1 | 0.13 | 20.8 | 585 | 4 | 4 |
| Example 31 | R-31 | UL-1 | 120°C/60 sec | 120°C/60 sec | D-1 | R-1 | 0.13 | 20.8 | 585 | 5 | 4 |
| Example 32 | R-32 | UL-1 | 120°C/60 sec | 120°C/60 sec | D-1 | R-1 | 0.13 | 17.3 | 437 | 5 | 4 |
| Example 33 | R-33 | UL-1 | 120°C/60 sec | 120°C/60 sec | D-1 | R-1 | 0.13 | 19.1 | 585/161 | 5 | 4 |
| Example 34 | R-34 | UL-1 | 100°C/60 sec | 110°C/60 sec | D-1 | R-1 | 0.13 | 13.5 | 270 | 5 | 3 |
| Example 35 | R-35 | UL-1 | 120°C/60 sec | 120°C/60 sec | D-1 | R-1 | 0.13 | 19.7 | 437 | 5 | 4 |
| Example 36 | R-36 | UL-1 | 120°C/60 sec | 140°C/60 sec | D-1 | R-1 | 0.13 | 23.9 | 585 | 5 | 4 |

(continued)

| Table 3-1 | Resist composition | Resist coating condition | | PEB and development condition | | | A value | Content [% by mass] of photoacid generator | Volume [Å] of acid generated | Evaluation results | |
|---|---|---|---|---|---|---|---|---|---|---|---|
| | | Base film | Baking condition | PEB condition | Developer | Rinsing liquid | | | | Bridge defect suppressing properties | Film thickness reduction suppressing properties |
| Example 37 | R-37 | UL-1 | 120°C/60 sec | 120°C/60 sec | D-1 | R-1 | 0.13 | 18.4 | 354 | 5 | 4 |
| Example 38 | R-38 | UL-1 | 100°C/60 sec | 120°C/60 sec | D-1 | R-1 | 0.13 | 16.6 | 257 | 5 | 3 |
| Example 39 | R-39 | UL-1 | 120°C/60 sec | 120°C/60 sec | D-1 | R-1 | 0.13 | 22.1 | 585 | 5 | 4 |
| Example 40 | R-40 | UL-1 | 120°C/60 sec | 120°C/60 sec | D-1 | R-1 | 0.13 | 20.4 | 437 | 5 | 4 |
| Example 41 | R-41 | UL-1 | 120°C/60 sec | 120°C/60 sec | D-1 | R-1 | 0.13 | 23.0 | 585 | 5 | 4 |
| Example 42 | R-42 | UL-1 | 120°C/60 sec | 120°C/60 sec | D-1 | R-1 | 0.13 | 23.0 | 585 | 5 | 4 |
| Example 43 | R-43 | UL-1 | 120°C/60 sec | 120°C/60 sec | D-1 | R-1 | 0.13 | 23.0 | 585 | 5 | 4 |
| Example 44 | R-44 | UL-1 | 120°C/60 sec | 120°C/60 sec | D-1 | R-1 | 0.13 | 23.0 | 585 | 5 | 4 |
| Example 45 | R-45 | UL-1 | 120°C/60 sec | 120°C/60 sec | D-1 | R-1 | 0.13 | 23.0 | 585 | 5 | 4 |
| Example 46 | R-46 | UL-1 | 120°C/60 sec | 120°C/60 sec | D-1 | R-1 | 0.13 | 23.0 | 585 | 5 | 4 |
| Example 47 | R-47 | UL-1 | 120°C/60 sec | 120°C/60 sec | D-1 | R-1 | 0.13 | 23.0 | 585 | 5 | 4 |
| Example 48 | R-48 | UL-1 | 120°C/60 sec | 120°C/60 sec | D-1 | R-1 | 0.13 | 23.0 | 585 | 5 | 4 |

(continued)

| Table 3-1 | Resist composition | Resist coating condition | | PEB and development condition | | | A value | Content [% by mass] of photoacid generator | Volume [A] of acid generated | Evaluation results | |
|---|---|---|---|---|---|---|---|---|---|---|---|
| | | Base film | Baking condition | PEB condition | Developer | Rinsing liquid | | | | Bridge defect suppressing properties | Film thickness reduction suppressing properties |
| Example 49 | R-49 | UL-1 | 120°C/60 sec | 120°C/60 sec | D-1 | R-1 | 0.13 | 23.0 | 585 | 5 | 4 |
| Comparative Example 1 | R-50 | UL-1 | 120°C/60 sec | 120°C/60 sec | D-1 | R-1 | 0.11 | 20.8 | 585 | 1 | 4 |
| Comparative Example 2 | R-51 | UL-1 | 120°C/60 sec | 120°C/60 sec | D-1 | R-1 | 0.13 | 20.8 | 585 | 3 | 3 |
| Comparative Example 3 | R-52 | UL-1 | 120°C/60 sec | 120°C/60 sec | D-1 | R-1 | 0.12 | 20.8 | 585 | 2 | 3 |
| Comparative Example 4 | R-53 | UL-1 | 120°C/60 sec | 120°C/60 sec | D-1 | R-1 | 0.11 | 20.8 | 585 | 2 | 4 |
| Comparative Example 5 | R-54 | UL-1 | 120°C/60 sec | 120°C/60 sec | D-1 | R-1 | 0.14 | 20.8 | 585 | 5 | 2 |

[Table 6]

| Table 3-2 | Resist composition | Resist coating condition | | PEB and development condition | | | A value | Content [% by mass] of photoacid generator | Volume [A] of acid generated | Evaluation results | |
|---|---|---|---|---|---|---|---|---|---|---|---|
| | | Base film | Baking condition | PEB condition | Developer | Rinsing liquid | | | | Bridge defect suppressing properties | Film thickness reduction suppressing properties |
| Example 52 | R-55 | UL-1 | 120°C/60 sec | 120°C/60 sec | D-1 | R-1 | 0.13 | 19.9 | 585 | 5 | 4 |
| Example 51 | R-56 | UL-1 | 120°C/60 sec | 120°C/60 sec | D-1 | R-1 | 0.13 | 19.9 | 585 | 5 | 4 |
| Example 50 | R-57 | UL-1 | 120°C/60 sec | 120°C/60 sec | D-1 | R-1 | 0.13 | 20.8 | 585 | 5 | 4 |
| Example 53 | R-58 | UL-1 | 120°C/60 sec | 120°C/60 sec | D-1 | R-1 | 0.13 | 21.2 | 585 | 5 | 4 |
| Example 54 | R-59 | UL-1 | 120°C/60 sec | 120°C/60 sec | D-1 | R-1 | 0.13 | 19.9 | 585 | 5 | 4 |
| Example 55 | R-60 | UL-1 | 120°C/60 sec | 120°C/60 sec | D-1 | R-1 | 0.13 | 19.9 | 585 | 5 | 4 |
| Example 56 | R-61 | UL-1 | 120°C/60 sec | 100°C/60 sec | D-1 | R-1 | 0.13 | 23.9 | 585 | 5 | 4 |
| Example 57 | R-62 | UL-1 | 120°C/60 sec | 120°C/60 sec | D-1 | R-1 | 0.13 | 19.9 | 585 | 5 | 4 |
| Example 58 | R-63 | UL-1 | 120°C/60 sec | 120°C/60 sec | D-1 | R-1 | 0.13 | 19.9 | 585 | 5 | 4 |
| Example 59 | R-64 | UL-1 | 120°C/60 sec | 120°C/60 sec | D-1 | R-1 | 0.13 | 19.9 | 585 | 5 | 4 |
| Example 60 | R-65 | UL-1 | 120°C/60 sec | 120°C/60 sec | D-1 | R-1 | 0.13 | 22.1 | 585 | 5 | 4 |
| Example 61 | R-66 | UL-1 | 120°C/60 sec | 100°C/60 sec | D-1 | R-1 | 0.13 | 21.3 | 585 | 5 | 4 |

(continued)

| Table 3-2 | Resist composition | Resist coating condition | | PEB and development condition | | | A value | Content [% by mass] of photoacid generator | Volume [A] of acid generated | Evaluation results | |
|---|---|---|---|---|---|---|---|---|---|---|---|
| | | Base film | Baking condition | PEB condition | Developer | Rinsing liquid | | | | Bridge defect suppressing properties | Film thickness reduction suppressing properties |
| Example 62 | R-67 | UL-1 | 120°C/60 sec | 120°C/60 sec | D-1 | R-1 | 0.13 | 21.4 | 585 | 5 | 4 |
| Example 63 | R-68 | UL-1 | 120°C/60 sec | 120°C/60 sec | D-1 | R-1 | 0.13 | 19.9 | 585 | 5 | 4 |
| Example 64 | R-69 | UL-1 | 120°C/60 sec | 120°C/60 sec | D-1 | R-1 | 0.13 | 19.9 | 585 | 5 | 4 |
| Example 65 | R-70 | UL-1 | 120°C/60 sec | 100°C/60 sec | D-1 | R-1 | 0.13 | 22.6 | 585 | 5 | 4 |
| Example 66 | R-71 | UL-1 | 120°C/60 sec | 120°C/60 sec | D-1 | R-1 | 0.13 | 19.9 | 585 | 5 | 4 |
| Example 67 | R-72 | UL-1 | 120°C/60 sec | 120°C/60 sec | D-1 | R-1 | 0.13 | 19.9 | 585 | 5 | 4 |
| Example 68 | R-73 | UL-1 | 120°C/60 sec | 120°C/60 sec | D-1 | R-1 | 0.13 | 21.6 | 585 | 5 | 4 |
| Example 69 | R-74 | UL-1 | 120°C/60 sec | 120°C/60 sec | D-1 | R-1 | 0.13 | 19.9 | 585 | 5 | 4 |
| Example 70 | R-75 | UL-1 | 120°C/60 sec | 120°C/60 sec | D-1 | R-1 | 0.13 | 19.9 | 585 | 5 | 4 |
| Example 71 | R-76 | UL-1 | 120°C/60 sec | 120°C/60 sec | D-1 | R-1 | 0.13 | 19.9 | 585 | 5 | 4 |
| Example 72 | R-77 | UL-1 | 120°C/60 sec | 110°C/60 sec | D-1 | R-1 | 0.13 | 19.9 | 585 | 5 | 4 |
| Example 73 | R-78 | UL-1 | 120°C/60 sec | 120°C/60 sec | D-1 | R-1 | 0.13 | 20.3 | 585 | 5 | 4 |

(continued)

| Table 3-2 | Resist composition | Resist coating condition | | PEB and development condition | | | A value | Content [% by mass] of photoacid generator | Volume [A] of acid generated | Evaluation results | |
|---|---|---|---|---|---|---|---|---|---|---|---|
| | | Base film | Baking condition | PEB condition | Developer | Rinsing liquid | | | | Bridge defect suppressing properties | Film thickness reduction suppressing properties |
| Example 74 | R-79 | UL-1 | 120°C/60 sec | 120°C/60 sec | D-1 | R-1 | 0.13 | 19.9 | 585 | 5 | 4 |
| Example 75 | R-80 | UL-1 | 120°C/60 sec | 100°C/60 sec | D-1 | R-1 | 0.13 | 19.9 | 585 | 5 | 4 |
| Example 76 | R-81 | UL-1 | 120°C/60 sec | 120°C/60 sec | D-1 | R-1 | 0.13 | 19.9 | 585 | 5 | 4 |
| Example 77 | R-82 | UL-1 | 120°C/60 sec | 120°C/60 sec | D-1 | R-1 | 0.13 | 19.9 | 585 | 5 | 4 |
| Example 78 | R-83 | UL-1 | 120°C/60 sec | 120°C/60 sec | D-1 | R-1 | 0.13 | 21.3 | 585 | 5 | 4 |
| Example 79 | R-84 | UL-1 | 120°C/60 sec | 120°C/60 sec | D-1 | R-1 | 0.13 | 19.9 | 585 | 5 | 4 |
| Example 80 | R-85 | UL-1 | 120°C/60 sec | 120°C/60 sec | D-1 | R-1 | 0.13 | 19.9 | 585 | 5 | 4 |
| Example 81 | R-86 | UL-1 | 120°C/60 sec | 120°C/60 sec | D-1 | R-1 | 0.13 | 19.9 | 585 | 5 | 4 |
| Example 82 | R-87 | UL-1 | 120°C/60 sec | 100°C/60 sec | D-1 | R-1 | 0.13 | 16.6 | 585 | 5 | 4 |
| Example 83 | R-88 | UL-1 | 120°C/60 sec | 130°C/60 sec | D-1 | R-1 | 0.13 | 19.9 | 585 | 5 | 4 |
| Example 84 | R-89 | UL-1 | 120°C/60 sec | 120°C/60 sec | D-1 | R-1 | 0.13 | 19.9 | 585 | 5 | 4 |
| Example 85 | R-90 | UL-1 | 120°C/60 sec | 120°C/60 sec | D-1 | R-1 | 0.13 | 19.9 | 585 | 5 | 4 |

(continued)

| Table 3-2 | Resist composition | Resist coating condition | | PEB and development condition | | | A value | Content [% by mass] of photoacid generator | Volume [A] of acid generated | Evaluation results | |
|---|---|---|---|---|---|---|---|---|---|---|---|
| | | Base film | Baking condition | PEB condition | Developer | Rinsing liquid | | | | Bridge defect suppressing properties | Film thickness reduction suppressing properties |
| Example 86 | R-91 | UL-1 | 120°C/60 sec | 120°C/60 sec | D-1 | R-1 | 0.13 | 19.9 | 585 | 5 | 4 |
| Example 87 | R-92 | UL-1 | 120°C/60 sec | 120°C/60 sec | D-1 | R-1 | 0.13 | 19.9 | 585 | 5 | 4 |
| Example 88 | R-93 | UL-1 | 120°C/60 sec | 120°C/60 sec | D-1 | R-1 | 0.13 | 22.1 | 585 | 5 | 4 |
| Example 89 | R-94 | UL-1 | 120°C/60 sec | 120°C/60 sec | D-1 | R-1 | 0.13 | 19.9 | 585 | 5 | 4 |
| Example 90 | R-95 | UL-1 | 120°C/60 sec | 120°C/60 sec | D-1 | R-1 | 0.13 | 19.9 | 585 | 5 | 4 |
| Example 91 | R-96 | UL-1 | 120°C/60 sec | 110°C/60 sec | D-1 | R-1 | 0.13 | 19.9 | 585 | 5 | 4 |
| Example 92 | R-97 | UL-1 | 120°C/60 sec | 120°C/60 sec | D-1 | R-1 | 0.13 | 22.1 | 585 | 5 | 4 |
| Example 93 | R-98 | UL-1 | 120°C/60 sec | 120°C/60 sec | D-1 | R-1 | 0.13 | 20.8 | 585 | 5 | 4 |
| Example 94 | R-99 | UL-1 | 120°C/60 sec | 120°C/60 sec | D-1 | R-1 | 0.13 | 17.6 | 354 | 5 | 4 |
| Example 95 | R-100 | UL-1 | 120°C/60 sec | 120°C/60 sec | D-1 | R-1 | 0.13 | 19.9 | 585 | 5 | 4 |
| Example 96 | R-101 | UL-1 | 120°C/60 sec | 120°C/60 sec | D-1 | R-1 | 0.13 | 19.9 | 585 | 5 | 4 |
| Example 97 | R-102 | UL-1 | 120°C/60 sec | 120°C/60 sec | D-1 | R-1 | 0.13 | 19.9 | 585 | 5 | 4 |

(continued)

| Table 3-2 | Resist composition | Resist coating condition | | PEB and development condition | | | A value | Content [% by mass] of photoacid generator | Volume [A] of acid generated | Evaluation results | |
|---|---|---|---|---|---|---|---|---|---|---|---|
| | | Base film | Baking condition | PEB condition | Developer | Rinsing liquid | | | | Bridge defect suppressing properties | Film thickness reduction suppressing properties |
| Example 98 | R-103 | UL-1 | 120°C/60 sec | 120°C/60 sec | D-1 | R-1 | 0.13 | 19.9 | 585 | 5 | 4 |
| Example 99 | R-104 | UL-1 | 120°C/60 sec | 120°C/60 sec | D-1 | R-1 | 0.13 | 19.9 | 585 | 5 | 4 |
| Example 100 | R-105 | UL-1 | 120°C/60 sec | 120°C/60 sec | D-1 | R-1 | 0.13 | 22.1 | 585 | 5 | 4 |
| Example 101 | R-106 | UL-1 | 120°C/60 sec | 120°C/60 sec | D-1 | R-1 | 0.13 | 19.9 | 585 | 5 | 4 |

As shown in Table 3 above, the resist compositions of Examples exhibited desired effects.

In addition, from the results in Table 3, it is clear that in a case where the volume of an acid generated from the photoacid generator is 300 A or more, a film thickness reduction in the unexposed area of the formed pattern is further suppressed (see the results of Example 34 and Example 38).

Furthermore, from the results in Table 3, it is clear that in a case where the A value of the resist composition obtained by Expression (1) is 0.13 or more, the bridge defects of the formed pattern are further suppressed (see the results of Example 4).

Moreover, from the results in Table 3, it is clear that in a case where the resin X includes repeating unit including a lactone structure as a specific repeating unit, and the repeating unit including a lactone structure includes the above-mentioned repeating unit represented by General Formula (A-2Z), the bridge defects of the formed pattern are further suppressed (see the results of Example 12, Example 13, Example 27, and Example 30).

In addition, from the results in Table 3, it is clear that the resin X includes the above-mentioned repeating unit represented by General Formula (A-1X) as a specific repeating unit, and the repeating unit represented by General Formula (A-1X) includes the above-mentioned repeating unit represented by General Formula (A-2X) or the above-mentioned repeating unit represented by General Formula (A-3X), the film thickness reduction in the unexposed area of the formed pattern is further suppressed (see the results of Examples 3 to 5 and 16 to 18).

## Claims

**1.** A photosensitive composition for EUV light, comprising:

a resin X of which a polarity is increased by an action of an acid so that a solubility in an alkali developer is increased and a solubility in an organic solvent is decreased, and a photoacid generator; or
a resin Y which includes a repeating unit having a photoacid generating group and of which a polarity is increased by an action of an acid so that a solubility in an alkali developer is increased and a solubility in an organic solvent is decreased,
wherein the photosensitive composition for EUV light satisfies both Requirement 1 and Requirement 2:

Requirement 1: an A value determined by Expression (1) is 0.12 or more and less than 0.14,

$$\text{Expression (1): } A = ([H] \times 0.04 + [C] \times 1.0 + [N] \times 2.1 + [O] \times 3.6 + [F] \times 5.6 + [S] \times 1.5 + [I] \times 39.5)/([H] \times 1 + [C] \times 12 + [N] \times 14 + [O] \times 16 + [F] \times 19 + [S] \times 32 + [I] \times 127)$$

in the expression, [H] represents a molar ratio of hydrogen atoms derived from a total solid content with respect to all atoms of the total solid content in the photosensitive composition for EUV light, [C] represents a molar ratio of carbon atoms derived from the total solid content with respect to all the atoms of the total solid content in the photosensitive composition for EUV light, [N] represents a molar ratio of nitrogen atoms derived from the total solid content with respect to all the atoms of the total solid content in the photosensitive composition for EUV light, [O] represents a molar ratio of oxygen atoms derived from the total solid content with respect to all the atoms of the total solid content in the photosensitive composition for EUV light, [F] represents a molar ratio of fluorine atoms derived from the total solid content with respect to all the atoms of the total solid content in the photosensitive composition for EUV light, [S] represents a molar ratio of sulfur atoms derived from the total solid content with respect to all the atoms of the total solid content in the photosensitive composition for EUV light, and [I] represents a molar ratio of iodine atoms derived from the total solid content with respect to all the atoms of the total solid content in the photosensitive composition for EUV light,
Requirement 2: the resin X and the resin Y each include two or more repeating units selected from the group consisting of a repeating unit represented by General Formula (A-1X), a repeating unit represented by General Formula (A-1Y), and a repeating unit including a lactone structure,

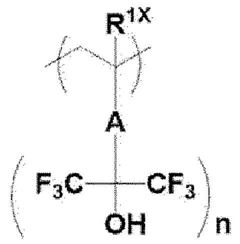

(A-1X)

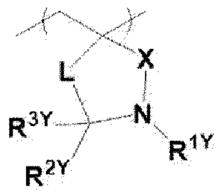

(A-1Y)

in General Formula (A-1X), $R^{1X}$ represents a hydrogen atom, an alkyl group which may be substituted with a fluorine atom, or a halogen atom, A represents an (n+1)-valent linking group, and n represents an integer of 1 or more, and
in General Formula (A-1Y), X represents -CO-, -SO-, or $-SO_2-$, $R^{1Y}$ to $R^{3Y}$ each independently represent a hydrogen atom or an organic group, and L represents a divalent linking group including a heteroatom as a ring member atom.

**2.** The photosensitive composition for EUV light according to claim 1, comprising:

the resin X of which a polarity is increased by an action of an acid so that a solubility in an alkali developer is increased and a solubility in an organic solvent is decreased; and
the photoacid generator.

**3.** The photosensitive composition for EUV light according to claim 1 or 2,
wherein a concentration of solid contents in the photosensitive composition for EUV light is 5.0% by mass or less.

**4.** The photosensitive composition for EUV light according to any one of claims 1 to 3,
wherein a content of the photoacid generator is 5% to 50% by mass with respect to a total solid content in the photosensitive composition for EUV light.

**5.** The photosensitive composition for EUV light according to any one of claims 1 to 4,
wherein a volume of an acid generated from the photoacid generator is 300Å$^3$ or more.

**6.** The photosensitive composition for EUV light according to any one of claims 1 to 5,

wherein the repeating unit including a lactone structure includes a repeating unit represented by General Formula (A-2Z),

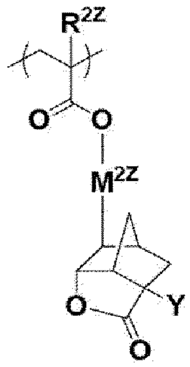

(A-2Z)

in General Formula (A-2Z), $R^{2Z}$ represents a hydrogen atom or an alkyl group which may have a substituent, $M^{2Z}$ represents a single bond or a divalent linking group, and Y represents a hydrogen atom or an electron-withdrawing group.

**7.** The photosensitive composition for EUV light according to any one of claims 1 to 6, wherein the repeating unit represented by General Formula (A-1X) includes a repeating unit represented by General Formula (A-2X) or General Formula (A-3X),

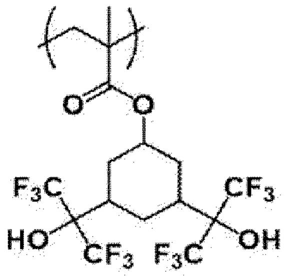

(A-2X)

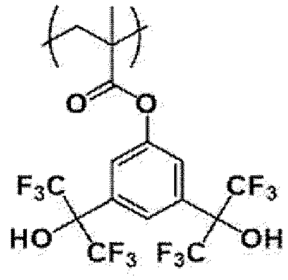

(A-3X) .

**8.** The photosensitive composition for EUV light according to any one of claims 1 to 7, wherein at least one of $R^{2Y}$ or $R^{3Y}$ in General Formula (A-1Y) is a group including a fluorine atom.

**9.** A pattern forming method comprising:

forming a resist film on a substrate using the photosensitive composition for EUV light according to any one of claims 1 to 8;
exposing the resist film with EUV light; and
developing the exposed resist film using an alkali developer to form a pattern.

**10.** A method for manufacturing an electronic device, the method comprising the pattern forming method according to claim 9.

**Patentansprüche**

**1.** Lichtempfindliche Zusammensetzung für EUV-Licht, umfassend:

ein Harz X, dessen Polarität durch eine Einwirkung einer Säure erhöht wird, sodass eine Löslichkeit in einem alkalischen Entwickler erhöht und eine Löslichkeit in einem organischen Lösungsmittel verringert wird, und einen Photosäuregenerator; oder
Harz Y, das eine sich wiederholende Einheit beinhaltet, die eine Photosäure erzeugenden Gruppe aufweist und dessen Polarität durch eine Einwirkung einer Säure erhöht wird, sodass eine Löslichkeit in einem alkalischen Entwickler erhöht und eine Löslichkeit in einem organischen Lösungsmittel verringert wird,
wobei die lichtempfindliche Zusammensetzung für EUV-Licht sowohl Bedingung 1 als auch Bedingung 2 erfüllt:

Bedingung 1: ein Wert A, der durch Ausdruck (1) bestimmt wird, ist 0,12 oder mehr und weniger als 0,14,

$$\text{Ausdruck (1): } A = ([H] \times 0{,}04 + [C] \times 1{,}0 + [N] \times 2{,}1 + [O] \times 3{,}6 + [F] \times 5{,}6 + [S] \times 1{,}5 + [I] \times 39{,}5)/([H] \times 1 + [C] \times 12 + [N] \times 14 + [O] \times 16 + [F] \times 19 + [S] \times 32 + [I] \times 127)$$

in dem Ausdruck [H] stellt ein molares Verhältnis von Wasserstoffatomen dar, abgeleitet von einem Gesamtfeststoffgehalt, in Bezug auf alle Atome des Gesamtfeststoffgehalts in der lichtempfindlichen Zusammensetzung für EUV-Licht, [C] stellt ein molares Verhältnis von Kohlenstoffatomen dar, abgeleitet von einem Gesamtfeststoffgehalt, in Bezug auf alle Atome des Gesamtfeststoffgehalts in der lichtempfindlichen Zusammensetzung für EUV-Licht, [N] stellt ein molares Verhältnis von Stickstoffatomen dar, abgeleitet von einem Gesamtfeststoffgehalt, in Bezug auf alle Atome des Gesamtfeststoffgehalts in der lichtempfindlichen Zusammensetzung für EUV-Licht, [O] stellt ein molares Verhältnis von Sauerstoffatomen dar, abgeleitet von einem Gesamtfeststoffgehalt, in Bezug auf alle Atome des Gesamtfeststoffgehalts in der lichtempfindlichen Zusammensetzung für EUV-Licht, [F] stellt ein molares Verhältnis von Fluoratomen dar, abgeleitet von einem Gesamtfeststoffgehalt, in Bezug auf alle Atome des Gesamtfeststoffgehalts in der lichtempfindlichen Zusammensetzung für EUV-Licht, [S] stellt ein molares Verhältnis von Schwefelatomen dar, abgeleitet von einem Gesamtfeststoffgehalt, in Bezug auf alle Atome des Gesamtfeststoffgehalts in der lichtempfindlichen Zusammensetzung für EUV-Licht, [I] stellt ein molares Verhältnis von Jodatomen dar, abgeleitet von einem Gesamtfeststoffgehalt, in Bezug auf alle Atome des Gesamtfeststoffgehalts in der lichtempfindlichen Zusammensetzung für EUV-Licht,

Bedingung 2: das Harz X und das Harz Y beinhalten jeweils zwei oder mehrere sich wiederholende Einheiten, die ausgewählt sind aus der Gruppe, bestehend aus einer sich wiederholenden Einheit, dargestellt durch die allgemeine Formel (A-1X), einer sich wiederholenden Einheit, dargestellt durch die allgemeine Formel (A-1Y), und einer sich wiederholenden Einheit, die eine Lactonstruktur beinhaltet,

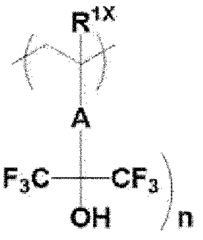

(A-1X)

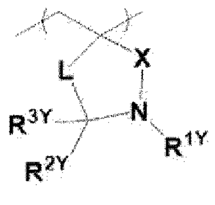

(A-1Y)

in der allgemeinen Formel (A-1X) stellt $R^{1X}$ ein Wasserstoffatom, eine Alkylgruppe, die mit einem Fluoratom substituiert sein kann, oder ein Halogenatom dar, A stellt eine (n+1)-wertige Verbindungsgruppe dar, und n ist eine ganze Zahl von 1 oder mehr, und

in der allgemeinen Formel (A-1Y) stellt X -CO-, -SO- oder $-SO_2-$ dar, $R^{1Y}$ bis $R^{3Y}$ stellen jeweils unabhängig ein Wasserstoffatom oder eine organische Gruppe dar, und L stellt eine zweiwertige Verbindungsgruppe dar, die ein Heteroatom als Ringelementatom beinhaltet.

**2.** Lichtempfindliche Zusammensetzung für EUV-Licht nach Anspruch 1, umfassend:
das Harz X, dessen Polarität durch eine Einwirkung einer Säure erhöht wird, sodass eine Löslichkeit in einem alkalischen Entwickler erhöht und eine Löslichkeit in einem organischen Lösungsmittel verringert wird; und den Photosäuregenerator.

**3.** Lichtempfindliche Zusammensetzung für EUV-Licht nach Anspruch 1 oder 2,
wobei die Konzentration an Feststoffgehalt in der lichtempfindlichen Zusammensetzung für EUV-Licht 5,0 Massen-% oder weniger ist.

**4.** Lichtempfindliche Zusammensetzung für EUV-Licht nach einem der Ansprüche 1 bis 3,
wobei ein Gehalt an dem Photosäuregenerator 5 Massen-% bis 50 Massen-% in Bezug auf den gesamten Feststoffgehalt in der lichtempfindlichen Zusammensetzung für EUV-Licht ist.

**5.** Lichtempfindliche Zusammensetzung für EUV-Licht nach einem der Ansprüche 1 bis 4, wobei das Volumen einer von dem Photosäuregenerator erzeugten Säure 300 Å$^3$ oder mehr ist.

**6.** Lichtempfindliche Zusammensetzung für EUV-Licht nach einem der Ansprüche 1 bis 5,

wobei die wiederkehrende Einheit, die eine Lactonstruktur beinhaltet, eine sich wiederholende Einheit dargestellt durch allgemeine Formel (A-2Z) beinhaltet,

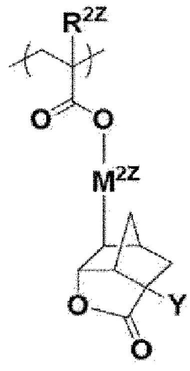

(A-2Z)

in der allgemeinen Formel (A-2Z) $R^{2Z}$ ein Wasserstoffatom oder eine Alkylgruppe darstellt, die einen Substituenten aufweisen kann, $M^{2Z}$ eine Einfachbindung oder eine zweiwertige Verbindungsgruppe und Y ein Wasserstoffatom oder eine elektronenziehende Gruppe darstellt.

**7.** Lichtempfindliche Zusammensetzung für EUV-Licht nach einem der Ansprüche 1 bis 6, wobei die durch die allgemeine Formel (A-1X) dargestellte Wiederholungseinheit eine durch die allgemeine Formel (A-2X) oder die allgemeine Formel (A-3X) dargestellte Wiederholungseinheit beinhaltet,

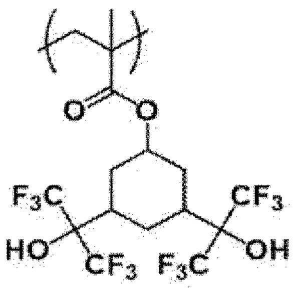

(A-2X)

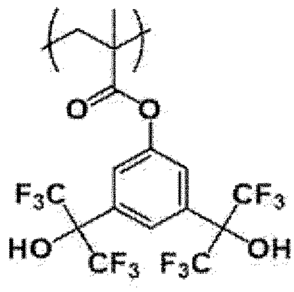

(A-3X)

**8.** Lichtempfindliche Zusammensetzung für EUV-Licht nach einem der Ansprüche 1 bis 7, wobei mindestens eines von $R^{2Y}$ oder $R^{3Y}$ in allgemeiner Formel (A-1Y) eine Gruppe ist, die ein Fluoratom beinhaltet.

**9.** Verfahren zum Herstellen von Mustern, umfassend:

Bilden eines Resistfilms auf einem Substrat unter Verwendung der lichtempfindlichen Zusammensetzung für EUV-Licht nach einem der Ansprüche 1 bis 8;
Belichten der Resistschicht mit EUV-Licht; und
Entwickeln des belichteten Resistfilms mit einem Alkalientwickler, um ein Muster zu bilden.

**10.** Verfahren zum Herstellen einer elektronischen Vorrichtung, das Verfahren umfassend das Musterbildungsverfahren nach Anspruch 9.

**Revendications**

**1.** Composition photosensible pour la lumière EUV, comprenant :

une résine X dont la polarité est augmentée par une action d’un acide de telle sorte qu’une solubilité dans un révélateur alcalin soit augmentée et qu’une solubilité dans un solvant organique soit diminuée, et un générateur de photoacide ; ou
une résine Y qui comprend une unité de répétition comportant un groupe générateur de photoacide et dont une

polarité est augmentée par l'action d'un acide de telle sorte qu'une solubilité dans un révélateur alcalin soit augmentée et qu'une solubilité dans un solvant organique soit diminuée,
dans laquelle la composition photosensible pour la lumière EUV satisfait à la fois à l'exigence 1 et à l'exigence 2 :

Exigence 1 : une valeur A déterminée par l'expression (1) est de 0,12 ou plus et inférieure à 0,14,

$$\text{Expression (1)}: A = ([H] \times 0{,}04 + [C] \times 1{,}0 + [N] \times 2{,}1 + [O] \times 3{,}6 + [F] \times 5{,}6 + [S] \times 1{,}5 + [I] \times 39{,}5)/([H] \times 1 + [C] \times 12 + [N] \times 14 + [O] \times 16 + [F] \times 19 + [S] \times 32 + [I] \times 127)$$

dans l'expression, [H] représente un rapport molaire des atomes d'hydrogène dérivés d'une teneur totale en solides par rapport à tous les atomes de la teneur totale en solides dans la composition photosensible pour la lumière EUV, [C] représente un rapport molaire des atomes de carbone dérivés de la teneur totale en solides par rapport à tous les atomes de la teneur totale en solides dans la composition photosensible pour la lumière EUV, [N] représente un rapport molaire des atomes d'azote dérivés de la teneur totale en solides par rapport à tous les atomes de la teneur totale en solides dans la composition photosensible pour la lumière EUV, [O] représente un rapport molaire des atomes d'oxygène dérivés de la teneur totale en solides par rapport à tous les atomes de la teneur totale en solides dans la composition photosensible pour la lumière EUV, [F] représente un rapport molaire des atomes de fluor dérivés de la teneur totale en solides par rapport à tous les atomes de la teneur totale en solides dans la composition photosensible pour la lumière EUV, [S] représente un rapport molaire des atomes de soufre dérivés de la teneur totale en solides par rapport à tous les atomes de la teneur totale en solides dans la composition photosensible pour la lumière EUV, et [I] représente un rapport molaire des atomes d'iode dérivés de la teneur totale en solides par rapport à tous les atomes de la teneur totale en solides dans la composition photosensible pour la lumière EUV,
Exigence 2 : la résine X et la résine Y comprennent chacune au moins deux unités de répétition sélectionnées dans le groupe constitué d'une unité de répétition représentée par la formule générale (A-1X), une unité de répétition représentée par la formule générale (A-1Y), et une unité de répétition comprenant une structure lactone,

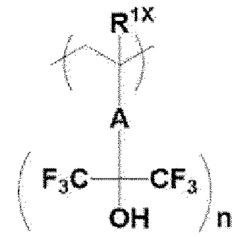
(A-1X)

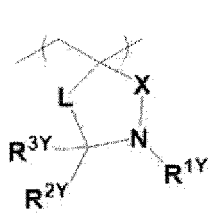
(A-1Y)

dans la formule générale (A-1X), $R^{1X}$ représente un atome d'hydrogène, un groupe alkyle qui peut être substitué par un atome de fluor ou un atome d'halogène, A représente un groupe de liaison (n+1)-valent et n représente un nombre entier de 1 ou plus, et
dans la formule générale (A-1Y), X représente -CO-, -SO- ou $-SO_2-$, $R^{1Y}$ à $R^{3Y}$ représentent chacun indépendamment un atome d'hydrogène ou un groupe organique, et L représente un groupe de liaison divalent comprenant un hétéroatome en tant qu'atome à chaînon de cycle.

2. Composition photosensible pour la lumière EUV selon la revendication 1, comprenant :

la résine X dont la polarité est augmentée par l'action d'un acide de telle sorte que la solubilité dans un révélateur alcalin soit augmentée et qu'une solubilité dans un solvant organique soit diminuée ; et
le générateur de photoacide.

3. Composition photosensible pour la lumière EUV selon la revendication 1 ou 2,
dans laquelle la concentration des teneurs en solides dans la composition photosensible pour la lumière EUV est de 5,0 % en masse ou moins.

4. Composition photosensible pour la lumière EUV selon l'une quelconque des revendications 1 à 3, dans laquelle la teneur du générateur de photoacide est de 5 % à 50 % en masse par rapport à la teneur totale en solides dans la composition photosensible pour la lumière EUV.

5. Composition photosensible pour la lumière EUV selon l'une quelconque des revendications 1 à 4, dans laquelle le volume d'un acide généré à partir du générateur de photoacide est de 300 Å$^3$ ou plus.

6. Composition photosensible pour la lumière EUV selon l'une quelconque des revendications 1 à 5,

dans laquelle l'unité de répétiton comprenant une structure lactone comprend une unité de répétition représentée par la formule générale (A-2Z),

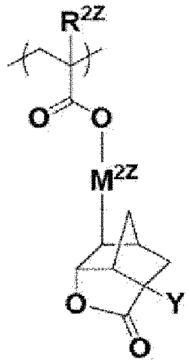

(A-2Z)

dans la formule générale (A-2Z), $R^{2Z}$ représente un atome d'hydrogène ou un groupe alkyle qui peut avoir un substituant, $M^{2Z}$ représente une liaison simple ou un groupe de liaison divalent, et Y représente un atome d'hydrogène ou un groupe de suppression d'électrons.

7. Composition photosensible pour la lumière EUV selon l'une quelconque des revendications 1 à 6, dans laquelle l'unité de répétition représentée par la formule générale (A-1X) comprend une unité de répétition représentée par la formule générale (A-2X) ou la formule générale (A-3X),

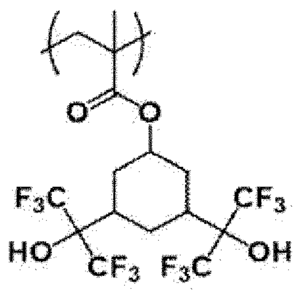

(A-2X)

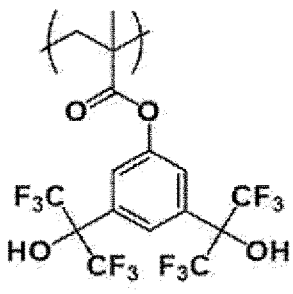

(A-3X)

8. Composition photosensible pour la lumière EUV selon l'une quelconque des revendications 1 à 7, dans laquelle au moins l'un parmi $R^{2Y}$ ou $R^{3Y}$ dans la formule générale (A-1Y) est un groupe comprenant un atome de fluor.

9. Procédé de formation de motif, comprenant :

la formation d'un film de réserve sur un substrat en utilisant la composition photosensible pour la lumière EUV selon l'une quelconque des revendications 1 à 8 ;
l'exposition du film de réserve à la lumière EUV ; et

le développement du film de réserve exposé en utilisant un révélateur alcalin pour former un motif.

**10.** Procédé de fabrication d'un dispositif électronique, le procédé comprenant le procédé de formation de motif selon la revendication 9.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2018193954 A
- WO 2019045107 A
- JP 2014041327 A
- JP 2014041328 A
- JP 2013228681 A
- US 2015004533 A
- JP 2014134686 A
- JP 2013011833 A
- US 20120251948 A1
- JP 2014010245 A
- JP 2011248019 A
- JP 2010175859 A
- JP 2012032544 A
- US 20080248425 A
- JP 2002090991 A
- JP 2014059543 A
- JP 2013061648 A
- JP 2009267112 A
- WO 2014002808 A
- JP 2004235468 A
- US 20100020297 A
- JP 2008083384 A
- JP 3270227 A
- JP H03270227 A
- JP 2013164509 A


### Non-patent literature cited in the description


- Chemical Handbook (II). Chemical Society of Japan, Maruzen Company, Ltd, 1993
- *Materials Letters,* 2008, vol. 62, 3152
- Prediction of polymer properties. Marcel Dekker Inc, 1993
- *Journal of The International Society for Optical Engineering (Proc. of SPIE),* 2008, vol. 6924, 692420
- Etching. Semiconductor Process Text Book. SEMI Japan, 2007
- EUV Resist Curing Technique for LWR Reduction and Etch Selectivity Enhancement. *Proc. of SPIE,* vol. 8328, 83280N-1
- *ACS Nano,* vol. 4 (8), 4815-4823